(19) Europäisches Patentamt
European Patent Office
Office européen des brevets

(11) **EP 2 141 215 A1**

(12) **EUROPEAN PATENT APPLICATION**
published in accordance with Art. 153(4) EPC

(43) Date of publication:
**06.01.2010 Bulletin 2010/01**

(21) Application number: **08739454.0**

(22) Date of filing: **31.03.2008**

(51) Int Cl.:
*C09K 11/64* (2006.01)          *C09K 11/08* (2006.01)
*H01L 33/00* (2010.01)          *H01S 5/022* (2006.01)
*H05B 33/14* (2006.01)

(86) International application number:
**PCT/JP2008/056340**

(87) International publication number:
**WO 2008/123498 (16.10.2008 Gazette 2008/42)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **30.03.2007 JP 2007092852**

(71) Applicant: **Mitsubishi Chemical Corporation Minato-ku Tokyo 108-0014 (JP)**

(72) Inventors:
• **SETO, Takatoshi**
  **Yokohama-shi**
  **Kanagawa 227-8502 (JP)**
• **KIJIMA, Naoto**
  **Yokohama-shi**
  **Kanagawa 227-8502 (JP)**
• **SHIMIZU, Etsuo**
  **Yokohama-shi**
  **Kanagawa 227-8502 (JP)**

(74) Representative: **HOFFMANN EITLE Patent- und Rechtsanwälte Arabellastrasse 4 81925 München (DE)**

(54) **PHOSPHOR AND METHOD FOR PRODUCING THE SAME, PHOSPHOR-CONTAINING COMPOSITION, LIGHT-EMITTING DEVICE, IMAGE DISPLAY DEVICE, AND ILLUMINATING DEVICE**

(57)    To provide a phosphor that stably shows high emission intensity and brightness as well as superior temperature characteristics, under excitation by near-ultraviolet light, the phosphor has a crystal phase comprising an alkali metal element and, in that crystal phase, the rate of substituted Eu (europium) to the number of sites which can be substituted with Eu is 15% or higher and the ratio of the alkali metal element to the number of sites which can be substituted with Eu is 3% or lower.

**EP 2 141 215 A1**

**Description**

Technical Field

The present invention relates to a phosphor that emits green or blue fluorescence and a production method thereof, a phosphor-containing composition and light emitting device using the phosphor, and a display and illuminating device using the light emitting device. More particularly, it relates to a green or blue phosphor that shows high emission intensity even under excitation by near-ultraviolet light, a phosphor-containing composition and light emitting device using the green or blue phosphor, and a display and illuminating device using the light emitting device.

Background Art

White light, which is essential in uses for an illuminating device and display, is generally obtained by mixing blue, green and red light emissions in accordance with the additive mixing principle of light. For backlights of color liquid crystal displays, which are a field of uses of displays, it is preferable that each of blue, green and red luminous bodies has as high emission intensity as possible and good color purity, in order to reproduce colors having wide range of chromaticity coordinates efficiently.

In these years, attempts have been made to use semiconductor light emitting devices as light sources of these three colors.

Known methods thereof are such that: blue, green and red lights are emitted using a semiconductor luminous element having its emission peak in the near-ultraviolet region (wavelength range of from 300 nm to 420 nm) as light source; and green and red lights are obtained by wavelength conversion at phosphors while utilizing blue light emitted from a luminous element having its emission peak in the blue region (wavelength range of from 420 nm to 500 nm) just as it is.

Of the three colors of blue, green and red, green is particularly important compared to the other two colors because it is especially high in luminosity factor to human eyes and it greatly contributes to the brightness of the entire display.

As phosphors emitting green fluorescence (hereinafter referred to as "green phosphors" as appropriate), oxide phosphors and oxynitride phosphors are known.

Oxide phosphors are particularly preferable industrially because they are easy to manufacture and low in production costs. However, previously known green oxide phosphors are still insufficient in terms of brightness and the like to be used as a green phosphor that is excited by a near-ultraviolet emitting semiconductor luminous element.

Of the oxide phosphors, ones having $(Ba,Sr,Ca)MgAl_{10}O_{17}$ as their host crystals (hereinafter abbreviated as "BAM phosphors" as appropriate), which were developed as phosphors that are excited by ultraviolet light of 365 nm or shorter wavelength or electron beam, are expected to be used as green phosphors because of their excellent brightnesses and chromaticities.

Therefore, attempts have been made to improve the characteristics of the BAM phosphors by making various modifications thereto.

For example in Patent Document 1, a phosphor for fluorescent lamps is disclosed in which an appropriate amount of phosphorus pentoxide $(P_2O_5)$ is additionally solid-solved in $Ba_{0.6}Al_2O_3:Eu^{2+},Mn^{2+}$ or $(Ba,Mg)O \cdot nAl_2O_3:Eu^{2+}_2,Mn^{2+}$.

In Patent Document 2, another phosphor for fluorescent lamps is disclosed in which an appropriate amount of boron oxide $(Ba_2O_3)$ is additionally solid-solved in $Ba_{0.6}Al_2O_3:Eu^{2+},Mn^{2+}$ or $(Ba,Mg)O \cdot nAl_2O_3:Eu^{2+}_2,Mn^{2+}$.

These documents also discloses that emission efficiency can be improved by adding fluorides as flux such as lithium fluoride (LiF), sodium fluoride (NaF), potassium fluoride (KF), or ammonium fluoride $(NH_4F \cdot HF)$, in a ratio of 1 to 5 weight % relative to a pre-fired phosphor material mixture.

Patent Document 3 discloses an aluminate phosphor represented by $(M^1_{1-x},Eu_x)O \cdot a(M^2_{1-y},Mn_y)O \cdot (5.5-0.5a)Al_2O_3$ as a phosphor for fluorescent lamps. The document also discloses that color shift or decrease in emission intensity occurring while the lamp is turned on can be prevented by letting Eu content within a specific range.

[Patent Document 1] Japanese Examined Patent Application Publication No. 56-25471
[Patent Document 2] Japanese Examined Patent Application Publication No. 57-8150
[Patent Document 3] Japanese Patent Laid-Open Publication No. 8-60147

Disclosure of the Invention

Problem to Be Solved by the Invention

However, the phosphors disclosed in Patent Document 1 and Patent Document 2 are insufficient in brightness to be used for displays or the like because they contain too little Eu.
The phosphor disclosed in Patent Document 3 is still lacking in sufficient protection of decrease in emission intensity or sufficient temperature characteristics.
Further, for achieving a light emitting device using a near-ultraviolet emission semiconductor luminous element as excitation light source, it is necessary for the phosphor used in combination to be high in intensity and flat in shape of its excitation spectrum in the near-ultraviolet region (especially around 400-nm wavelength). However, the phosphors disclosed in the above-mentioned documents are insufficient in these excitation spectrum characteristics.
The present invention has been made in view of the above problems. The object thereof is to provide a phosphor that stably shows not only high emission intensity and brightness but also excellent temperature characteristics under excitation by near-ultraviolet light, as well as to provide a phosphor-containing composition and light emitting device using the phosphor, and further to provide a display and illuminating device using the light emitting device.

Means for Solving the Problem

The present inventors made an intensive investigation to solve the above problems and have found that a phosphor having high Eu content and low ratio of alkali metal element to the number of sites which can be substituted with Eu can stably shows not only high emission intensity and brightness but also excellent temperature characteristics under excitation by near-ultraviolet light. In addition, they have found that such a phosphor can be obtained by firing a phosphor precursor in the presence of univalent metal element halide. These findings led to the completion of the present invention.
Namely, the subject matter of the present invention lies in a phosphor having a crystal phase comprising an alkali metal element, the crystal phase having a rate of substituted Eu (europium) to the number of sites which can be substituted with Eu of 15% or higher, and a ratio of the alkali metal element to the number of sites which can be substituted with Eu of 3% or lower (claim 1).
In this case, it is preferable that the phosphor has β-alumina structure (claim 2).
Further, it is preferable that the phosphor has an emission peak in the wavelength region between 470 nm and 570 nm when excited with light in a wavelength range between 380 nm and 410 nm (claim 3).
Further, it is preferable that the phosphor has an emission peak in the wavelength region between 420 nm and 470 nm when excited with light in a wavelength range between 380 nm and 410 nm (claim 4).
Further, it is preferable that the full width at half maximum of the emission peak is 60 nm or smaller (claim 5).
Further, it is preferable that the phosphor is an oxide phosphor of which the oxygen content to the total amount of elements constituting anions in the phosphor is 40 atomic percent or higher (claim 6).
Further, it is preferable that the phosphor is an alkaline-earth metal aluminate (claim 7).
Further, it is preferable that the phosphor further contains Mn (manganese) (claim 8).
Further, it is preferable that the phosphor further contains Mg (magnesium) (claim 9).
Further, it is preferable that the phosphor is represented by the formula [1] below (claim 10).

$$(1-a)Ba_{(1-b-c-d)}Sr_bCa_cEu_dMg_{(1-e-f)}Zn_eMn_fAl_gO_h \cdot (a)Ba_{(1-b'-c'-d')}Sr_{b'}Ca_{c'}Eu_{d'}Al_{11}O_{17.25}A_i \qquad [1]$$

(Where

A represents at least one kind of alkali metal element, and
a, b, c, d, e, f, g, h, i, b', c', and d' represent numbers satisfying the following conditions:

$0 \le a \le 1$,
$0 \le b < 1$,
$0 \le c < 1$,
$0.1 < d < 1$,
$0 \le e < 1$,
$0 \le f \le 1$,
$9 \le g \le 11$,
$15.3 \le h \le 18.7$,
$0 \le i \le 0.03$,

0≤b'<1,
0≤c'<1, and
0.1<d'<1.)

Another subject matter of the present invention lies in a production method of a phosphor comprising a step of firing a phosphor precursor in the presence of univalent metal element halide of more than 0 weight % and less than 1 weight % (claim 11).

In this case, it is preferable that the univalent metal element halide is halide of one or more kinds of metal elements selected from the group consisting of Na (sodium), K (potassium), and Li (lithium) (claim 12).

Further, it is preferable that the obtained phosphor is an alkaline-earth metal aluminate (claim 13).

Further, it is preferable that the obtained phosphor is represented by the formula [1] mentioned above (claim 14).

Still another subject matter of the present invention lies in a phosphor-containing composition comprising: the phosphor mentioned above and a liquid medium (claim 15).

Still another subject matter of the present invention lies in a light emitting device comprising: a first luminous body and a second luminous body which emits visible light when irradiated with light from the first luminous body, wherein the second luminous body comprises, as a first phosphor, at least one kind of the phosphor mentioned above (claim 16).

In this case, it is preferable that the second luminous body comprises, as a second phosphor, at least one kind of a phosphor of which luminous wavelength is different from that of the first phosphor (claim 17).

Further, it is preferable that the first luminous body has an emission peak in the wavelength range of 300 nm or longer and 420 nm or shorter, and the second luminous body comprises, as the second phosphor, at least one kind of a phosphor having an emission peak in the wavelength range of 530 nm or longer and 780 nm or shorter (claim 18).

Further, it is also preferable that the first luminous body has an emission peak in the wavelength range of 300 nm or longer and 420 nm or shorter, and the second luminous body comprises, as the second phosphor, at least one kind of a phosphor having an emission peak in the wavelength range of longer than 420 nm and 490 nm or shorter and at least one kind of a phosphor having an emission peak in the wavelength range of 570 nm or longer and 780 nm or shorter (claim 19).

Further, it is also preferable that the first luminous body has an emission peak in the wavelength range of 300 nm or longer and 420 nm or shorter, and the second luminous body comprises, as the second phosphor, at least one kind of a phosphor having an emission peak in the wavelength range of longer than 500 nm and 550 nm or shorter and at least one kind of a phosphor having an emission peak in the wavelength range of 570 nm or longer and 780 nm or shorter (claim 20).

Still another subject matter of the present invention lies in a display comprising, as a light source, the light emitting device mentioned above (claim 21).

Still another subject matter of the present invention lies in an illuminating device comprising, as a light source, the light emitting device mentioned above (claim 22).

Advantageous Effect of the Invention

According to the present invention, a phosphor that stably shows high emission intensity and brightness as well as superior temperature characteristics, even under excitation by near-ultraviolet light, can be obtained. In addition, the use of a composition containing the phosphor can provide a superior light emitting device that hardly effects a color shift or decreases emission intensity. This light emitting device can be preferably used for displays or illuminating devices.

Brief Description of the Drawings

[Fig. 1] Fig. 1 is a schematic perspective view illustrating the positional relationship between an excitation light source (first luminous body) and a phosphor-containing part (second luminous body), in an example of the light emitting device of the present invention.

[Fig. 2] Both Fig. 2(a) and Fig. 2(b) are schematic sectional views illustrating an example of the light emitting device comprising an excitation light source (first luminous body) and a phosphor-containing part (second luminous body).

[Fig. 3] Fig. 3 is a sectional view schematically illustrating an embodiment of the illuminating device of the present invention.

[Fig. 4] Fig. 4 is a graph showing emission spectral maps measured on phosphors of Example 1 and Comparative Examples 1 and 2 of the present invention.

[Fig. 5] Fig. 5 is a graph showing excitation spectral maps measured on phosphors of Example 1 and Comparative Examples 1 and 2 of the present invention.

[Fig. 6] Fig. 6 is a graph showing emission spectral maps measured on phosphors of Examples 28 and 29 and Comparative Examples 7 and 8 of the present invention.

[Fig. 7] Fig. 7 is a graph showing excitation spectral maps measured on phosphors of Examples 28 and 29 and Comparative Examples 7 and 8 of the present invention.

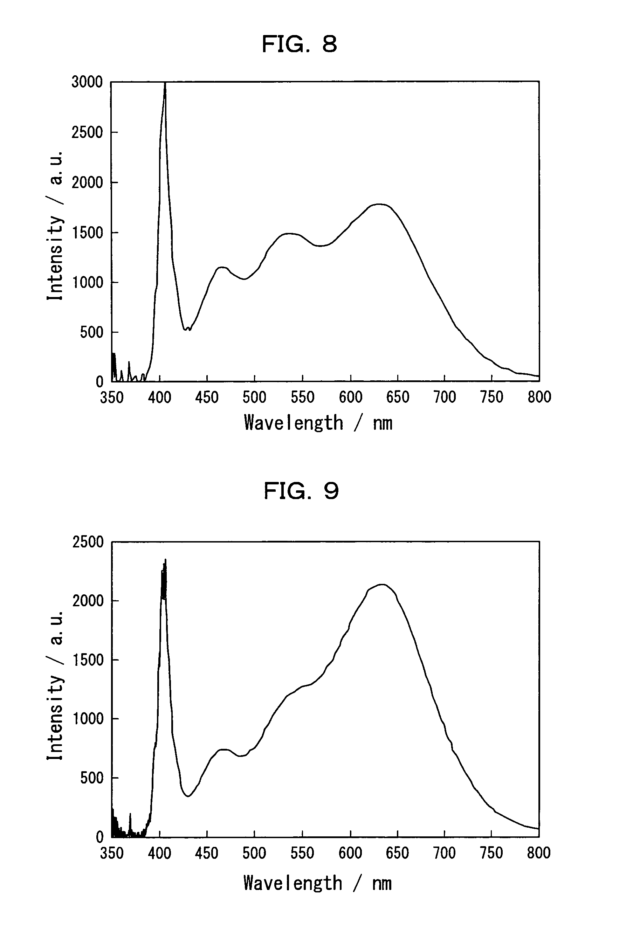

[Fig. 8] Fig. 8 is a graph showing an emission spectral map of the white light emitting device prepared in Example 32 of the present invention.

[Fig. 9] Fig. 9 is a graph showing an emission spectral map of the white light emitting device prepared in Example 33 of the present invention.

[Fig. 10] Fig. 10 is a graph showing an emission spectral map of the white light emitting device prepared in Example 34 of the present invention.

Explanation of Letters or Numerals

1: second luminous body
2: surface-emitting type GaN-based LD (first luminous body)
3: substrate
4: light emitting device
5: mount lead
6: inner lead
7: first luminous body
8: phosphor-containing resinous part
9: conductive wire
10: moled member
11: surface-emitting lighting system
12: holding case
13: light emitting device
14: diffusion plate
22: first luminous body
23: phosphor-containing resinous part (second luminous body)
24: frame
25: conductive wire
26, 27: electrode

Best Modes for Carrying Out the Invention

The present invention will be described in detail below. However, the present invention is not at all limited to the below description, but any modification can be made without departing from the scope of the invention.

Each composition formula of the phosphors in this description is punctuated by a comma (,). Further, when two or more elements are juxtaposed with a comma (,) in between, one kind of or two or more kinds of the juxtaposed elements can be contained in the composition formula in any combination and in any composition. In this context, the total content of the elements juxtaposed in parentheses is 1 mole. For example, a composition formula, "$(Ba,Sr,Ca)Al_2O_4:Eu$", inclusively indicates all of "$BaAl_2O_4:Eu$", "$SrAl_2O_4:Eu$", "$CaAl_2O_4:Eu$", "$Ba_{1-x}Sr_xAl_2O_4:Eu$", "$Ba_{1-x}Ca_xAl_2O_4:Eu$", "$Sr_{1-x}Ca_xAl_2O_4:Eu$", and "$Ba_{1-x-y}Sr_xCa_yAl_2O_4:Eu$" (in the formulae, $0<x<1$, $0<y<1$, $0<x+y<1$).

[1. Phosphor]

[I-1. Characteristics of phosphor]

<I-1-1. Specific crystal phase>

The phosphor of the present invention is **characterized in that** it has a crystal phase comprising an alkali metal element and, in that crystal phase, the rate of substituted Eu (europium) to the number of sites which can be substituted with Eu is 15% or higher and the ratio of the alkali metal element to the number of sites which can be substituted with Eu is 3% or lower. Due to such characteristics, the phosphor of the present invention can stably show a high emission intensity and brightness even under excitation by near-ultraviolet light as well as show superior temperature characteristics.

Specifically, in the crystal phase of the phosphor of the present invention, the rate of substituted Eu (europium) to the number of sites which can be substituted with Eu (namely, the number of the Eu / the number of the sites) is usually 15% or higher, preferably 20% or higher, and more preferably 25% or higher. When the rate of substituted Eu is too low, brightness of the obtained phosphor may not be improved sufficiently. There is no limitation on the upper limit of the rate of substituted Eu. Since a too high rate of substituted Eu may result in a decrease in emission intensity, it is desirable that the upper limit is usually 70% or lower, preferably 60% or lower, and more preferably 55% or lower.

Eu is an activation element and substitutes a part of elements in the host crystal. In this case, the "sites which can be substituted with Eu" means sites which are occupied by bivalent metal elements of which the radius, in a state with six ligands and a valence of 2, is 0.92 Å or larger in the host crystal. Preferable examples of such bivalent metal elements include: Ca, Sr, and Ba.

In addition, the crystal phase contained in the phosphor of the present invention comprises an alkali metal element.

Examples of such an alkali metal element include: Li (lithium), Na (sodium), K (potassium), Rb (rubidium), Cs (cesium), and Fr (francium). Of these, Li, Na, and K are preferable, and Na and K are particularly preferable. The crystal phase contained in the phosphor of the present invention may comprise either one kind of these alkali metal elements alone or two or more kinds of them together in any combination and in any ratio.

In the phosphor of the present invention, the host crystal contains sites which can be substituted with Eu, as described above. It is preferable to contain at least one of Ca, Sr, and Ba as those sites. It is more preferable to contain at least one of Sr and Ba. It is particularly preferable to contain Ba. Of these, when containing at least Sr, brightness of the phosphor in the early stage can be enhanced and temperature dependence of the brightness can be improved, which are preferable. The crystal phase contained in the phosphor of the present invention may comprise either one kind of these alkaline-earth metal elements alone or two or more kinds of them together in any combination and in any ratio. At this point, the ratio of Sr and Ba to the total amount of Ca, Sr, and Ba is preferably 30 mole percent or higher, more preferably 60 mole percent or higher, and still more preferably 90 mole percent or higher. When the ratio is too low, the emission intensity under excitation by a near-ultraviolet light may decrease.

In the crystal phase of the phosphor of the present invention, the ratio of the alkali metal element to the number of sites which can be substituted with Eu (namely, the number of the alkali metal / the number of the sites) is usually higher than 0%, preferably 0.1% or higher, more preferably 0.2% or higher, still more preferably 0.3% or higher, particularly preferably 0.5% or higher, and usually 3% or lower, preferably 2.6% or lower, more preferably 2.3% or lower, still more preferably 2% or lower, particularly preferably 1.8% or lower, still particularly preferably 1.6% or lower. When the ratio of the alkali metal element to the number of sites which can be substituted with Eu is too low, the temperature characteristics of the obtained phosphor may not be fully improved. When the ratio of the alkali metal element to the number of sites which can be substituted with Eu is too high, the emission intensity of the obtained phosphor may decrease.

Furthermore, it is preferable for the phosphor of the present invention to contain F as an anion element. In the crystal phase of the phosphor of the present invention, the ratio of F element to the number of sites which can be substituted with Eu is usually higher than 0%, preferably 0.01% or higher, more preferably 0.05% or higher, still more preferably 0.1% or higher, and usually 10% or lower, preferably 5% or lower, more preferably 3% or lower. The ratio of F element may be, though it depends on materials or flux used for production of the phosphor, as low as 1% or lower especially when the type of the used flux has much influence and only an alkali metal fluoride is used as flux.

There is no other limitation on the characteristics of the phosphor of the present invention insofar as it has the above-mentioned specific crystal phase, but the characteristics are preferably as follows.

<I-1-2. Composition>

It is preferable for the phosphor of the present invention to have composition characteristics mentioned below.

It is preferable for the phosphor of the present invention to be an oxide phosphor. In such a case, the oxygen content to the total amount of elements constituting anions (for example, sulfur (S), nitrogen (N), oxygen (O), or halogens) in the phosphor of the present invention (namely, oxygen / total amount of elements constituting anions) is usually 40 atomic percent or higher, preferably 60 atomic percent or higher, more preferably 80 atomic percent or higher, still more preferably 90 atomic percent or higher, and particularly preferably 100 atomic percent. Too low an oxygen ratio to the total amount of elements constituting anions may tend to decrease the emission-peak intensity or broaden the full width at half maximum of the emission peak.

It is preferable that the phosphor of the present invention further comprises Al (aluminium). In such a case, the ratio of all bivalent metal elements of which the radii, in a state with six ligands and a valence of 2, are 0.92 Å or larger to Al in the phosphor of the present invention is usually 0 mole percent or higher, preferably 1.7 mole percent or higher, more preferably 8 mole percent or higher, and usually 20 mole percent or lower, preferably 18 mole percent or lower, more preferably 12 mole percent or lower.

It is preferable that the above phosphor is specifically an alkaline-earth metal aluminate. Preferable examples of the host crystal composition thereof include: $BaMgAl_{10}O_{17}$, $Ba_{0.75}Al_{11}O_{17.25}$, $BaMg_2Al_{16}O_{27}$, $BaAl_2O_4$, and $Ba_4Al_{19}O_{25}$.

It is preferable that the phosphor of the present invention further comprises Mn (manganese) when used as a green phosphor. In such a case, the ratio of Mn to all bivalent metal elements of which radii, in a state with six ligands and a valence of 2, are 0.92 Å or larger in the phosphor of the present invention is usually 0 mole percent or higher, preferably 10 mole percent or higher, more preferably 20 mole percent or higher, and usually 70 mole percent or lower, preferably 60 mole percent or lower, more preferably 55 mole percent or lower.

It is preferable that the phosphor of the present invention further comprises Mg (magnesium). In such a case, the ratio of Mg to all bivalent metal elements of which radii, in a state with six ligands and a valence of 2, are 0.92 Å or larger in the phosphor of the present invention is usually 0 mole percent or higher, preferably 20 mole percent or higher, more preferably 30 mole percent or higher, and usually 190 mole percent or lower, preferably 90 mole percent or lower, more preferably 80 mole percent or lower.

Particularly, it is preferable for the phosphor of the present invention to have a composition represented by the formula [1] below.

$$(1-a)Ba_{(1-b-c-d)}Sr_bCa_cEu_dMg_{(1-e-f)}Zn_eMn_fAl_gO_h \cdot (a)Ba_{(0.75-b'-c'-d')}Sr_{b'}Ca_{c'}Eu_{d'}Al_{11}O_{17.25} \cdot A_i \qquad [1]$$

(Where

A represents at least one kind of alkali metal element, and

a, b, c, d, e, f, g, h, i, b', c', and d' represent numbers satisfying the following conditions:

$0 \leq a \leq 1$,
$0 \leq b < 1$,
$0 \leq c < 1$,
$0.1 < d < 1$,
$0 \leq e < 1$,
$0 \leq f \leq 1$,
$9 \leq g \leq 11$,
$15.3 \leq h \leq 18.7$,
$0 \leq i \leq 0.03$,
$0 \leq b' < 1$,
$0 \leq c' < 1$, and
$0.1 < d' < 1$.)

In the formula [1], A represents an alkali metal element. The alkali metal element is as described earlier.

The value "a" is usually 0 or larger, and usually 1 or smaller, preferably 0.4 or smaller, more preferably 0.2 or smaller, particularly preferably 0.

The value "b" is usually 0 or larger, and usually smaller than 1, preferably smaller than 0.55, more preferably smaller than 0.5, still more preferably smaller than 0.45.

The value "c" is usually 0 or larger, and usually smaller than 1, preferably smaller than 0.5, more preferably smaller than 0.45, still more preferably smaller than 0.35.

The value "d" is usually larger than 0.1, preferably 0.15 or larger, more preferably 0.2 or larger, still more preferably 0.25 or larger, and usually smaller than 1, preferably 0.7 or smaller, more preferably 0.6 or smaller, still more preferably 0.5 or smaller.

The value "e" is usually 0 or larger, and usually smaller than 1, preferably 0.4 or smaller, more preferably 0.3 or smaller, still more preferably 0.15 or smaller.

The value "f" is usually 0 or larger, preferably larger than 0, more preferably 0.05 or larger, still more preferably 0.1 or larger, particularly preferably 0.15 or larger, and usually 1 or smaller, preferably 0.7 or smaller, more preferably 0.6 or smaller, still more preferably 0.5 or smaller.

The value "g" is usually 9 or larger, preferably 9.5 or larger, and usually 11 or smaller, preferably 10.5 or smaller, particularly preferably 10.

The value "h" is usually 15.3 or larger, preferably 16 or larger, and usually 18.7 or smaller, preferably 18 or smaller, particularly preferably 17.

The value "b'" is usually 0 or larger, and usually smaller than 1 [sic], preferably smaller than 0.5, more preferably smaller than 0.45.

The value "c'" is usually 0 or larger, and usually smaller than 1 [sic], preferably smaller than 0.5, more preferably smaller than 0.45.

The value "d'" is usually larger than 0.1, preferably 0.15 or larger, more preferably 0.2 or larger, still more preferably 0.25 or larger, and usually smaller than 1 [sic], preferably 0.7 or smaller, more preferably 0.6 or smaller, still more preferably 0.5 or smaller.

The value "i" is usually larger than 0, preferably 0.001 or larger, more preferably 0.002 or larger, still more preferably 0.003 or larger, particularly preferably 0.005 or larger, and usually 0.03 or smaller, preferably 0.026 or smaller, more preferably 0.023 or smaller, still more preferably 0.02 or smaller, particularly preferably 0.018 or smaller, still particularly preferably 0.016 or smaller.

<I-1-3. Crystal structure>

It is preferable that the phosphor of the present invention has β-alumina structure.

A typical substance having β-alumina structure, which is a preferable crystal structure of the phosphor of the present invention, is $BaMgAl_{10}O_{17}$. $BaMgAl_{10}O_{17}$ has a crystal system of hexagonal system, a space group of $P6_3/mmc$, and a laminated structure in which BaO layers are sandwiched by an $Al_2O_3$ layer and an $MgAl_2O_4$ layer. The $Ba^{2+}$ lattice location can be substituted with $Eu^{2+}$, $Sr^{2+}$, or $Ca^{2+}$ in a variety of composition ranges. The $Mg^{2+}$ lattice location can be substituted with $Mn^{2+}$ or $Zn^{2+}$ in a variety of composition ranges. The $Mg^{2+}$ sites has an oxygen coordination geometry with 4 ligands, and the crystalline field formed by the coordination geometry is thought to be contributing to the green luminescence.

Eu-activated $Ba_{0.75}Al_{11}O_{17.25}$, which can be obtained from $BaMgAl_{10}O_{17}$ by substituting Al for Mg and O for a part of Ba, is known as a blue phosphor. It is known that the Eu-activated $Ba_{0.75}Al_{11}O_{17.25}$ has similar luminescent characteristics to those of $BaMgAl_{10}O_{17}$:Eu phosphor and they form a solid solution by being solid-solved in each other. From the above-mentioned standpoint, a preferable composition of the phosphor of the present invention comes to be represented by the above formula [1].

Especially when the phosphor of the present invention has the composition represented by the above formula [1] and "a" is not 0 or 1, the phosphor of the present invention has two parts respectively represented by $Ba_{(1-b-c-d)}Sr_b$-$Ca_cEu_dMg_{(1-e-f)}Zn_eMn_fAl_gO_h$ and $Ba_{(1-b'-c'-d')}Sr_{b'}Ca_{c'}Eu_{d'}Al_{11}O_{17.5}$ [sic]. These two parts of the phosphor of the present invention may be a solid solution having a uniform crystal phase, or may form a mixture of different crystal phases of these parts.

<I-1-4. Emission spectrum>

It is preferable that the phosphor of the present invention has the following emission spectrum characteristics under excitation by light in a wavelength range between 380 nm and 410 nm, in light of its use as a green or blue phosphor.

(I-1-4-1. Emission-peak wavelength)

It is preferable for the phosphor of the present invention, when used as a green phosphor, to have an emission-peak wavelength $\lambda_p$ (nm) of the emission spectrum that is obtained when excited with light in the above-mentioned wavelength range in the range of usually 470 nm or longer, preferably 490 nm or longer, more preferably 510 nm or longer, and usually 570 nm or shorter, preferably 550 nm or shorter, more preferably 535 nm or shorter. When the emission-peak wavelength $\lambda_p$ is too short, the luminescent color tends to deviate from green to blue green. When the emission-peak wavelength $\lambda_p$ is too long, the luminescent color tends to deviate from green to yellow green.

It is preferable for the phosphor of the present invention, when used as a blue phosphor, to have an emission-peak wavelength $\lambda_p$ (nm) of the emission spectrum that is obtained when excited with light in the above-mentioned wavelength range in the range of usually 420 nm or longer, preferably 430 nm or longer, more preferably 440 nm or longer, and usually 470 nm or shorter, preferably 465 nm or shorter, more preferably 460 nm or shorter. When the emission-peak wavelength $\lambda_p$ is too short, the luminescent color tends to deviate from blue to purple. When the emission-peak wavelength $\lambda_p$ is too long, the luminescent color tends to deviate from blue to blue green.

(I-1-4-2. Full width at half maximum of the emission peak)

It is preferable that, in the phosphor of the present invention, the full width at half maximum (hereinafter abbreviated as "FWHM" as appropriate) of the above-mentioned emission peak in the emission spectrum is usually 60 nm or smaller, preferably 55 nm or smaller, more preferably 40 nm or smaller, still more preferably 35 nm or smaller, particularly preferably 30 nm or smaller. When the FWMH is too wide, color purity may decrease. There is no limitation on the lower limit of the FWMH. However, it is desirable for the lower limit to be usually 3 nm or larger, and preferably 4 nm or larger, because too narrow an FWMH may decrease brightness.

(I-1-4-3. Ratio of blue emission peak intensity to green emission peak intensity)

The phosphor of the present invention makes a phosphor which emits light mainly in the green region (namely, a green phosphor) especially when it comprises Eu and Mn together. In such a case, it is preferable that the emission peak present in other-than-green wavelength regions (mainly, blue wavelength region) is sufficiently small relative to the emission peak present in the green wavelength region.

Specifically, it is preferable that the ratio (intensity of the blue emission peak when letting that of green emission peak be 1) of the peak (blue emission peak) present in usually 420 nm or longer, preferably 430 nm or longer, and usually 470 nm or shorter, preferably 465 nm or shorter to the peak (green emission peak) present in usually 490 nm or longer, preferably 510 nm or longer, and usually 550 nm or shorter, preferably 535 nm or shorter is usually 0.15 or smaller, preferably 0.09 or smaller, more preferably 0.07 or smaller, still more preferably 0.06 or smaller, particularly preferably 0.05 or smaller. When the ratio of blue emission peak intensity to that of green emission peak is too large, the performance of the phosphor may not be sufficient as a green phosphor.

(I-1-4-4. Measurement of emission spectrum)

The emission spectrum of the phosphor of the present invention can be measured using, for example, a fluorescence measurement apparatus (manufactured by JASCO corporation) equipped with a 150-W xenon lamp as an excitation light source and a multichannel CCD detector C7041 (manufactured by Hamamatsu Photonics K.K.) as a spectrum measurement apparatus. The measurement of emission spectrum shall be carried out at 25°C.

<I-1-5. Excitation spectrum>

It is preferable that the phosphor of the present invention has the following excitation spectrum characteristics.

(1-1-5-1. Reduction rate of I(400) to I(340))

In the excitation spectrum of the phosphor of the present invention, it is preferable that I(340), which is the emission intensity under excitation by 340 nm, and I(400), which is the emission intensity under excitation by 400 nm, satisfy the following formula [2].

$$0 \leq [\{I(340) - I(400)\} / I(340)] \times 100 \leq 29 \quad [2]$$

The maximum value of the excitation spectrum of the phosphor of the present invention is present at a wavelength of around 340 nm. Therefore, the above formula [2] indicates that the reduction rate of the excitation spectrum intensity I(400) around 400 nm relative to the excitation spectrum intensity I(340), which is present around the maximum value point of the excitation spectrum, is low. In other words, it indicates that the excitation spectrum intensity around 400 nm is high. A phosphor that is high in excitation spectrum intensity at around 400 nm is preferable because it shows superior emission efficiency when using a near-ultraviolet light emitting diode (hereinafter abbreviated as "LED" as appropriate) as an excitation light source.

It is preferable for the upper limit of the value "[{I(340) - I(400)} / I(340)] $\times$ 100" in the above formula [2] to be as small as possible. Specifically, it is desirable that the upper limit is usually 29 or smaller, preferably 26 or smaller, and more preferably 23 or smaller.

On the other hand, there is no limitation on the lower limit of the value "[{I(340) - I(400)} / I(340)] $\times$ 100", and it is usually 0 or larger.

(I-1-5-2. Ratio of change of I(390) to I(382))

In the excitation spectrum of the phosphor of the present invention, it is preferable that I(382), which is the emission intensity under excitation by 382 nm, and I(390), which is the emission intensity under excitation by 390 nm, satisfy the following formula [3].

$$0 \leq |[\{I(382) - I(390)\} / I(382)]| \times 100 \leq 3.1 \quad [3]$$

The above formula [3] indicates that the ratio of change of the excitation spectrum intensity I(390) relative to the excitation spectrum intensity I(382) is low. Further, it indicates that the shape of the excitation spectrum in the wavelength range of from 382 nm to 390 nm is flat. This wavelength range of from 382 nm to 390 nm is an excitation wavelength used mainly for a near-ultraviolet excitation. Therefore, a phosphor that has a flat excitation spectrum shape in this wavelength range is preferable because it hardly shows a decrease in emission intensity or a color shift when using a near-ultraviolet LED as an excitation light source.

It is preferable for the upper limit of the value "[{I(382) - I(390)} / I(382)] $\times$ 100" in the above formula [3] to be as small as possible. Specifically, it is desirable that the upper limit is usually 3.1 or smaller, preferably 2.5 or smaller, more preferably 2 or smaller, still more preferably 1.5 or smaller.

On the other hand, there is no limitation on the lower limit of the value "[{I(382) - I(390)} / I(382)] $\times$ 100", and it is usually 0 or larger.

(I-1-5-3. Measurement of excitation spectrum)

The excitation spectrum of the phosphor of the present invention can be measured using, for example, a fluorescence measurement apparatus (manufactured by JASCO corporation) equipped with a 150-W xenon lamp as an excitation light source and a multichannel CCD detector C7041 (manufactured by Hamamatsu Photonics K.K.) as a spectrum measurement apparatus. The measurement of excitation spectrum shall be carried out at 25°C.

<I-1-6. Temperature characteristics>

It is preferable that the phosphor of the present invention has the following temperature characteristics when measuring its emission spectrum under excitation by 405 nm light.

(I-1-6-1. Stability in brightness with respect to temperature change)

It is preferable for the phosphor of the present invention to satisfy the following formulae [4-1] to [4-4], when letting brightness values under excitation by 405 nm at 20°C±5°C, 60°C±5°C, 100°C±5°C, 135°C±10°C, and 175°C±10°C be "$B^{(405)}_{(20)}$", "$B^{(405)}_{(60)}$", "$B^{(405)}_{(100)}$", "$B^{(405)}_{(135)}$", and "$B^{(405)}_{(175)}$", respectively.

$$0 \leq |[B^{(405)}_{(60)} - B^{(405)}_{(20)}] / B^{(405)}_{(20)}| \times 100 \leq 8 \qquad [4-1]$$

$$0 \leq |[B^{(405)}_{(100)} - B^{(405)}_{(20)}] / B^{(405)}_{(20)}| \times 100 \leq 8 \qquad [4-2]$$

$$0 \leq |[B^{(405)}_{(135)} - B^{(405)}_{(20)}] / B^{(405)}_{(20)}| \times 100 \leq 8 \qquad [4-3]$$

$$0 \leq |[B^{(405)}_{(175)} - B^{(405)}_{(20)}] / B^{(405)}_{(20)}| \times 100 \leq 8 \qquad [4-4]$$

The above formulae [4-1] to [4-4] indicate that the rate of change of brightness values ($B^{(405)}_{(60)}$, $B^{(405)}_{(100)}$, $B^{(405)}_{(135)}$, and $B^{(405)}_{(175)}$) under excitation by 405 nm at 60°C±5°C, 100°C±5°C, 135°C±10°C, and 175°C±10°C relative to the brightness value ($B^{(405)}_{(20)}$) under excitation by 405 nm at 20°C±5°C is low. In other words, they indicate that the stability in brightness with respect to temperature changes is excellent.

Specifically, it is desirable that the upper limits of values $|[B^{(405)}_{(60)} - B^{(405)}_{(20)}] / B^{(405)}_{(20)}| \times 100$ of the above formula [4-1], $|[B^{(405)}_{(100)} - B^{(405)}_{(20)}] / B^{(405)}_{(20)}| \times 100$ of the above formula [4-2], $|[B^{(405)}_{(135)} - B^{(405)}_{(20)}] / B^{(405)}_{(20)}| \times 100$ of the above formula [4-3], and $|[B^{(405)}_{(175)} - B^{(405)}_{(20)}] / B^{(405)}_{(20)}| \times 100$ of the above formula [4-4] are all usually 8 or smaller, preferably 5 or smaller, still more preferably 3 or smaller.

On the other hand, there is no limitation on the lower limits of these values, and they are ideally 0.

(I-1-6-2. Stability in emission intensity with respect to temperature change)

It is preferable for the phosphor of the present invention to satisfy the following formulae [5-1] to [5-4], when letting emission-peak intensities under excitation by 405 nm at 20°C±5°C, 60°C±5°C, 100°C±5°C, 135°C±10°C, and 175°C±10°C be "$I^{(405)}_{(20)}$", "$I^{(405)}_{(60)}$", "$I^{(405)}_{(100)}$", "$I^{(405)}_{(135)}$", and "$I^{(405)}_{(175)}$", respectively.

$$0 \leq |[I^{(405)}_{(60)} - I^{(405)}_{(20)}] / I^{(405)}_{(20)}| \times 100 \leq 30 \quad [5\text{-}1]$$

$$0 \leq |[I^{(405)}_{(100)} - I^{(405)}_{(20)}] / I^{(405)}_{(20)}| \times 100 \leq 30 \quad [5\text{-}2]$$

$$0 \leq |[I^{(405)}_{(135)} - I^{(405)}_{(20)}] / I^{(405)}_{(20)}| \times 100 \leq 30 \quad [5\text{-}3]$$

$$0 \leq |[I^{(405)}_{(175)} - I^{(405)}_{(20)}] / I^{(405)}_{(20)}| \times 100 \leq 30 \quad [5\text{-}4]$$

The above formulae [5-1] to [5-4] indicate that the rate of change of emission-peak intensities ($I^{(405)}_{(60)}$, $I^{(405)}_{(100)}$, $I^{(405)}_{(135)}$, and $I^{(405)}_{(175)}$) under excitation by 405 nm at 60°C±5°C, 100°C±5°C, 135°C±10°C, and 175°C±10°C relative to the emission-peak intensity ($I^{(405)}_{(20)}$) under excitation by 405 nm at 20°C±5°C is low. In other words, they indicate that the stability in emission intensity with respect to temperature changes is excellent.

Specifically, it is desirable that the upper limits of values $|[I^{(405)}_{(60)} - I^{(405)}_{(20)}] / I^{(405)}_{(20)}| \times 100$ of the above formula [5-1], $|[I^{(405)}_{(100)} - I^{(405)}_{(20)}] / I^{(405)}_{(20)}| \times 100$ of the above formula [5-2], $|[I^{(405)}_{(135)} - I^{(405)}_{(20)}] / I^{(405)}_{(20)}| \times 100$ of the above formula [5-3], and $|[I^{(405)}_{(175)} - I^{(405)}_{(20)}] / I^{(405)}_{(20)}| \times 100$ of the above formula [5-4] are all usually 30 or smaller, preferably 25 or smaller, more preferably 20 or smaller.

On the other hand, there is no limitation on the lower limits of these values, and they are ideally 0.

The rate of change of the emission intensity increases as the temperature rises. Therefore, of those in the above formulae [5-1] to [5-4], the rate of change of [5-4] is usually the largest. Accordingly, whether the formula [5-4] is satisfied or not is especially important from the standpoint of high-temperature stability. Moreover, it is preferable that the upper limit of the formula [5-3] is 15 or smaller. Furthermore, it is preferable that the upper limit of the formulae [5-1] and [5-2] are 15 or smaller, and more preferably, 10 or smaller.

(I-1-6-3. Measurement of temperature characteristics)

The above-mentioned temperature characteristics can be examined by a procedure described below using, for example, a multi-channel spectrum analyzer MCPD7000 manufactured by Otsuka Electronics Co., Ltd. as an emission spectrum device, a luminance colorimeter BM5A as a brightness measurement device, a stage equipped with a cooling mechanism using a peltiert device and a heating mechanism using a heater, and a light source device equipped with a 150-W xenon lamp.

A cell holding a phosphor sample is put on the stage, and the temperature is changed stepwise within the range from 20°C to 175°C. After verifying the surface temperature of the phosphor at each temperature, brightness value and emission spectrum are measured by exciting the phosphor with light from the light source having a wavelength of 405 nm, which is separated using a diffraction grating. Emission-peak intensity is decided from the measured emission spectrum. At this point, as the measurement value of the surface temperature of the phosphor on the side irradiated with the excitation light, is used a value corrected by temperature values measured with a radiation thermometer and a thermocouple.

<I-1-7. Weight median diameter>

There is no limitation on the weight median diameter ($D_{50}$) of the phosphor of the present invention insofar as the advantage of the present invention is not significantly impaired. It is preferable that it is in the range of usually 0.1 $\mu$m or larger, preferably 0.5 $\mu$m or larger, and usually 30 $\mu$m or smaller, preferably 20 $\mu$m or smaller. When the weight median diameter is too small, the brightness tends to decrease and the phosphor particles tend to aggregate. On the other hand, when the weight median diameter is too large, unevenness in coating, clogging in a dispenser or the like tends to occur. The weight median diameter of the phosphor of the present invention can be measured using a laser diffraction/scattering particle size distribution analyzer, for example.

The primary particles of the phosphors of the present invention, especially of the phosphors represented by the general formula [1] mentioned earlier, are usually hexagonal columns which are single grains that rarely agglutinate. The height of the hexagonal column represents the c-axis length of the crystal lattice. The average length of c-axis is preferably 2 $\mu$m or larger, more preferably 2.5 $\mu$m or larger, still more preferably 3 $\mu$m or larger, particularly preferably 3.3 $\mu$m or larger, still particularly preferably 3.5 $\mu$m or larger. Measurement of the average length of c-axis is usually performed with an SEM (scanning electron microscope). Specifically, the actual heights of the hexagonal columns shall be determined by the method of projections from the observed lengths of the three adjacent sides and heights of the hexagonal columns, since the numerous hexagonal columns of the primary particles in an SEM image are oriented in various directions.

The above-mentioned measurement is desirably performed usually on 10 or more of particles, preferably on 30 or more of particles, more preferably on 100 or more of particles, still more preferably 300 or more of particles. Actually, the number of particles to be measured also relates to the ratio to the total number of the crystalline particles. It is ideal to perform the measurement on every particle, but it can be performed in a ratio of usually 15% or higher, preferably 30% or higher, more preferably 50% or higher, still more preferably 80% or higher, relative to the total number of particles.

[I-2. Production method of phosphor]

Production method of the phosphor of the present invention is not particularly limited. It can be produced by, for example, pulverizing and mixing raw materials of elements constituting the phosphor (pulverization and mixing process) and firing the obtained mixture (hereinafter referred to as the "phosphor precursor" as appropriate) (firing process).

In the following description, materials of respective elements constituting the phosphor of the present invention will be represented by its atomic symbol added with "source". For example, the material of Al will be represented by "Al source". These materials will sometimes be collectively referred to as "materials of respective elements" as appropriate.

<I-2-1. Raw materials>

As materials for the phosphor of the present invention, materials of respective elements constituting the phosphor are used. There is no limitation on the combination or proportion of the materials of respective elements used. They can be selected as appropriate in accordance with the composition of the intended phosphor.

Examples of the materials of respective elements used to produce the phosphor of the present invention include: oxides, hydroxides, carbonates, nitrates, sulfates, oxalates, carboxylates and halides of the respective elements. Of these compounds, appropriate ones can be selected in light of reactivity into composite oxides and the amount of nitrogen oxides ($NO_x$), sulfur oxides ($SO_x$), or the like generated at the time of firing.

The examples of the materials of respective elements can be listed as follows in terms of the kind thereof.

Examples of Al source include: $Al_2O_3$, $Al(OH)_3$, $AlOOH$, $Al(NO_3)_3 \cdot 9H_2O$, $Al_2(SO_4)_3$, and $Al_2Cl_3$. Of these, $Al_2O_3$, $Al(NO_3)_3 \cdot 9H_2O$, and the like are preferable.

Examples of Ba source include: $BaO$, $Ba(OH)_2 \cdot 8H_2O$, $BaCO_3$, $Ba(NO_3)_2$, $BaSO_4$ $Ba(OCO)_2 \cdot 2H_2O$, Ba$(OCOCH_3)_2$ and $BaCl_2$. Of these, $Ba(OH)_2 \cdot 8H_2O$, $Ba(NO_3)_2$, $BaCO_3$, and the like are preferable.

Examples of Sr source include: $SrO$, $Sr(OH)_2 \cdot 8H_2O$, $SrCO_3$, $Sr(NO_3)_2$, $SrSO_4$ $Sr(OCO)_2 \cdot H_2O$, Sr$(OCOCH_3)_2 \cdot 0.5H_2O$ and $SrCl_2$. Of these, preferable are $SrCO_3$, $Sr(NO_3)_2$, $Sr(OH)_2 \cdot 8H_2O$, and the like.

Examples of Eu source include: $Eu_2O_3$, $Eu_2(SO_4)_3$, $Eu_2(OCO)_6$, $EuCl_2$, $EuCl_3$, $EuF_3$, and $Eu(NO_3)_3 \cdot 6H_2O$. Of

these, $Eu_2O_3$, $EuF_3$, $EuCl_3$, and the like are preferable.

Examples of Mn source include: $Mn(NO_3)_2 \cdot 6H_2O$, $MnO_2$, $Mn_2O_3$, $Mn_3O_4$, MnO, $Mn(OH)_2$, $MnCO_3$, $Mn(OCOCH_3)_2 \cdot 2H_2O$, $Mn(OCOCH_3)_3 \cdot nH_2O$, and $MnCl_2 \cdot 4H_2O$. Of these, $MnCO_3$, $Mn(NO_3)_2 \cdot 6H_2O$, MnO, and the like are preferable.

Examples of Mg source include: $Mg(OH)_2$, $Mg(NO_3)_2 \cdot 6H_2O$, $Mg(OCOCH_3)_2 \cdot 4H_2O$, $MgCl_2$, $MgCO_3$, basic magnesium carbonates, MgO, $MgSO_4$, and $Mg(C_2O_4 \cdot 2H_2O)$. Of these, $MgCO_3$, basic magnesium carbonates, MgO, and the like are preferable.

Examples of Ca source include: CaO, $Ca(OH)_2$, $CaCO_3$, $Ca(NO_3)_2 \cdot 4H_2O$, $CaSO_4 \cdot 2H_2O$, $Ca(OCO)_2 \cdot H_2O$, $Ca(OCOCH_3)_2 \cdot H_2O$ and $CaCl_2$. Of these, preferable are $CaCO_3$, $Ca(NO_3)_2 \cdot 4H_2O$, $CaCl_2$ and the like.

Examples of Zn source include: ZnO, $ZnF_2$, $ZnCl_2$, $Zn(OH)_2$, $Zn(C_2O_4) \cdot 2H_2O$ and $ZnSO_4 \cdot 7H_2O$.

These materials of respective elements can be used either as any single kind thereof or as a mixture of two or more kinds in any combination and in any ratio.

<I-2-2. Pulverization and mixing process>

There is no particular limitation on the method for pulverizing and mixing the materials of respective elements. The known examples listed below as (A) and (B) can be used arbitrarily. These methods can be carried out under known conditions, such as using two kinds of balls having different particle diameters while being mixed in a ball mill, as appropriate.

(A) Dry-type mixing methods in which materials, such as the materials of respective elements, are pulverized and mixed by combining pulverization, which is done by means of a dry-type pulverizer such as a hammer mill, roll mill, ball mill and jet mill, or pestle / mortar, and mixing, which is done by means of a mixing apparatus such as ribbon blender, V type blender and Henschel mixer, or pestle / mortar. In these methods, the materials of respective elements may be mixed after the pulverization, pulverized after the mixing, or pulverized and mixed at the same time.

(B) Wet-type methods in which after addition of solvents or dispersion media such as water or ethanol to the materials of respective elements, pulverization and mixing are done by means of a wet-type pulverizer such as a medium-stirring type pulverizer, pestle / mortar, evaporation dish / stirring rod or the like to make a solution or slurry by adding and mixing it in the media such as water, followed by drying by such method as spray drying, heated drying or air drying.

Of these pulverization and mixing methods, methods using a liquid medium are preferable because, for material compounds of luminescent center ion elements, it is desirable to use it in a small amount in a state of being mixed and dispersed homogenously. Particularly preferable are (B) wet-type methods because a homogenous mixture can be obtained even for materials of other elements. There is no limitation on the medium (solvent or dispersion medium) used in wet-type methods. Water, ethanol or the like is preferable.

The phosphor materials may be sieved at the time of mixing and pulverization mentioned above if necessary. In such a case, various kinds of commercially available sieves can be used. However, sieves made of a resin such as nylon mesh are more preferable than those of metal mesh for preventing contamination with impurities.

<I-2-3. Firing process>

(I-2-3-1. Firing conditions)

The mixture obtained is filled into a heat-resistant container such as a crucible or tray which is made of material unlikely to react with each phosphor material. Material examples of such heat-resistant containers used for a firing process include: ceramics such as alumina, quartz, boron nitride, silicon nitride, silicon carbide, magnesium and mullite; metals such as platinum, molybdenum, tungsten, tantalum, niobium, iridium and rhodium; alloys mainly constituted of these metals; and carbon (graphite). Of these, heat-resistant containers made of quartz can be used for heat treatment at relatively low temperatures such as 1200°C or lower, and the preferable temperature range of its use is 1000°C or lower.

Preferable examples of such heat-resistant containers include: heat-resistant containers made of alumina, boron nitride, silicon nitride, platinum, molybdenum, tungsten, and tantalum. Of these, heat-resistant containers made of alumina, boron nitride, or molybdenum are preferable. Ones made of boron nitride or molybdenum is more preferable. Particularly preferable are alumina ones because they are stable even at firing temperatures range in a nitrogen-hydrogen reducing atmosphere.

The filling rates (hereinafter referred to as "filling rate into heat-resistant container") at which the phosphor precursors are filled into the above-mentioned heat-resistant containers differ depending on the firing conditions. However, the rate may be such that the pulverization of the fired product will not be difficult at the post-treatment steps to be described later. Therefore, it is usually 10 volume % or larger, and usually 90 volume % or smaller. Meanwhile, there are gaps between the phosphor precursor particles, namely particles of the phosphor materials, filled in a crucible. Therefore, the volume which the phosphor materials occupy themselves in 100 ml of the heat-resistant container is usually 10 ml or larger, preferably 15 ml or larger, more preferably 20 ml or larger, and usually 50 ml or smaller, preferably 40 ml or smaller, more preferably 30 ml or smaller.

When a large amount of phosphor precursors is treated at one time, it is preferable to make heat distributed uniformly within the heat-resistant container for example by decelerating the temperature rising rate.
The filling rate (hereinafter referred to as "filling rate into furnace" as appropriate) at which the heat-resistant containers are filled into a furnace is preferably such that the heat-resistant containers will be heated uniformly in the furnace.
When a large number of heat-resistant containers are fired in the firing furnace, it is preferable for the uniformity of firing to distribute heat uniformly to each heat-resistant container, for example by decelerating the above-mentioned temperature rising rate.
When a metal carbonate is used as a phosphor material, it is preferable to perform a prebake to change it into metal oxide at least partly for the sake of preventing a firing furnace damage due to carbon dioxide desorbed.

A part of firing treatment is preferably carried out at reduced pressure on the way of temperature rising. Specifically, the reduced pressure condition (specifically, $10^{-2}$ Pa or higher and 0.1 MPa or lower as usual) is preferably provided at a certain point of time when the temperature is preferably room temperature or higher and preferably 1500°C or lower, more preferably 1200°C or lower, still more preferably 1000°C or lower. Particularly, it is preferable to perform the temperature rising with an inert gas or reducing gas, to be described later, introduced in the system after reducing the pressure in the system.
During the pressure reduction, the temperature may be retained if necessary at a desired value for 1 minute or longer, preferably 5 minutes or longer, and more preferably 10 minutes or longer. The retention period is usually 5 hours or shorter, preferably 3 hours or shorter, and more preferably 1 hour or shorter.

There is no limitation on the atmosphere at the time of firing. Usually, a single kind of gas or a mixed gas of two or more kinds of gases out of air, oxygen, carbon monoxide, carbon dioxide, nitrogen, hydrogen, argon and the like are used.
The atmosphere at the time of firing can be selected in light of reactivity with the materials of respective elements such as oxides, hydroxides, carbonates, basic carbonates, nitrates, sulfates, oxalates, carboxylates, halides or the like and the amount of $NO_x$, $SO_x$ or the like generated at the time of firing. It is particularly preferable to select an atmosphere necessary for the luminescent center ion element to be in an ion state (valence) that can contribute to luminescence.
Especially when a phosphor of the present invention containing bivalent Eu or the like is produced, inert or reducing gases such as carbon monoxide, nitrogen, hydrogen, argon or the like are preferable. However, oxidizing atmospheres such as air, oxygen or the like can also be used depending on conditions.
A firing in a carbon monoxide atmosphere can be executed by, for example, putting carbon powders or carbon cubes such as graphite, carbon or the like in the vicinity of the phosphor material or introducing a carbon monoxide gas in the furnace.

When the firing is done in a weakly reducing atmosphere, it is preferable to use hydrogencontaining nitrogen. In such a case, it is preferable that oxygen concentration in an electric furnace is kept at 20 ppm or lower. Further, it is preferable that hydrogen content in the atmosphere is 1 volume % or higher and 5 volume % or lower, more preferably 2 volume % or higher. This is because, when the content of hydrogen in the atmosphere is too high, safety may not be guaranteed. When it is too low, sufficient reducing atmosphere may not be secured.
The above-mentioned inert gas or reducing gas can be introduced either before starting the temperature rising or in the course of the temperature rising. Or otherwise, it can be introduced when the temperature reaches a firing temperature. It is particularly preferable to introduce it before or in the course of the temperature rising.
When the firing is carried out under a flow of such an inert gas or reducing gas, the flow rate is usually 0.1 L/min to 10 L/min.

The firing temperature is in the range of usually 1200°C or higher, preferably 1400°C or higher, more preferably 1500°C or higher, and usually 1750°C or lower, preferably 1700°C or lower, more preferably 1650°C or lower. When the firing temperature is too low, the crystal may not grow fully, leading possibly to a smaller particle diameter. On the other hand, when the firing temperature is too high, the crystal may grow excessively, leading possibly to too large a particle diameter.

The pressure at the time of firing differs depending on such factors as firing temperature. It is usually normal pressure or higher.

The firing time differs depending on the temperature, pressure or the like of the firing. It is usually 0.5 hours or longer, preferably 1 hour or longer. It is preferable for the firing time to be long. However, it is usually 100 hours or shorter, preferably 50 hours or shorter, more preferably 24 hours or shorter, still more preferably 12 hours or shorter.

(I-2-3-2. Flux)

The production method of the present invention is **characterized in that** the above-mentioned mixture (phosphor precursor) of the materials of respective elements is fired in the presence of univalent metal element halide of a predetermined concentration, which is contained in the reaction system as flux. By performing firing of the phosphor precursor in the presence of a univalent metal element halide of a predetermined concentration, a phosphor (phosphor of the present invention) that stably shows high emission intensity and brightness as well as superior temperature characteristics, even under excitation by a near-ultraviolet light, can be obtained.

Examples of the univalent metal element (alkali metal element) include: K (potassium), Na (sodium), Li (lithium), Cs (cesium), and Rb (rubidium). Of these, K, Na, and Li are preferable. K and Na are particularly preferable. Examples of the halogen element include:

fluorine (F), chlorine (Cl), bromine (Br), and iodine (I). Of these, F and Cl are preferable. F is particularly preferable.

Examples of the univalent metal element halide include: KF (potassium fluoride), NaF (sodium fluoride), LiF (lithium fluoride), CsF (cesium fluoride), and RbF (rubidium fluoride). Of these, KF, NaF, and LiF are preferable. KF and NaF are particularly preferable. These univalent metal element halides can be used either as any single kind of them or as a mixture of two or more kinds of them in any combination and in any ratio.

The ratio of the univalent metal element halide used relative to the amount of the phosphor precursor is usually higher than 0 weight %, preferably 0.05 weight % or higher, more preferably 0.1 weight % or higher, still more preferably 0.2 weight % or higher, particularly preferably 0.25 weight % or higher, still particularly preferably 0.30 weight % or higher, and usually lower than 1 weight %, preferably 0.95 weight % or lower, more preferably 0.9 weight % or lower.

In the case where an other-valency metal element halide (for example, bivalent or trivalent metal element halide to be described later) is used in addition to a univalent metal element halide, the above-mentioned advantageous effect can be achieved even when using a small amount of univalent metal element halide.

Specifically, when firing is performed in the presence of a multivalent (other-than univalent) metal element halide in a ratio of 0.15 weight % or higher relative to the amount of the phosphor precursor, the ratio of the univalent metal element halide used relative to the amount of the phosphor precursor is usually higher than 0 weight %, preferably 0.04 weight % or higher, more preferably 0.08 weight % or higher, still more preferably 0.13 weight % or higher, and usually lower than 1 weight %, preferably 0.95 weight % or lower, more preferably 0.9 weight % or lower.

When the amount of univalent metal element halide used is too small, emission efficiency of the obtained phosphor may not be fully improved. When the amount of univalent metal element halide used is too large, temperature characteristics of the obtained phosphor may decrease.

When two or more kinds of univalent metal element halides are used in combination, the total amount of them shall be adjusted to fall within the above range.

By the production method of the present invention, in which firing is performed in the presence of a univalent metal element halide of a concentration lower than before relative to the phosphor precursor as described earlier, a phosphor (phosphor of the present invention) that stably shows high emission intensity and brightness as well as superior temperature characteristics even under excitation by near-ultraviolet light can be obtained.

The reason for such an advantageous effect is not clear. By the present inventors' speculation, it is probably because the excitation spectrum intensity is increased by well-grown crystals and/or change in lattice defect amount due to substitution of the univalent metal element for a part of Ba or Mg sites accelerates respective processes leading to green emission. In this case, the use of Na for example as the univalent metal element may form intermediate such as $NaAlF_4$ or $NaBaF_3$, which may lead to such an advantageous effect.

In the production method of the present invention, as flux used for firing the phosphor precursor, a bivalent metal element halide such as $BaF_2$ or $MgF_2$ (preferably, a fluoride of bivalent metal element) and a trivalent metal element halide such as described below, in addition to the above-mentioned univalent metal element halide. There is no limitation on the kinds of these halides.

Examples of the above-mentioned trivalent metal element include: rare-earth elements such as La (lanthanum), and Y (yttrium), Al (aluminium), Sc (scandium). Of these, Al is preferable.

Examples of the trivalent metal element halide include: $AlF_3$ (aluminium fluoride) and $AlCl_3$ (aluminium chloride). These can be used either as a single kind thereof or as a mixture of more than one kind in any combination and in any ratio.

It is preferable that the ratio of the multivalent (other-than-univalent) metal element halide used relative to the amount of the phosphor precursor is usually higher than 0 weight %, preferably 0.05 weight % or higher, more preferably 0.1 weight % or higher, still more preferably 0.2 weight % or higher, and usually 15 weight % or lower, preferably 10 weight % or lower, more preferably 7 weight % or lower. When the ratio of the multivalent metal element halide used is too high, the advantageous effect of increase in emission efficiency under excitation by near-ultraviolet light may be lost rather than achieved. When two or more kinds of multivalent metal element halides are used in combination, the total amount of them shall be adjusted to fall within the above range.

(I-2-3-3. Multiple firing)

In order to improve crystallinity by promoting solid state reaction in the firing process, firing may be performed in multiple steps. Specifically, after firing (first firing process) of the phosphor precursor obtained by the mixing process, the fired product is further fired (second firing process) one or more times. Before those additional firings, pretreatment such as pulverization and/or washing may be carried out if necessary.

The additional firings are performed under appropriately-selected firing conditions within the same ranges as described before. At this point, it is preferable to perform at least more than one time of the latter firing process of certain two successive firing processes at higher firing temperature because it can accelerate the crystal growth of the phosphor and thus enhance the crystallinity.

A pulverization process is performed to pulverize the fired product (namely, the substance obtained by firing) when the fired product is too large. There is no special limitation on the method of such pulverization. For example, dry-type pulverization methods and wet-type pulverization methods that were listed in the section of mixing process of the phosphor materials can be used.

A washing process is performed when adherents to the fired product such as impurity phases should be preferably removed. It is particularly effective to perform it after the first firing process and/or before the last firing process. The washing can be done using, for example, water such as deionized water, organic solvent such as ethanol, and alkaline aqueous solution such as ammonia water. Further, water solutions of inorganic acids such as hydrochloric acid, nitric acid and sulfuric acid or water solutions of organic acids such as acetic acid can also be used, for example for the purpose of improving luminescent characteristics by removing impurity phases such as flux attached to the surface of the fired product. In such a case, it is preferable that, after a washing with an acidic aqueous solution, an additional washing is carried out with water.

It is preferable to perform the washing to the extent that the pH of the supernatant fluid obtained by dispersing the washed fired product in water which is 10 times as heavy as the phosphor and leaving it to stand for 1 hour becomes neutral (pH of around 5 to 9). This is because a deviation toward basicity or acidity may adversely affect the liquid medium, to be described later, or the like when the phosphor is mixed with the liquid medium.

The above-mentioned extent of washing can also be indicated by the electric conductivity of the supernatant fluid that is obtained by dispersing the washed phosphor in water which is 10 times as heavy as the phosphor and leaving it to stand for 1 hour. The lower the electric conductivity is, the more preferable, from the standpoint of higher luminescent characteristics. However, also in consideration of the productivity, it is preferable to repeat the washing treatments until the electric conductivity reaches usually 10 mS/m or lower, preferably 5 mS/m or lower, and more preferably 4 mS/m or lower.

The method for measuring the electric conductivity is as follows. The fired product particles, which have larger specific gravity than water, are allowed to precipitate spontaneously, by leaving them to stand for 1 hour after they are stirred in water which is 10 times as heavy as the fired product for a predetermined period of time, for example 10 minutes. The electric conductivity of the supernatant fluid at that time can be measured using a conductance meter, "EC METER CM-30G", manufactured by DKK-TOA CORPORATION or the like. There is no special limitation on the water used for the washing treatment and measurement of the electric conductivity, but desalted water or distilled water is preferable. Among them, the one having low electric conductivity is particularly preferable. Its electric conductivity shall be usually 0.0064 mS/m or higher, and usually 1 mS/m or lower, preferably 0.5 mS/m or lower. The measurement of the electric conductivity is usually carried out at a room temperature (around 25°C).

When carrying out a multistep firing, the flux can be added in any firing step. It is particularly effective to use it in the first firing process and/or the last firing process. In such a case, firing conditions such as atmosphere may differ between each firing step.

When the number of crucibles set in the firing furnace during the above-mentioned firing is large, it is preferable to distribute heat uniformly to each crucible for example by decelerating the above-mentioned temperature rising rate, for the sake of uniformity of firing.

<I-2-4. Post-treatment>

In the production of phosphors, other processes than described above can also be carried out. For example, reheating (anneal), pulverization, washing, drying, and classification treatment are performed if considered appropriate, after the heat treatment in the above firing step.

In the reheating process, the phosphor obtained in the firing process is heated at lower temperatures than the firing temperature.

The heating temperature in the reheating process is usually lower than 1200°C, preferably 1000°C or lower, more preferably 800°C or lower, and usually 300°C or higher, preferably 400°C or higher, more preferably 500°C or higher, particularly preferably 600°C or higher.

The atmosphere, pressure, and time of heat treatment in the reheating process can be the same as those described for the firing process, for example.

It is probable that such a reheating process further reduces deformations or defects within the phosphor crystals, which makes it possible to improve the crystallinity of the phosphor, to reform the phosphor surface, and also to improve the phosphor durability. In addition, the atmosphere at the time of heat treatment in the reheating process may be a reducing atmosphere, by which $Eu^{3+}$ of the Eu, an activation element, can be converted to $Eu^{2+}$.

The reheating process can be performed either on the phosphor after subjected to the firing process mentioned above, or on the phosphor after subjected to treatments such as pulverization, washing, or classification to be described later.

The pulverization treatment is performed on a fired product, for example when the phosphor obtained does not have desired particle diameters. There is no special limitation on the method of pulverization treatment. For example, dry-type pulverization methods and wet-type pulverization methods that were listed in the section of mixing process of the phosphor materials can be used. For the purpose of, for example, crushing the secondary particles while preventing destruction of the phosphor crystals generated, it is preferable to perform a ball milling for on the order of 10 minutes to 24 hours using, for example, a container made of alumina, silicon nitride, $ZrO_2$ glass or the like putting balls made of the same materials as the container, iron-core urethane, or the like. In this case, a dispersant such as an organic acid or a alkaline phosphate like hexametaphosphate can be used at 0.05 weight % to 2 weight %.

The washing process can be performed, for example in the same way as the washing process performed between the first firing process and the second firing process.

The classification treatment can be done by means of, for example, levigation or elutriation. Or otherwise, it can be done using various classifiers such as an air current classifier or vibrating sieve. Particularly, a dry classification using a nylon mesh can be preferably used to obtain a phosphor of good dispersibility with a weight median diameter of about 20 $\mu$m.

In a levigation or elutriation treatment, the pH of the aqueous medium shall be set at usually 4 or larger, preferably 5 or larger, and usually 9 or smaller, preferably 8 or smaller, usually in order for phosphor particles to be dispersed in an aqueous medium at a concentration of around 0.1 weight % to 10 weight % and also to prevent the degradation of the phosphor. In addition, for achieving the phosphor particles with a weight median diameter such as described above by a levigation or elutriation treatment, it is preferable to perform two-step sieving in which, for example, particles of 50 $\mu$m or smaller are sifted out and then particles of 30 $\mu$m or smaller are sifted out, from the standpoint of balance between the operating efficiency and yield. Regarding the lower limit of sieving, it is preferable to sift out particles of usually 1 $\mu$m or larger, preferably 5 $\mu$m or larger.

When a light emitting device is produced using the obtained phosphor of the present invention by a method described later, the surface of the phosphors may be subjected to surface treatment if necessary such as covering the surfaces with some foreign compound, in order to improve weatherability such as moisture resistance or improve dispersibility in a resin in the phosphor-containing part of the light emitting device described later.

Examples of the substance that can be applied to the phosphor surface (hereinafter referred to as "surface treatment substance" as appropriate) include: organic compounds, inorganic compounds, and glass materials.

Examples of the organic compounds include:

thermofusible polymer such as acrylic resin, polycarbonate, polyamide and polyethylene; latex; and polyorganosiloxane.

Examples of the inorganic compounds include:

metal oxides such as magnesium oxide, aluminum oxide, silicon oxide, titanium oxide, zirconium oxide, tin oxide, germanium oxide, tantalum oxide, niobium oxide, vanadium oxide, boron oxide, antimony oxide, zinc oxide, yttrium oxide and bismuth oxide; metal nitrides such as silicon nitride and aluminum nitride; orthophosphates such as calcium phosphate, barium phosphate and strontium phosphate; polyphosphate; and combinations of calcium salt and

phosphates of alkali metals and/or alkaline-earth metals such as a combination of calcium nitrate and sodium phosphate.

Examples of the glass material include: boron silicate, phosphorus silicate, and alkali silicate.

These surface treatment substances can be used either as a single one or as a combination of two or more kinds in any combination and in any ratio.

For the phosphor represented by the formula [1] described above, calcium phosphate is used particularly preferably as surface treatment substance.

The phosphor of the present invention obtained by the above surface treatment has a surface treatment substance existing on its surface. The mode of existence of the surface treatment substance can be as follows, for example.

(i) The above surface treatment substance constitutes a continuous layer and covers the surface of the phosphor.
(ii) The above surface treatment substance is attached to the surface of the phosphor as numerous microparticles and these microparticles cover the surface of the phosphor.

There is no special limitation on the amount of the surface treatment substance which can cover or be attached to the surface of the phosphor, insofar as the advantage of the present invention is not significantly impaired. However, the amount, relative to the weight of the phosphor, is usually 0.1 weight % or more, preferably 1 weight % or more, more preferably 5 weight % or more, still more preferably 10 weight % or more, and usually 50 weight % or less, preferably 30 weight % or less, more preferably 20 weight % or less. When the amount of the surface treatment substance relative to that of the phosphor is too large, the luminescent characteristics of the phosphor may be impaired. When it is too small, the coverage of the surface may be insufficient, and moisture resistance and dispersibility may not be improved.

There is no special limitation on the film thickness (layer thickness) of the surface treatment substance formed by the surface treatment, insofar as the advantage of the present invention is not significantly impaired. However, it is usually 10 nm or larger, preferably 50 nm or larger, and usually 2000 nm or smaller, preferably 1000 nm or smaller. When the layer is too thick, the luminescent characteristics of the phosphor may be impaired. When it is too thin, the coverage of the surface may be insufficient, and moisture resistance and dispersibility may not be improved.

No particular limitation is imposed on the method of such surface treatment. The examples include the following coating treatment method using a metal oxide (silicon oxide).

The phosphor of the present invention is added to an alcohol such as ethanol, mixed and stirred. To this is added an alkaline aqueous solution such as ammonia water, followed by stirring. A hydrolyzable silicic acid alkyl ester such as tetraethyl orthosilicate is then added and the mixture is stirred. The solution obtained is allowed to stand for 3 minutes to 60 minutes, and then the supernatant containing silicon oxide particles which remain unattached to the surface of the phosphor is removed by pipetting or the like. Then, mixing in alcohol, stirring, allowing to stand and removal of the supernatant are repeated several times and a drying is performed under a reduced pressure at 120°C to 150°C for 10 minutes to 5 hours, for example 2 hours. Thereby, a surface-treated phosphor is obtained.

Examples of other surface treatment methods of phosphors include: various known methods such as a method in which spherical silicon oxide fine powder is attached to the phosphor (Japanese Patent Laid-Open Publications No. 2-209989 and No. 2-233794), a method in which a coating film of Si-compound is attached to the phosphor (Japanese Patent Laid-Open Publication No. 3-231987), a method in which the surface of the phosphor is covered with polymer microparticles (Japanese Patent Laid-Open Publication No. 6-314593), a method in which the phosphor is coated with organic, inorganic, grass and the like materials (Japanese Patent Laid-Open Publication No. 2002-223008), a method in which the surface of the phosphor is covered by means of chemical vapor reaction (Japanese Patent Laid-Open Publication No. 2005-82788), and a method in which particles of a metal compound is attached (Japanese Patent Laid-Open Publication No. 2006-28458).

[I-3. Use of phosphor]

The phosphor of the present invention can be used for any purposes that use a phosphor. Mainly, it can be used for a variety of light emitting devices ("light emitting devices of the present invention" to be described later) preferably.

The phosphor of the present invention shows different luminescent colors depending on its composition or the like. When it contains both Eu and Mn, it usually comes to be a green phosphor. When it contains Eu, it usually comes to be a blue phosphor.

A white light emitting device can be produced by, for example, using an near-ultraviolet excitation light source, an orange or red phosphor (hereinafter referred to as "orange/red phosphor"), and a blue or green phosphor (hereinafter referred to as "blue/green phosphor"). As the blue/green phosphor, a phosphor of the present invention can be used either alone or in combination with other blue/green phosphor.

A white light emitting device can also be produced by, for example, using an near-ultraviolet excitation light source, a yellow phosphor, and a blue/green phosphor. As the blue/green phosphor, a phosphor of the present invention can be used either alone or in combination with other blue/green phosphor.

In these cases, the luminescent color can be modified freely by means of adjusting the luminous wavelength of the phosphor of the present invention or the other blue/green phosphor. For example, even an emission spectrum that is similar to the so-called pseudo-white (the luminescent color of a light emitting device combining a blue LED and a yellow phosphor, for example) emission spectrum can be obtained.

Furthermore, by incorporating a red phosphor in this white light emitting device, a light emitting device that extremely excels in red color rendering or that emits warm white light can be produced.

By further adjusting the kinds or contents of the phosphors combined, light emitting devices having other various luminescent colors can also be produced. The luminescent color of the light emitting devices is not limited to white. Appropriate combination of a yellow phosphor (phosphors emitting yellow fluorescence), blue phosphor, orange/red phosphor, green phosphor and the like and appropriate adjustment of kinds or contents of the phosphors can prepare light emitting devices emitting arbitrary color lights. The light emitting devices thus obtained can be used for illuminating devices or illuminant portions of displays (especially, backlights of liquid crystal displays).

The phosphor of the present invention shows stable emission intensity when excited by light of excitation wavelength 340 nm to 400 nm (the characteristic of the formula [2] above) and also shows stable emission intensity when excited by light of excitation wavelength, preferably, 382 nm to 390 nm (the characteristic of the formula [3] above). From these characteristics, the phosphor of the present invention can give a light emitting device with high emission efficiency by incorporating a luminous body that emits near-ultraviolet light, such as an LED, as an excitation light source. Furthermore, even when incorporating a plurality of LED light sources as excitation light sources, there is little possibility of nonuniformity in the color tones or intensities of the luminescences, which may be caused by wavelength variations of the excitation light sources. In consequence, light emitting devices having uniform luminescent colors can be produced in good yield.

[II. Phosphor-containing composition]

Any phosphor of the present invention mentioned above can be used as a mixture with a liquid medium. Especially when a phosphor of the present invention is used for a light emitting device or the like, it is preferable to use it by dispersing it in a liquid medium and curing it by heat or light after it is sealed. The phosphor of the present invention that is dispersed in a liquid medium will be referred to as the "phosphor-containing composition of the present invention" as appropriate.

[II-1. Phosphor]

There is no limitation on the type of the phosphor of the present invention to be contained in the phosphor-containing composition of the present invention, and any of that can be selected from those described above. The phosphor of the present invention to be contained in the phosphor-containing composition of the present invention can be used as a single kind thereof or as a mixture of two or more kinds in any combination and in any ratio. Furthermore, in the phosphor-containing composition of the present invention, a phosphor other than the phosphor of the present invention can be contained, insofar as the advantage of the present invention is not significantly impaired.

[II-2. Liquid medium]

There is no special limitation on the kind of a liquid medium used for the phosphor-containing composition of the present invention, insofar as the performance of the phosphor can be sufficient enough to achieve the object of the present invention. For example, any inorganic material and/or organic material can be used, insofar as it exhibits liquid characteristics under a desired use condition and lets the phosphor of the present invention be dispersed preferably without any unfavorable reaction.

Examples of the inorganic materials include:

metal alkoxide, ceramic precursor polymer, a solution obtained by hydrolytic polymerization of a solution containing metal alkoxide using a sol-gel method (such as an inorganic material containing siloxane bond).

Examples of the organic materials include

thermoplastic resin, thermosetting resin and light curing resin. More specifically, the examples include: methacrylic resin such as polymethacrylate methyl; styrene resin such as polystyrene, styreneacrylonitrile copolymer; polycarbonate resin; polyester resin; phenoxy resin; butyral resin; polyvinyl alcohol; cellulose resin such as ethyl cellulose, cellulose acetate and cellulose acetate butyrate; epoxy resin; phenol resin; and silicone resin.

Of these, a silicon-containing compound as a liquid medium can be preferably used from the standpoint of high heat resistance, high light resistance and the like, particularly when the phosphor of the present invention is used for a high-power light emitting device such as an illuminating device.

Silicon-containing compound means a compound of which molecular contains a silicon atom. Examples thereof include organic materials (silicone materials) such as polyorganosiloxane, inorganic materials such as silicon oxide, silicon nitride and silicon oxynitride, glass materials such as borosilicate, phosphosilicate and alkali silicate. Among them, silicone materials are preferably used from the standpoint of ease in handling or the like.

The above-mentioned silicone material usually indicates organic polymers having a siloxane bond as the main chain. Examples thereof include compounds represented by the following general composition formula (i) and/or mixtures of them.

$$(R^1R^2R^3SiO_{1/2})_M(R^4R^5SiO_{2/2})_D(R^6SiO_{3/2})_T(SiO_{4/2})_Q \qquad \text{formula (i)}$$

In the general composition formula (i), $R^1$ to $R^6$ are each selected from the group consisting of organic functional group, hydroxyl group and hydrogen atom. $R^1$ to $R^6$ can be the same as or different from each other.

In addition, M, D, T and Q of the above-mentioned formula (i) are each number of 0 or greater and smaller than 1, and they satisfies M+D+T+Q=1.

The silicone material can be used after being sealed with a liquid silicone material and cured by heat or light, when used for sealing a semiconductor luminous element.

When categorizing silicone materials based on the curing mechanism, they usually fall into such categories as addition polymerization-curable type, polycondensation-curable type, ultraviolet ray-curable type and peroxide vulcanized type. Of these, preferable are addition polymerization-curable type (addition type silicone material) and condensation-curable type (condensing type silicone material) and ultraviolet ray-curable type. In the following, addition type silicone material and a condensing type silicone material will be explained.

An addition type silicone material represents a material in which polyorganosiloxane chain is crosslinked by means of organic additional bond. Typical examples thereof include a compound having an Si-C-C-Si bond as the crosslinking point, which can be obtained through a reaction between vinylsilane and hydrosilane in the presence of an addition type catalyst such as Pt catalyst. As such compounds, commercially available ones can be used. For example, as concrete commercial names of an addition polymerization-curable type can be cited "LPS-1400", "LPS-2410" and "LPS-3400", manufactured by Shin-Etsu Chemical Co., Ltd.

On the other hand, examples of a condensing type silicone material include a compound having an Si-O-Si bond as the crosslinking point, which can be obtained through hydrolysis and polycondensation of alkyl alkoxysilane. Specific examples thereof include: a polycondensate obtained by performing hydrolysis and polycondensation of compounds represented by the following general formula (ii) and/or (iii), and/or an oligomer thereof.

$$M^{m+}X_nY^1_{m-n} \qquad \text{(ii)}$$

(In the formula (ii), M represents at least one element selected from silicon, aluminum, zirconium and titanium, X represents a hydrolyzable group, $Y^1$ represents a monovalent organic group, m represents an integer of 1 or larger representing the valence of M, and n represents an integer of 1 or larger representing the number of X groups, where m≥n.)

$$(M^{s+}X_tY^1_{s-t-1})_uY^2 \qquad \text{(iii)}$$

(In the formula (iii), M represents at least one element selected from silicon, aluminum, zirconium and titanium, X represents a hydrolyzable group, $Y^1$ represents a monovalent organic group, $Y^2$ represents a u-valent organic group, s represents an integer of 1 or larger representing the valence of M, t represents an integer of 1 or larger and s-1 or smaller, and u represents an integer of 2 or larger.)

The condensing type silicone material may contain a curing catalyst. As the curing catalyst, a metal chelate compound can be used preferably, for example. The metal chelate compound preferably contains at least one of Ti, Ta and Zr, and more preferably contains Zr. The curing catalysts may be used either as a single kind thereof or as a mixture of more than one kind in any combination and in any ratio.

As such a condensing type silicone material can be used preferably, for example, semiconductor light emitting device members disclosed in Japanese Patent Laid-Open Publications (Kokai) No. 2007-112973 to No. 2007-112975, Japanese Patent Laid-Open Publication (Kokai) No. 2007-19459, and Japanese Patent Application No. 2006-176468.

In the following, particularly preferable ones among condensing type silicone materials will be explained.

Silicone materials generally have such problems as low adhesiveness to the semiconductor luminous element, the substrate at which the element is disposed, the package and the like. However, as a silicone material with especially high adhesion can be preferably used a condensing type silicone material having the following characteristics [1] to [3].

[1] The silicon content ratio is 20 weight % or more.
[2] In the solid Si-nuclear magnetic resonance (NMR) spectrum, measured by a method to be described later in detail, it has at least one of Si-originated peaks of the following (a) and/or (b).

(a) A peak whose peak top position is in an area of a chemical shift of -40 ppm or more and 0 ppm or less, with reference to tetramethoxysilane, and whose full width at half maximum is 0.3 ppm or more and 3.0 ppm or less.
(b) A peak whose peak top position is in an area of a chemical shift of -80 ppm or more and less than -40 ppm, with reference to tetramethoxysilane, and whose full width at half maximum is 0.3 ppm or more and 5.0 ppm or less.

[3] The silanol content ratio is 0.1 weight % or more and 10 weight % or less.

It is preferable that the silicone material in the present invention has the characteristic [1], among the above-mentioned characteristics [1] to [3]. It is more preferable that the silicone material has the above-mentioned characteristics [1] and [2]. It is particularly preferable that the silicone material has all the above-mentioned characteristics [1] to [3]. In the following, the above-mentioned characteristics [1] to [3] will be explained.

[II-2-1. Characteristic [1] (silicon content ratio)]

The silicon content ratio in the silicone material that is preferable for the present invention is usually 20 weight % or more. However, it is particularly preferably 25 weight % or more, and more particularly preferably 30 weight % or more. On the other hand, the upper limit thereof is usually 47 weight % or less, because the silicon content ratio of a grass, consisting only of $SiO_2$, is 47 weight %.
The silicon content ratio of a silicone material can be calculated based on the result of inductively coupled plasma spectrometry (hereinafter abbreviated as "ICP" when appropriate) analysis, carried out in accordance with, for example, a method described below.

{Measurement of silicon content ratio}

A silicone material is kept in a platinum crucible in the air at 450°C for 1 hour and then at 750°C for 1 hour and at 950°C for 1.5 hours for firing. After removal of carbon components, the small amount of residue obtained is added with a 10-fold amount or more of sodium carbonate, and then heated by a burner to melt it. Then the melted product is cooled and added with desalted water, being diluted to several ppm in silicon, while adjusting pH value to around neutrality using hydrochloric acid. And then ICP analysis is performed.

[II-2-2. Characteristic [2] (solid Si-NMR spectrum)]

When measuring the solid Si-NMR spectrum of a silicone material preferable for the present invention, at least one, preferably two or more of peaks can be observed in the aforementioned peak regions (a) and/or (b), originating from a silicon atom directly bonded with a carbon atom of an organic group.
Summarizing in terms of chemical shifts, in a silicone material preferable for the present invention, the full width at half maximum of the peak described in (a) is generally smaller than that of the peak of (b) described later, due to smaller constraints of molecular motion. Namely, it is in the range of usually 3.0 ppm or less, preferably 2.0 ppm or less, and usually 0.3 ppm or more.
On the other hand, the full width at half maximum of the peak described in (b) is in the range of usually 5.0 ppm or less, preferably 4.0 ppm or less, and usually 0.3 ppm or more, preferably 0.4 ppm or more.
If the full width at half maximum of a peak observed in the above chemical shift areas is too large, a state in which constraints of molecular motion are large and thus the distortion is large is created, leading possibly to forming a member inferior in heat resistance, weather resistance and durability and of which cracks are more likely to appear. For example when a lot of tetrafunctional silane is used or when large internal stress is generated by a rapid drying in the drying process, the range of the full width at half maximum will be larger than the above range.
If the full width at half maximum of the peak is too small, Si atoms existing in its environment are not involved in the siloxane crosslinking. In such a case, for example when trifunctional silane remains in a non-crosslinked state, the obtained member may be inferior in heat resistance, weather resistance and durability to materials formed mainly of siloxane bonds.
However, even if a peak, of the above-mentioned range of the full width at half maximum, is observed in an area of -80 ppm or more in a silicone material containing a small amount of Si component in a large amount of organic components, the heat resistance, light resistance and coating properties may not be excellent.

The chemical shift value of a silicone material preferable for the present invention can be calculated based on the results of a solid Si-NMR measurement performed by, for example, a method described below. Also, the measured data (the full width at half maximum and silanol amount) is analyzed by a method in which each peak is divided and extracted by the waveform separation analysis or the like utilizing, for example, the Gauss function or Lorentz function.

{Solid Si-NMR spectrum measurement and calculation of the silanol content ratio}

When measuring the solid Si-NMR spectrum of a silicone material, the solid Si-NMR spectrum measurement and the waveform separation analysis are performed under the following conditions. Further, the full width at half maximum of each peak is determined, for the silicone material, based on the obtained waveform data. In addition, the silanol content ratio is determined by comparing the ratio (%) of silicon atoms in silanol to all silicon atoms, decided from the ratio of peak areas originating from silanol to all peak areas, with the silicon content ratio analyzed separately.

{Device conditions}

Device: Infinity CMX-400 nuclear magnetic resonance spectroscope, manufactured by Chemagnetics Inc.

$^{29}$Si resonance frequency: 79.436 MHz
Probe: 7.5 mm $\phi$ CP/MAS probe
Temperature: Room temperature
Rotational frequency of sample: 4 kHz
Measurement method: Single pulse method
$^{1}$H decoupling frequency: 50 kHz
$^{29}$Si flip angle: 90°
$^{29}$Si 90° pulse width: 5.0 $\mu$s
Repetition time: 600 s
Total count: 128 times
Observation width: 30 kHz
Broadening factor: 20 Hz
Authentic sample: tetramethoxysilane

For a silicone material, 512 points are taken in as measured data and zero-filled to 8192 points, before Fourier transformation is performed.

{Waveform separation analysis method}

For each peak of the spectrum after Fourier transformation, an optimization calculation is performed by the nonlinear least square method using the center position, height and full width at half maximum of a peak shape, created by a Lorentz waveform, Gauss waveform or a mixture of both, as variable parameters.
For identification of a peak, AIChE Journal, 44(5), p. 1141, 1998 or the like can be referred.

[II-2-3. Characteristic [3] (silanol content ratio)]

The silanol content ratio of a silicone material preferable for the present invention is in the range of usually 0.1 weight % or more, preferably 0.3 weight % or more, and usually 10 weight % or less, preferably 8 weight % or less, more preferably 5 weight % or less. When the silanol content is small, the silanol [sic] material varies little over time and can be superior in long-term performance stability, as well as in low hygroscopicity and low moisture permeability. However, no silanol content results only in poor adhesion, and therefore, there is such appropriate range of the silanol content ratio as described above.

The silanol content ratio of a silicone material can be decided by such a method as described before for {Solid Si-NMR spectrum measurement and calculation of the silanol content ratio} in [II -2-2. Characteristic [2] (solid Si-NMR spectrum)], for example. In such a method, the ratio (%) of silicon atoms in silanol relative to all silicon atoms is determined from the ratio of peak areas originating from silanol relative to all peak areas by means of the solid Si-NMR spectrum measurement, and then, the silanol content ratio can be calculated by comparing the determined silicon ratio with the silicon content ratio analyzed separately.

Since a silicone material preferable for the present invention contains an appropriate amount of silanol, which is bound to a polar portion, usually existing on the device surface, through hydrogen bond, the adhesion develops. The polar portion includes, for example, a hydroxyl group and oxygen in a metalloxane bond.

In addition, a silicone material preferable for the present invention usually forms, due to dehydration condensation, a covalent bond with a hydroxyl group on the device surface when heated in the presence of an appropriate catalyst, leading to a development of still firmer adhesion.

With too much content of silanol, on the other hand, thickening in the system may make the coating difficult, and also, with increased activity, the occurrence of curing before low-boiling point components volatilize by heating may induce a foaming and an increase in internal stress, which may result in crack generations.

[II-3. Content ratio of liquid medium]

There is no special limitation on the content of the liquid medium, insofar as the advantage of the present invention is not significantly impaired. However, it is usually 50 weight % or more, preferably 75 weight % or more, and usually 99 weight % or less, preferably 95 weight % or less, to the whole phosphor-containing composition of the present invention. Even a large amount of liquid medium does not induce any problems particularly, but in order to achieve desired color coordinate, color rendering index, emission efficiency or the like when it is used for a semiconductor light emitting device, it is preferable that the liquid medium is used usually in the above-mentioned proportion. With too small amount of the liquid medium, on the other hand, its handling may be difficult due to too little fluidity.

The liquid medium serves mainly as binder, in the phosphor-containing composition of the present invention. The liquid medium can be used either as a single one or as a mixture of two or more kinds in any combination and in any ratio. For example, when a silicon-containing compound is used for the purpose of heat resistance or light resistance, other thermosetting resin such as epoxy resin can be included to the extent that the durability of the silicon-containing compound will not be impaired. In such a case, it is preferable that the content of the other thermosetting resin is usually 25 weight % or lower, preferably 10 weight % or lower, to the whole amount of the liquid medium, which serves as the binder.

[II-4. Other component]

In the phosphor-containing composition of the present invention, other components can be contained in addition to the phosphor and liquid medium, insofar as the advantage of the present invention is not significantly impaired. The other components may be used either as a single kind thereof or as a mixture of more than one kind in any combination and in any ratio.

[II-5. Advantageous effect of phosphor-containing composition]

The phosphor-containing composition of the present invention can fix the phosphor of the present invention at a desired location easily. For example when the phosphor-containing composition of the present invention is used for a light emitting device, the phosphor of the present invention can be easily fixed at a desired location by forming the phosphor-containing composition of the present invention at a desired location and curing the liquid medium for sealing the phosphor of the present invention with the liquid medium.

[III. Light emitting device]

Next, an explanation will be given on the light emitting device of the present invention.
The light emitting device of the present invention comprises at least a first luminous body (excitation light source) and a second luminous body which emits visible light when irradiated with light from the first luminous body.
The feature thereof is that the second luminous body comprises, as a first phosphor, at least one kind of phosphors of the present invention.
In addition, it is preferable that the second luminous body comprises, as a second phosphor, at least one kind of a phosphor of which luminous wavelength is different from that of the first phosphor.
The light emitting device of the present invention can be of any known device configuration specifically in which an excitation light source such as described later is used as the first luminous body and the phosphor adjusted in its kind or content is used as the second luminous body. With such a configuration, the light emitting device of the present invention can emit any color of light.

For example, a white light emitting device can be produced by combining an excitation light source emitting near-ultraviolet light, a phosphor emitting blue fluorescence (blue phosphor), a green phosphor, and a red phosphor.
Furthermore, by adjusting the kind and proportion of that red phosphor, a light emitting device that extremely excels in red color rendering or emits warm white light can also be produced.
In this context, "white" color of the white light emitting device includes all of (Yellowish) White, (Greenish) White, (Bluish) White, (Purplish) White and White, defined in JIS Z 8701. Of these, preferable is White.

The emission spectrum peak in the green region, of the light emitting device of the present invention, preferably exists in a wavelength range of 510 nm to 535 nm. The emission spectrum peak in the red region thereof preferably exists in a wavelength range of 580 nm to 680 nm. The emission spectrum peak in the blue region thereof preferably exists in a wavelength range of 430 nm to 480 nm. The emission spectrum peak in the yellow region thereof preferably exists in a wavelength range of from 540 nm to 580 nm.

The emission spectrum of the light emitting device can be measured in a room of which temperature is kept at $25\pm1°C$ with energization of 20 mA, using a software for measuring color and illumination intensity, manufactured by Ocean Optics, Inc., and a spectroscope of USB2000 series (integrating sphere version). From this emission spectrum data in the wavelength region of 380 nm to 780 nm, can be calculated the chromaticity value (x, y, z) as color coordinates of xyz colorimetric system, defined in JIS Z8701. In this case, the relational expression of x+y+z=1 holds. In the present description, the aforementioned XYZ colorimetric system is occasionally referred to as XY colorimetric system and the value thereof is usually represented as (x,y).

Emission efficiency can be determined by calculating the total luminous flux from the results of emission-spectrum measurement using a light emitting device mentioned earlier and then dividing the lumen (1m) value obtained by the power consumption (W). The power consumption can be obtained as the product of the current value and the voltage value, which is measured using True RMS Multimeters Model 187 and 189 manufactured by Fluke Corporation while 20 mA energization.

The general color rendering index (Ra) of light emitting device of the present invention takes the values of usually 80 or larger, preferably 90 or larger, and more preferably 95 or larger.

In the following description, explanation will be given on a preferable constitution of the light emitting device of the present invention, taking the case where the phosphor of the present invention is a green phosphor as an example. However, the light emitting device of the present invention is by no means limited to such a case. When the phosphor of the present invention is a blue phosphor, a light emitting device of the present invention can also be constituted by incorporating an appropriate first phosphor and second phosphor. Specifically, the word "green" and the expression corresponding to the word "green" in the following description can be replaced with the word "blue" and the expression corresponding to the word "blue".

[III-1. First luminous body]

The first luminous body of the light emitting device of the present invention emits light for exciting the second luminous body to be described later.

The first luminous body has no particular limitation in its luminous wavelength, insofar as it overlaps the absorption wavelength of the second luminous body to be described later, and therefore, various luminous bodies with wide range of luminous wavelength regions can be used. A luminous body having a luminous wavelength from near-ultraviolet region to blue region, which is specifically usually 300 nm or longer, preferably 330 nm or longer and usually 500 nm or shorter, preferably 480 nm or shorter, is usually used.

Among them, it is preferable to use, as the first luminous body, a luminous body having a near-ultraviolet luminous wavelength (namely, near-ultraviolet luminous body), which is specifically: usually 300 nm or longer, preferably 360 nm or longer, and usually 420 nm or shorter. By using a near-ultraviolet luminous body as the first luminous body, the above-mentioned advantageous effect of the phosphor of the present invention which serves as the first phosphor as described later, namely, realizing a light emitting device with excellent emission efficiency and little possibility of nonuniformity in color tones or intensities of the luminescences due to wavelength variations, can be achieved remarkably.

As the first luminous body, a semiconductor luminous element is generally used. Specifically, a light-emitting diode (namely, LED), semiconductor laser diode (hereinafter, abbreviated as "LD" as appropriate) or the like can be used. Other examples include: organic electroluminescence luminous elements and inorganic electroluminescence luminous elements. Of course, the first luminous body is not limited to the above examples. However, it is preferable to select an LED, particularly a near-ultraviolet LED, as the first luminous body. By using an LED, particularly a near-ultraviolet LED, as the first luminous body, the above-mentioned advantageous effect of the phosphor of the present invention which serves as the first phosphor as described later, namely, realizing a light emitting device with little possibility of nonuniformity in color tones or intensities of the luminescences due to wavelength variations, can be achieved remarkably.

Among them, a GaN-based LED and GaN-based LD, using a GaN-based compound semiconductor, are preferable for the first luminous body. This is because a GaN-based LED and GaN-based LD have light output and external quantum efficiency far greater than those of an SiC-based LED and the like that emit the same range of light and therefore they can give very bright luminescence with very low electric power when used in combination with the above-mentioned phosphor. For example, when applying current load of 20 mA, a GaN-based LED and GaN-based LD usually have emission intensity 100 times or higher than that of an SiC-based ones. As GaN-based LED or GaN-based LD, one having an $Al_xGa_yN$ luminous layer, GaN luminous layer or $In_xGa_yN$ luminous layer is preferable. Among GaN-based LEDs in particular, the one having $In_xGa_yN$ luminous layer is particularly preferable because emission intensity thereof is then very high. Among GaN-based LDs, the one having a multiple quantum well structure of $In_xGa_yN$ layer and GaN layer is particularly preferable because emission intensity thereof is then very high.

In the above description, the X + Y usually takes a value in the range of 0.8 to 1.2. A GaN-based LED having a such kind of luminous layer that is doped with Zn or Si or without any dopant is preferable for the purpose of adjusting the luminescent characteristics.

A GaN-based LED contains, as its basic components, a such kind of luminous layer, p layer, n layer, electrode and substrate. Among them, a GaN-based LED having such a heterostructure as sandwiching the luminous layer with n type and p type of $Al_xGa_yN$ layers, GaN layers, $In_xGa_yN$ layers or the like is preferable, from the standpoint of high emission efficiency. Moreover, the one whose heterostructure is replaced by a quantum well structure is more preferable because it can show higher emission efficiency.

The first luminous body can be used either as a single one or as a mixture of two or more of them in any combination and in any ratio.

[III-2. Second luminous body]

The second luminous body of the light emitting device of the present invention is a luminous body which emits visible light when irradiated with light from the above-mentioned first luminous body. It comprises the aforementioned phosphor of the present invention (green phosphor) as the first phosphor, as well as the second phosphor (orange/red phosphor, blue phosphor, yellow phosphor, and the like) to be described later as appropriate depending on its use or the like. The second luminous body is formed, for example, so that the first and the second phosphors are dispersed in a sealing material.

There is no special limitation on the composition of the other phosphor than the phosphor of the present invention, which is used in the second luminous body. The examples include compounds incorporating a host crystal, such as a metal oxide typified by $Y_2O_3$, $YVO_4$, $Zn_2SiO_4$, $Y_3Al_5O_{12}$ and $Sr_2SiO_4$, a metal nitride typified by $Sr_2Si_5N_8$, phosphate typified by $Ca_5(PO_4)_3Cl$, a sulfide typified by ZnS, SrS and CaS and an oxysulfide typified by $Y_2O_2S$ and $La_2O_2S$, with an activation element or coactivation element, such as an ion of a rare earth metal including Ce, Pr, Nd, Pm, Sm, Eu, Tb, Dy, Ho, Er, Tm or Yb, or a metal ion of Ag, Cu, Au, Al, Mn or Sb.

Preferable examples of the host crystal include:

sulfides such as (Zn,Cd)S, $SrGa_2S_4$, SrS and ZnS; oxysulfides such as $Y_2O_2S$; aluminates such as $(Y,Gd)_3Al_5O_{12}$, $YAlO_3$, $BaMgAl_{10}O_{17}$, (Ba,Sr) $(Mg,Mn)Al_{10}O_{17}$, (Ba,Sr,Ca) $(Mg,Zn,Mn)Al_{10}O_{17}$, $BaAl_{12}O_{19}$, $CeMgAl_{10}O_{19}$, (Ba,Sr, Mg)O·$Al_2O_3$, $BaAl_2Si_2O_8$, $SrAl_2O_4$, $Sr_4Al_{14}O_{25}$ and $Y_3Al_5O_{12}$; silicates such as $Y_2SiO_5$ and $Zn_2SiO_4$; oxides such as $SnO_2$ and $Y_2O_3$; borates such as $GdMgB_5O_{10}$ and (Y,Gd)$BO_3$; halophosphates such as $Ca_{10}(PO_4)_6(F,Cl)_2$ and $(Sr,Ca,Ba,Mg)_{10}(PO_4)_6Cl_2$; and phosphates such as $Sr_2P_2O_7$ and (La,Ce)$PO_4$.

No particular limitation is imposed on the element compositions of the above-mentioned host crystal, and activation element or coactivation element. Partial substitution with an element of the same group is possible. Any phosphor obtained can be used so long as it absorbs light in the near-ultraviolet to visible region and emits visible light.

More concretely, those listed below can be used as phosphor. However, the lists are just examples and phosphors that can be used in the present invention are not limited to those examples. In the following examples, phosphors with different partial structure are shown abbreviated as a group for the sake of convenience, as mentioned earlier.

<III-2-1. First phosphor>

The second luminous body in the light emitting device of the present invention contains at least the above-mentioned phosphor of the present invention as the first phosphor. The phosphor of the present invention can be used either as a single kind or as a mixture of two or more kinds in any combination and in any ratio. In addition, the first phosphor may contain, in addition to the phosphor of the present invention, a phosphor (a combined same-color phosphor) emitting a fluorescence of the same color as that of the phosphor of the present invention. Since the phosphor of the present invention is usually a green phosphor, another kind of green phosphor can be used as the first phosphor in combination with the phosphor of the present invention.

As such a green phosphor, any green phosphor can be used insofar as the advantage of the present invention is not significantly impaired.

Examples of such a green phosphor include an europium-activated alkaline earth silicon oxynitride phosphor represented by $(Mg,Ca,Sr,Ba)Si_2O_2N_2$:Eu, which is constituted by fractured particles having a fractured surface and emits light in the green region.

Other examples of such green phosphor include:

Eu-activated aluminate such as $Sr_4Al_{14}O_{25}$:Eu and (Ba,Sr,Ca)$Al_2O_4$:Eu; Eu-activated silicate such as (Sr,Ba)$Al_2Si_2O_8$:Eu, (Ba,Mg)$_2SiO_4$:Eu, (Ba,Sr,Ca,Mg)$_2SiO_4$:Eu, (Ba,Sr,Ca)$_2$(Mg,Zn)$Si_2O_7$:Eu and (Ba,Ca,Sr,Mg)$_9$(Sc,Y,Lu,Gd)$_2$(Si,Ge)$_6O_{24}$:Eu; Ce,Tb-activated silicate such as $Y_2SiO_5$:Ce,Tb; Eu-activated boro-phosphate such as $Sr_2P_2O_7$-Sr2B205:Eu; Eu-activated halosilicate such as $Sr_2Si_3O_8$-2$SrCl_2$:Eu; Mn-activated silicate such as $Zn_2SiO_4$:Mn; Tb-activated aluminate such as $CeMgAl_{11}O_{19}$:Tb and $Y_3Al_5O_{12}$:Tb; Tb-activated silicate such as $Ca_2Y_8(SiO_4)_6O_2$:Tb and $La_3Ga_5SiO_{14}$:Tb; Eu,Tb,Sm-activated thiogalate such as (Sr,Ba,Ca)$Ga_2S_4$:Eu,Tb, Sm; Ce-activated aluminate such as $Y_3(Al,Ga)_5O_{12}$:Ce and (Y,Ga,Tb,La,Sm,Pr,Lu)$_3$(Al,Ga)$_5O_{12}$:Ce; Ce-activated silicate such as $Ca_3SC_2Si_3O_{12}$:Ce and $Ca_3$(Sc,Mg,Na,Li)$_2Si_3O_{12}$:Ce; Ce-activated oxide such as $CaSC_2O_4$:Ce; Eu-activated oxynitride such as Eu-activated β-sialon; Eu,Mn-activated aluminate such as $BaMgAl_{10}O_{17}$:Eu; Eu-activated aluminate such as $SrAl_2O_4$:Eu; Tb-activated oxysulfide such as (La,Gd,Y)$_2O_2S$:Tb; Ce,Tb-activated phosphate such as $LaPO_4$:Ce,Tb; sulfide such as ZnS:Cu,Al and ZnS:Cu,Au,Al; Ce,Tb-activated borate such as (Y,Ga,Lu,Sc,La)$BO_3$:Ce,Tb, $Na_2Gd_2B_2O_7$:Ce,Tb and (Ba,Sr)$_2$(Ca,Mg,Zn)$B_2O_6$:K,Ce,Tb; Eu,Mn-activated halosilicate such as $Ca_8Mg(SiO_4)_4Cl_2$:Eu,Mn; Eu-activated thioaluminate or thiogallate such as (Sr,Ca,Ba)(Al,Ga,In)$_2S_4$:Eu; Eu,Mn-activated halosilicate such as (Ca,Sr)$_8$(Mg,Zn) (SiO$_4$)$_4Cl_2$:Eu,Mn; and Eu-activated oxynitride such as $M_3Si_6O_9N_4$:Eu and $M_3Si_6O_{12}N_2$:Eu (here, M represents alkaline earth metal element).

Also applicable as the green phosphor are fluorescent dyes such as pyridine-phthalimide condensed derivative, benzoxadinone compound, quinazoline compound, coumarine compound, quinophthalone compound, naphthalimide compound, and organic phosphors such as terbium complex.

The green phosphor exemplified above can be used either as a single kind or as a mixture of two or more kinds in any combination and in any ratio.

It is preferable that the first phosphor used for the light emitting device of the present invention has an emission-peak wavelength $\lambda_p$ (nm) in the range of usually longer than 500 nm, particularly 510 nm or longer, further particularly 515 nm or longer, and usually 550 nm or shorter, particularly 542 nm or shorter, further particularly 535 nm or shorter. When that emission-peak wavelength $\lambda_p$ is too short, the color tends to be bluish green. On the other hand, when it is too long, the color tends to be yellowish green. In both cases, the characteristics as a green light may be deteriorated.

In addition, it is preferable that the first phosphor used for the light emitting device of the present invention has a full width at half maximum (hereinafter abbreviated as "FWHM" as appropriate) of the emission peak, in the above-mentioned emission spectrum, in the range of usually 10 nm or larger, preferably 20 nm or larger, more preferably 25 nm or larger, and usually 85 nm or smaller, particularly 75 nm or smaller, further particularly 70 nm or smaller. When the full width at half maximum, FWHM, is too small, the emission intensity may decrease. When it is too large, the color purity may decrease.

The external quantum efficiency of the first phosphor used for the light emitting device of the present invention is usually 60% or higher, and preferably 70% or higher. The weight median diameter thereof is usually 1 $\mu$m or larger, preferably 5 um or larger, more preferably 10 $\mu$m or larger, still more preferably 12 $\mu$m or larger, and usually 30 $\mu$m or smaller, preferably 25 $\mu$m or smaller, more preferably 20 $\mu$m or smaller. When the weight median diameter is too small, the brightness tends to decrease and the phosphor particles tend to aggregate. On the other hand, when the weight median diameter is too large, unevenness in coating, clogging in a dispenser or the like tends to occur.

<III-2-2. Second phosphor>

The second luminous body of the light emitting device of the present invention may contain another phosphor (namely, a second phosphor) in addition to the above-mentioned first phosphor, depending on its use. The second phosphor is a phosphor having a different emission wavelength from that of the first phosphor. Accordingly, the second phosphor often uses a phosphor emitting different color fluorescence from the first phosphor. Such a second phosphor is usually used for adjusting color tone of light emission of the second luminous body. Since a green phosphor is usually used as the first phosphor as described above, a phosphor other than green phosphor, such as orange/red phosphor, blue phosphor, or yellow phosphor, is used as the second phosphor.

It is preferable that the weight median diameter of the second phosphor used for the light emitting device of the present invention is in the range of usually 1 $\mu$m or larger, preferably 5 $\mu$m or larger, more preferably 10 $\mu$m or larger, particularly preferably 12 $\mu$m or larger, and usually 30 $\mu$m or smaller, preferably 25 $\mu$m or smaller, more preferably 20 $\mu$m or smaller. When the weight median diameter is too small, the brightness tends to decrease and the phosphor particles tend to aggregate. On the other hand, the weight median diameter is too large, unevenness in coating, clogging in a dispenser or the like tend to occur.

(III-2-2-1. Orange/red phosphor)

When an orange/red phosphor is used as the second phosphor, any kind of orange/red phosphor can be used, insofar as the advantage of the present invention is not significantly impaired. It is preferable that the emission-peak wavelength of the orange/red phosphor is in the wavelength range of usually 570 nm or longer, preferably 580 nm or longer, more preferably 585 nm or longer, and usually 780 nm or shorter, preferably 700 nm or shorter, more preferably 680 nm or shorter. The full width at half maximum of the emission peak of such an orange/red phosphor is usually in the range of 1 nm to 100 nm. The external quantum efficiency thereof is usually 60% or higher, and preferably 70% or higher.

Examples of such an orange or red phosphor include: an europium-activated alkaline earth silicon nitride phosphor represented by $(Mg,Ca,Sr,Ba)_2Si_5N_8$:Eu, which is constituted by fractured particles having red fractured surfaces and emits light in red region; and an europium-activated rare-earth oxychalcogenide phosphor represented by $(Y, La,Gd,Lu)_2O_2S$:Eu, which is constituted by growing particles having a nearly spherical shapes typical of regular crystal growth and emits light in red region.

Also applicable in the present embodiment is an phosphor containing oxynitride and/or oxysulfide which include at least one element selected from the group consisting of Ti, Zr, Hf, Nb, Ta, W and Mo, described in Japanese Patent Laid-Open Publication (Kokai) No. 2004-300247, and containing an oxynitride having an a-sialon structure in which all or part of Al elements are replaced by Ga elements. These are phosphors which contain oxynitride and/or oxysulfide.

Other examples of the orange/red phosphor include: Eu-activated oxysulfide such as $(La, Y)_2O_2S$:Eu; Eu-activated oxide such as $Y(V,P)O_4$:Eu and $Y_2O_3$:Eu; Eu,Mn-activated silicate such as $(Ba,Mg)_2SiO_4$:Eu,Mn and $(Ba,Sr, Ca,Mg)_2SiO_4$:Eu,Mn; Eu-activated tungstate such as $LiW_2O_8$:Eu, $LiW_2O_8$:Eu,Sm, $Eu_2W_2O_9$, $Eu_2W_2O_9$:Nb, $Eu_2W_2O_9$: Sm; Eu-activated sulfide such as $(Ca,Sr)S$:Eu; Eu-activated aluminate such as $YAlO_3$:Eu; Eu-activated silicate such as $Ca_2Y_8(SiO_4)_6O_2$:Eu, $LiY_9(SiO_4)_6O_2$:Eu, $(Sr,Ba,Ca)_3SiO_5$:Eu and $Sr_2BaSiO_5$:Eu; Ce-activated aluminate such as $(Y, Gd)_3Al_5O_{12}$:Ce and $(Tb,Gd)_3Al_5O_{12}$:Ce; Eu-activated oxide, nitride or oxynitride such as $(Mg,Ca,Sr,Ba)_2Si_5(N,O)_8$:Eu, $(Mg,Ca,Sr,Ba)Si(N,O)_2$:Eu and $(Mg,Ca,Sr,Ba)AlSi(N,O)_3$:Eu; Ce-activated oxide, nitride or oxynitride such as $(Mg,Ca, Sr,Ba)AlSi(N,O)_3$:Ce; Eu,Mn-activated halophosphate such as $(Sr,Ca,Ba,Mg)_{10}(PO_4)_6Cl_2$:Eu,Mn; Eu,Mn-activated silicate such as $(Ba_3Mg)Si_2O_8$:Eu,Mn and $(Ba,Sr,Ca,Mg)_3(Zn,Mg)Si_2O8$:Eu,Mn; Mn-activated germanate such as $3.5MgO \cdot 0.5MgF_2 \cdot GeO_2$:Mn; Eu-activated oxynitride such as Eu-activated $\alpha$-sialon; Eu,Bi-activated oxide such as $(Gd, Y,Lu,La)_2O_3$:Eu,Bi; Eu,Bi-activated oxysulfide such as $(Gd,Y,Lu,La)_2O_2S$:Eu,Bi; Eu,Bi-activated vanadate such as $(Gd, Y,Lu,La)VO_4$:Eu,Bi; Eu,Ce-activated sulfide such as $SrY_2S_4$:Eu,Ce; Ce-activated sulfide such as $CaLa_2S_4$:Ce; Eu,Mn-activated phosphate such as $(Ba,Sr,Ca)MgP_2O_7$:Eu,Mn and $(Sr,Ca,Ba,Mg,Zn)_2P_2O_7$:Eu,Mn; Eu,Mo-activated tungstate such as $(Y,Lu)_2WO_6$:Eu,Mo; Eu,Ce-activated nitride such as $(Ba,Sr,Ca)_xSi_yN_z$:Eu,Ce (x,y,z being an integer of 1 or larger); Eu,Mn-activated halophosphate such as $(Ca,Sr,Ba,Mg)_{10}(PO_4)_6(F,Cl,Br,OH)$:Eu,Mn; Ce-activated silicate such as $((Y,Lu,Gd,Tb)_{1-x-y}Sc_xCe_y)_2(Ca,Mg)1-r(Mg,Zn)_{2+r}Si_{z-q}Ge_qO_{12+\delta}$; and $K_2TiF_6$:Mn.

Also applicable examples of the red phosphor include: red organic phosphor consisting of rare-earth ion complex containing anions of such as $\beta$-diketonate, $\beta$-diketone, aromatic carboxylic acid or Bronsted acid as ligands, perylene pigment (for example, dibenzo{[f,f']-4,4',7,7'-tetraphenyl}diindeno[1,2,3-cd:1',2',3'-lm]perylene), anthraquinone pigment, lake pigment, azo pigment, quinacridone pigment, anthracene pigment, isoindoline pigment, isoindolinone pigment, phthalocyanine pigment, triphenylmethane series basic dye, indanthrone pigment, indophenol pigment, cyanine pigment and dioxazine pigment.

Among them, it is preferable that the red phosphor contains $(Ca,Sr,Ba)_2Si_5(N,O)_8$:Eu, $(Ca,Sr,Ba)Si(N,O)_2$:Eu, $(Ca,Sr,Ba)AlSi(N,O)_3$:Eu, $(Sr,Ba)_3SiO_5$:Eu, $(Ca,Sr)S$:Eu, $(La,Y)_2O_2S$:Eu or Eu complex. It is more preferable that it contains $(Ca,Sr,Ba)_2Si_5(N,O)_8$:Eu, $(Ca,Sr,Ba)Si(N,O)_2$:Eu, $(Ca,Sr,Ba)AlSi(N,O)_3$:Eu, $(Sr,Ba)_3SiO_5$:Eu, $(Ca,Sr)S$:Eu, $(La,Y)_2O_2S$:Eu, $\beta$-diketone Eu complex such as $Eu(dibenzoylmethane)_3 \cdot 1,10$-phenanthroline complex or carboxylic acid Eu complex. Of these, especially preferable are $(Ca,Sr,Ba)_2Si_5(N,O)_8$:Eu, $(Sr,Ca)AlSiN_3$:Eu and $(La,Y)_2O_2S$:Eu.

Among the above examples, a phosphor that can be preferably used as the orange phosphor is $(Sr,Ba)_3SiO_5$: Eu and $(Mg,Ca,Sr,Ba)AlSi(N,O)_3$:Ce.

(111-2-2-2. Blue phosphor)

When a blue phosphor is used as the second phosphor, any kind of blue phosphor can be used insofar as the advantage of the present invention is not significantly impaired. It is preferable that the emission-peak wavelength of such a blue phosphor is in the range of usually 420 nm or longer, preferably 430 nm or longer, more preferably 440 nm or longer, and usually 490 nm or shorter, preferably 480 nm or shorter, more preferably 470 nm or shorter, still more preferably 460 nm or shorter.

The full width at half maximum of the emission peak of such a blue phosphor is usually in the range of 20 nm to 80 nm. The external quantum efficiency thereof is usually 60% or higher, and preferably 70% or higher.

Examples of such a blue phosphor include:

europium-activated calcium halphosphate phosphors represented by $(Mg,Ca,Sr,Ba)_5(PO_4)_3(Cl,F):Eu$, which is constituted by growing particles having a nearly spherical shape typical of regular crystal growth and emits light in the blue region, europium-activated alkaline earth chloroborate phosphors represented by $(Ca,Sr,Ba)_2B_5O_9Cl:Eu$, which is constituted by growing particles having a nearly cubic shape typical of regular crystal growth and emits light in the blue region, and europium-activated alkaline earth aluminate phosphors represented by $(Sr,Ca,Ba)Al_2O_4:Eu$ or $(Sr,Ca,Ba)_4Al_{14}O_{25}:Eu$, which is constituted by fractured particles having fractured surfaces and emits light in the blue green region.

Other examples of such a blue phosphor include:

Sn-activated phosphate such as $Sr_2P_2O_7:Sn$; Ce-activated thiogalate such as $SrGa_2S_4:Ce$ and $CaGa_2S_4:Ce$; Eu-activated halophosphate such as $(Sr,Ca,Ba,Mg)_{10}(PO_4)_6Cl_2:Eu$ and $(Ba,Sr,Ca)_5(PO_4)_3(Cl,F,Br,OH):Eu,Mn,Sb$; Eu-activated silicate such as $BaAl_2Si_2O_8:Eu$, $(Sr,Ba)_3MgSi_2O_8:Eu$; Eu-activated phosphate such as $Sr_2P_2O_7:Eu$; sulfide such as ZnS:Ag and ZnS:Ag,Al; Ce-activated silicate such as $Y_2SiO_5:Ce$; tungstate such as $CaWO_4$; Eu,Mn-activated borophosphate such as $(Ba,Sr,Ca)BPO_5:Eu,Mn$, $(Sr,Ca)_{10}(PO_4)_6 \cdot nB_2O_3:Eu$ and $2SrO \cdot 0.84P_2O_5 \cdot 0.16B_2O_3:Eu$; Eu-activated halosilicate such as $Sr_2Si_3O_8 \cdot 2SrCl_2:Eu$; Eu-activated oxynitride such as $SrSi_9Al_{19}ON_{31}:Eu$ and $EuSi_9Al_{19}ON_{31}$; and Ce-activated oxynitride such as $La_{1-x}Ce_xAl(Si_{6-z}Al_z)(N_{10-z}O_z)$ (here, x and z are numbers satisfying $0 \leq x \leq 1$ and $0 \leq z \leq 6$, respectively) and $La_{1-x-y}Ce_xCayAl(Si_{6-z}Al_z)(N_{10-z}O_z)$ (here, x, y and z are numbers satisfying $0 \leq x \leq 1$, $0 \leq y \leq 1$ and $0 \leq z \leq 6$, respectively).

Also applicable as the blue phosphor are, for example, fluorescent dyes such as naphthalimide compound, benzoxazole compound, styryl compound, coumarine compound, pyrazoline compound and triazole compound, and organic phosphors such as thulium complex.

Among them, it is preferable that the blue phosphor contains $(Sr,Ca,Ba,Mg)_{10}(PO_4)_6(Cl,F)_2:Eu$ or $(Ba,Ca,Mg,Sr)_2SiO_4:Eu$. It is more preferable that it contains $(Sr,Ca,Ba,Mg)_{10}(PO_4)_6(Cl,F)_2:Eu$ or $(Ba,Ca,Sr)_3MgSi_2O_8:Eu$. It is still more preferable that it contains $Sr_{10}(PO_4)_6(Cl,F)_2:Eu$ or $Ba_3MgSi_2O_8:Eu$. Of these, $(Sr,Ca,Ba,Mg)_{10}(PO_4)_6Cl_2:Eu$ is particularly preferable in uses for illuminating devices and displays.

(III-2-2-3. Yellow phosphor)

When a yellow phosphor is used as the second phosphor, any kind of blue [sic] phosphor can be used, insofar as the advantage of the present invention is not significantly impaired. It is preferable that the emission-peak wavelength of such a yellow phosphor is in the wavelength range of usually 530 nm or longer, preferably 540 nm or longer, more preferably 550 nm or longer, and usually 620 nm or shorter, preferably 600 nm or shorter, more preferably 580 nm or shorter.
The full width at half maximum of the emission peak of such a yellow phosphor is usually in the range of 60 nm to 200 nm. The external quantum efficiency thereof is usually 60% or higher, and preferably 70% or higher.

Examples of such a yellow phosphor include various phosphors of such as oxide, nitride, oxynitride, sulfide and oxysulfide.
Particularly preferable examples include garnet phosphors having garnet structures, represented by $RE_3M_5O_{12}:Ce$ (here, RE indicates at least one element selected from the group consisting of Y, Tb, Gd, Lu and Sm, and M indicates at least one element selected from the group consisting of Al, Ga and Sc) and $M^a_3M^b_2M^c_3O_{12}:Ce$ (here, $M^a$, $M^b$ and $M^c$ are divalent, trivalent and tetravalent metal element respectively), for example; orthosilicate phosphors represented by $AE_2M^dO_4:Eu$ (here, AE indicates at least one element selected from the group consisting of Ba, Sr, Ca, Mg and Zn, and $M^d$ indicates Si and/or Ge), for example; oxynitride phosphors in which a part of the oxygen, contained in the above types of phosphors as constituent element, are substituted by nitrogen; Ce-activated nitride phosphors having $CaAlSiN_3$ structures such as $AEAlSiN_3:Ce$ (here, AE indicates at least one element selected from the group consisting of Ba, Sr, Ca, Mg and Zn); and $(Mg,Ca,Sr,Ba)Si_2O_2N_2:Eu$.

Also applicable as the yellow phosphor are: Eu-activated phosphors including sulfides such as $(Mg,Ca,Sr,Ba)Si_2O_2N_2:E_uC_aGa_2S_4:Eu$ [sic], $(Ca,Sr)Ga_2S4:Eu$ and $(Ca,Sr)(Ga,Al)_2S_4:Eu$; and oxynitrides having SiAlON structure such as $Cax(Si,Al)_{12}(O,N)_{16}:Eu$.

As other examples of the yellow phosphor can be cited fluorescent dyes such as brilliant sulfoflavine FF (Color Index Number 56205), basic yellow HG (Color Index Number 46040), eosine (Color Index Number 45380) and rhodamine 6G (Color Index Number 45160).

(III-2-2-4. Combination of second phosphors)

The above-mentioned second phosphors can be used either as a single kind or as a mixture of two or more kinds in any combination and in any ratio. There is no special limitation on the ratio between the first phosphor and the second phosphor, insofar as the advantage of the present invention is not significantly impaired. Accordingly, the amount of the second phosphors used, as well as the combination and the mixing ratio of the phosphors used as the second phosphor, can be set arbitrarily according to the use or the like of the light emitting device.

Whether the above-described second phosphors (orange/red phosphors, blue phosphors or the like) are used or not and what kind of them are used, in the light emitting device of the present invention, can be decided as appropriate depending on the use of the light emitting device. For example when the light emitting device of the present invention is constructed in a way that it is used as a green light emitting device, it usually requires only a first phosphor (green phosphor) and no second phosphor.

When the light emitting device of the present invention is constructed in a way it is used as a white light emitting device, it would be better to combine a first luminous body, a first phosphor (green phosphor) and a second phosphor appropriately, for synthesizing the desired white color. Concrete examples of preferable combination of a first luminous body, a first phosphor, and a second phosphor, when the light emitting device of the present invention is constructed as a white light emitting device, include the following combinations (i) to (iii) [sic].

(i) A near-ultraviolet luminous body (near-ultraviolet LED or the like: luminous wavelength of 300 nm to 420 nm) is used as the first luminous body. A green phosphor (a phosphor of the present invention or the like) is used as the first phosphor. And a combination of a blue phosphor (usually having an emission peak in the range of longer than 420 nm and 490 nm or shorter) and a red phosphor (usually having an emission peak in the range of 570 nm or longer and 780 nm or shorter) are used as the second phosphor. In this case, as the blue phosphor, one or more kinds of blue phosphors selected from the group consisting of $(Mg,Ca,Sr,Ba)_5(PO_4)_3(Cl,F):Eu$ are preferable. As the red phosphor, one or more kinds of red phosphors selected from the group consisting of $K_2TiF_6:Mn$, $(Sr,Ca)AlSiN_3:Eu$, and $La_2O_2S:Eu$ are preferable. Among them, it is particularly preferable to combine a near-ultraviolet LED, a phosphor of the present invention, $(Sr)_5(PO_4)_3Cl_2:Eu$ as blue phosphor, and $(Sr,Ca)AlSiN_3:Eu$ as red phosphor.

(ii) A near-ultraviolet luminous body (near-ultraviolet LED or the like: luminous wavelength of 300 nm to 420 nm) is used as the first luminous body. A blue to blue green phosphor (a phosphor of the present invention or the like) is used as the first phosphor. And a combination of a yellow phosphor (usually having an emission peak in the range of 530 nm or longer and 620 nm or shorter) and/or orange/red phosphor (usually having an emission peak in the range of 570 nm or longer and 780 nm or shorter) is used as the second phosphor. In this case, as the yellow and orange/red phosphors, $Y_3Al_5O_{12}:Ce$, $(Sr,Ca)AlSiN_3:Ce$, $(Mg,Ca,Sr,Ba)Si_2O_2N_2:Eu$, $Cax(Si,Al)_{12}(O,N)_{16}:Eu$, $(Sr,Ba)_3SiO_5:Eu$, and $(Sr,Ca)AlSiN_3:Eu$ are preferable.

The phosphor of the present invention can be used as a mixture with another phosphor (in this context, "mixture" does not necessary means to blend the phosphors with each other, but means to use different kinds of phosphors in combination). Among them, the combined use of phosphors described above will provide a preferable phosphor mixture. There is no special limitation on the kind or the ratio of the phosphors mixed.

[III-3. Sealing material]

The above-mentioned first and/or second phosphors are usually used by being dispersed in a liquid medium, which serves as a sealing material, in the light emitting device of the present invention. Examples of that liquid medium include the same ones as described in the aforementioned section [II. Phosphor-containing composition].

The liquid medium may contain a metal element that can be a metal oxide having high refractive index, for the purpose of adjusting the refractive index of the sealing member. As examples of a metal oxide having high refractive indexes can be cited Si, Al, Zr, Ti, Y, Nb and B. These metal elements can be used as a single kind or as a mixture of two or more kinds in any combination and in any ratio.

There is no special limitation on the state of existence of such metal elements, insofar as the transparency of the sealing member does not deteriorate. For example, they may exist as a uniform grass layer of metalloxane bonds or as particles in the sealing member. When they exist in a state of particles, the structure inside the particles may be either amorphous or crystal structure. However, for higher refractive index, the crystal structure is preferable. In such a case, the particle diameter thereof is usually equal to or smaller than the luminous wavelength of a semiconductor luminous element, and preferably 100 nm or smaller, more preferably 50 nm or smaller, particularly preferably 30 nm or smaller, in order not to impair the transparency of the sealing member. The above-mentioned metal elements in a state of particles contained in the sealing member can be obtained by means of adding, to a silicone material, such particles as silicon oxide, aluminium oxide, zirconium oxide, titanium oxide, yttrium oxide, niobium oxide or the like, for example.

Furthermore, the above-mentioned liquid medium may be further added with a known additive such as diffusing agent, filler, viscosity modifier and UV absorbing agent.

[III-4. (Other) configurations of light emitting device]

There is no special limitation on the other configuration of the light emitting device of the present invention, insofar as it comprises the above-mentioned first luminous body and second luminous body. However, it usually comprises a frame on which the above-mentioned first luminous body and second luminous body are located. The location is configured so that the second luminous body is excited (namely, the first and second phosphors are excited) by the light emitted from the first luminous body to emit light and the lights from the first luminous body and/or from the second luminous body are radiated to the outside. At this point, it is not always necessary for the first and second phosphors to be contained in the same layer. Each of different colored phosphors may be contained in the different layer from each other. For example, a layer containing the second phosphor can be laminated on a layer containing the first phosphor.

The light emitting device of the present invention may also utilize a member other than the above-mentioned excitation light source (the first luminous body), the phosphor (the second luminous body) and a frame. As the example can be cited the aforementioned sealing material. The sealing material can be used for, in addition to dispersing the phosphor (the second luminous body), adhering the excitation light source (the first luminous body), the phosphor (the second luminous body) and the frame to each other, in the light emitting device.

[III-5. Embodiment of light emitting device]

The light emitting device of the present invention will be explained in detail below with reference to a concrete embodiment. However, it is to be noted that the present invention is by no means restricted to the following embodiment and any modifications can be added thereto insofar as they do not depart from the scope of the present invention.

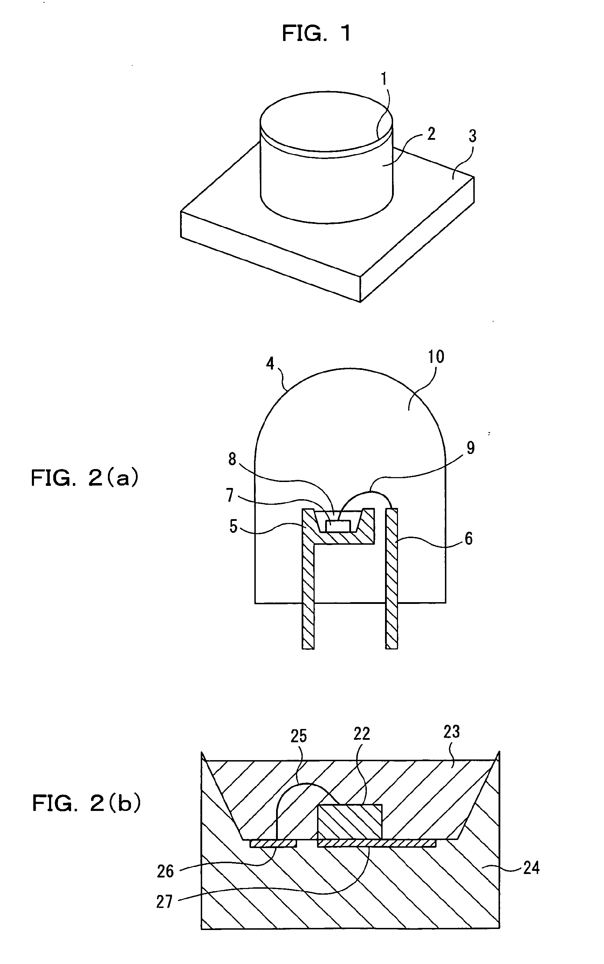

FIG. 1 is a schematic perspective view illustrating the positional relationship between the first luminous body, which functions as the excitation light source, and the second luminous body, constructed as the phosphor-containing part containing a phosphor, in an example of the light emitting device of the present invention. In FIG. 1, the numeral 1 indicates a phosphor-containing part (second luminous body), the numeral 2 indicates a surface emitting type GaN-based LD as an excitation light source (first luminous body), and the numeral 3 indicates a substrate. In order to configure them so that they are in contact with each other, the LD (2) and the phosphor-containing part (second luminous body) (1), prepared separately, may be made contact with each other in their surfaces by means of adhesive or the like, or otherwise, a layer of the phosphor-containing part (second luminous body) may be formed (molded) on the emission surface of the LD (2). With such configurations, the LD (2) and the phosphor-containing part (second luminous body) (1) can be kept contact with each other.

With such device configurations, light quantity loss, induced by a leakage of light emitted from the excitation light source (first luminous body) and reflected on the layer surface of the phosphor-containing part (second luminous body) to outside, can be avoided, which makes possible enhancement in emission efficiency of the entire device.

FIG. 2(a) shows a typical example of a light emitting device generally called a sell type. It is a schematic sectional view illustrating an Example of the light emitting device comprising an excitation light source (first luminous body) and a phosphor-containing part (second luminous body). In this light emitting device (4), the numeral 5, numeral 6, numeral 7, numeral 8, numeral 9 and numeral 10 indicate a mount lead, inner lead, excitation light source (first luminous body), phosphor-containing resinous part, conductive wire and mold member, respectively.

FIG. 2(b) shows a typical example of a light emitting device generally called a surface-mount type. It is a schematic sectional view illustrating an Example of the light emitting device comprising an excitation light source (first luminous body) and a phosphor-containing part (second luminous body). In the Figure, the numeral 22, numeral 23, numeral 24, numeral 25 and numerals 26, 27 indicate an excitation light source (first luminous body), a phosphor-containing resinous part as phosphor-containing part (second luminous body), a frame, a conductive wire and electrodes, respectively.

[III-6. Use of light emitting device]

There is no special limitation on the use of the light emitting device of the present invention, and therefore it can be used in various fields where a usual light emitting device is used. However, owing to its wide color reproduction range and high color rendering, it can be used as a light source of illuminating devices or displays particularly preferably.

<III-6-1. Illuminating device>

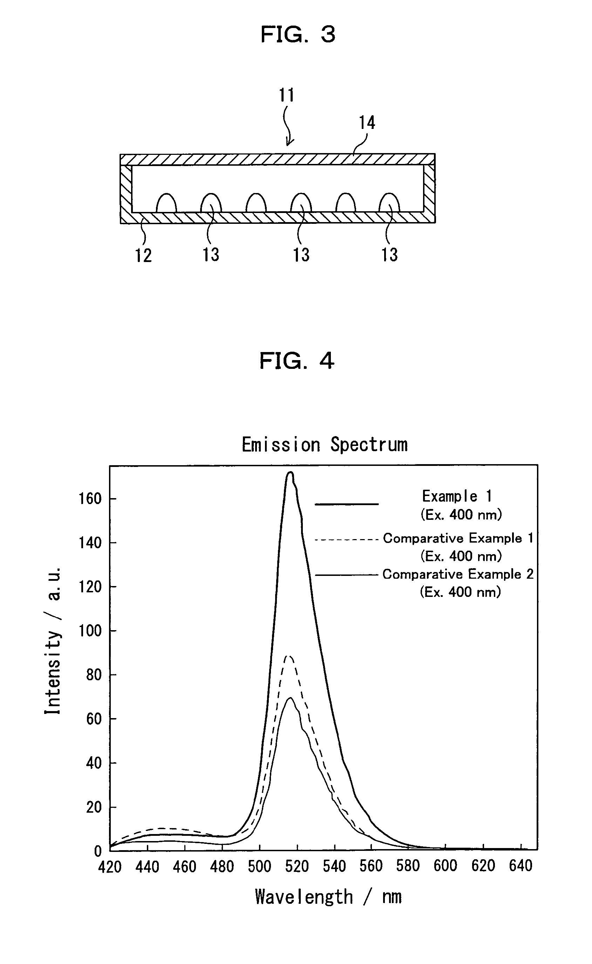

The application of the light emitting device of the present invention to an illuminating device can be carried out by incorporating a light emitting device such as described earlier into a known illuminating device as appropriate. A surface-emitting lighting system (11), shown in FIG. 3, in which the aforementioned light emitting device (4) is incorporated, can be cited as the example.

FIG. 3 is a sectional view schematically illustrating an embodiment of the illuminating device of the present invention. As shown in this FIG. 3, the surface-emitting lighting system comprises a large number of light emitting devices (13) (corresponding to the aforementioned light emitting device (4)) on the bottom surface of a rectangular holding case (12), of which inner surfaces are made to be opaque ones such as white smooth surfaces, and a power supply, circuit or the like (not shown in the figure) for driving the light emitting devices (13) outside the holding case. In addition, it comprises a milky-white diffusion plate (14), such as an acrylic plate, at the place corresponding to the cover part of the holding case (12), for homogenizing the light emitted.

When the surface-emitting lighting system (11) is driven by means of applying a voltage to the excitation light source (the first luminous body) of the light emitting device (13), light is emitted from the light source and the aforementioned phosphor in the phosphor-containing resinous part, which serves as phosphor-containing part (the second luminous body), absorbs a part of the emitted light and emits visible light. These lights mixed form a light emission with high color rendering, and then the mixed light passes through the diffusion plate (14) to be radiated in the upward direction of the figure. Consequently, an illumination light with a brightness that is uniform within the surface of the diffusion plate (14) of the holding case (12) can be obtained.

<III-6-2. Display>

When the light emitting device of the present invention is used as a light source in a display, there is no limitation on the specific configuration of the display. However, it is preferable to be used together with a color filter. For example when a color display utilizing a color liquid-crystal display element is constituted by a display using a light emitting device of the present invention (namely, a display of the present invention), it can be formed by combining the above-mentioned light emitting device as a backlight, an optical shutter utilizing a liquid crystal, and a color filter having red, green and blue picture elements.

The NTSC ratio of the color reproduction range of the light passed through the color filter is usually 60% or higher, preferably 80% or higher, more preferably 90% or higher, still more preferably 100% or higher, and usually 150% or lower.

The transmitted light amount from each color filter relative to the transmitted light amount from the entire color filters (namely, light utilization efficiency) is usually 20% or higher, preferably 25% or higher, more preferably 28% or higher, and still more preferably 30% or higher. The higher the utilization efficiency, the more preferable. However, since three kinds of filters red, green and blue are used, they are usually 33% or lower.

Example

Next, the present invention will be further described in detail by way of Examples. It is to be understood that the present invention is by no means limited by the following Examples insofar as they do not depart from the intent of the invention.

[Production of phosphor (Example 1)]

As phosphor materials, 0.552 g of barium carbonate ($BaCO_3$), 0.211 g of europium oxide ($Eu_2O_3$), 0.261 g of basic magnesium carbonate (mass of 93.17 per 1 mole of Mg), 0.138 g of manganese carbonate ($MnCO_3$), and 2.038 g of $\alpha$-alumina ($Al_2O_3$) were weighed out and used. Also, as flux, 0.015 g (0.47 weight % relative to the total weight of the phosphor materials weighed out) of potassium fluoride (KF), which is a univalent metal element halide, were weighed out and used.

The phosphor materials and fluxes mentioned above were mixed in a mortar for 30 minutes and filled in an alumina crucible. In order to create a reducing atmosphere at the time of firing, bead-shaped graphites were placed in a space around the crucible. This mixture of the phosphor materials and flux was fired at 1550°C for 2 hours under atmospheric pressure. The fired product obtained was ground, thereby to obtain a phosphor. The phosphor will be hereinafter referred to as the "phosphor of Example 1".

The composition formula of the phosphor of Example 1 obtained was $Ba_{0.7}Eu_{0.3}Mg_{0.7}Mn_{0.3}Al_{10}O_{17}$. An elemental analysis on the phosphor of Example 1 for the content ratio of each element showed that the content of K (potassium) relative to the number of sites which can be substituted with Eu was 1 mole % and the content of F (fluorine) was 0.2 mole %.

The elemental analysis was performed on the phosphor obtained by washing of the above-mentioned phosphor powder with hydrochloric acid while pulverizing it with a mortar and then eliminating deposits on the surface of it by washings with water and ethanol. The object color of the phosphor of Example 1 was vivid green in comparison with phosphors of Comparative Examples 1 and 2 to be described later.

[Preparation of phosphor (Comparative Example 1)]

A commercially available, Eu,Mn-activated barium magnesium aluminate phosphor (LP-G3, manufactured by Kasei Optonics, Ltd.) was used as the phosphor of Comparative Example 1.

[Production of phosphor (Comparative Example 2)]

A phosphor was obtained in the same procedure as Example 1 except that no flux was used. The phosphor will be hereinafter referred to as the "phosphor of Comparative Example 2".

[Measurement of emission spectrum and calculation of characteristics thereof (Example 1 and Comparative Examples 1 and 2)]

On each phosphor of Example 1 and Comparative Examples 1 and 2, emission spectrum was measured under excitation by light of 400 nm wavelength, which is the main wavelength of the near-ultraviolet region lights of GaN-based light-emitting diodes. Fig. 4 shows the emission spectra. The emission spectrum was measured by using a fluorescence measurement apparatus (manufactured by JASCO corporation) equipped with a 150-W xenon lamp as an excitation light source and a multichannel CCD detector, C7041 (manufactured by Hamamatsu Photonics K.K.), as a spectrum measurement apparatus. Lights from the excitation light source were passed through a grating spectroscope with a focal length of 10 cm so as to isolate lights having a wavelength of 400 nm, and the isolated excitation light was radiated onto the phosphor via optical fiber. Lights emitted from the phosphor by irradiation of the excitation light were separated using a grating spectroscope with a focal length of 25 cm, and the emission intensity of each wavelength was measured using the spectrum measurement apparatus in the wavelength range of from 300 nm to 800 nm. Then, through a signal processing such as sensitivity correction with a personal computer, the emission spectrum was obtained. The slit width of the receiving spectroscope was set at 1 nm during the measurement.

From the emission spectra measured on the respective phosphors of Example 1 and Comparative Examples 1 and 2, emission-peak wavelength, relative emission-peak intensity, and ratio (%) of the blue-emission peak intensity relative to that of the green emission peak were calculated.

The relative emission-peak intensity was indicated by letting the emission-peak intensity of the phosphor of Comparative Example 1 be 100.

The ratio of the blue-emission peak intensity relative to that of the green emission peak was calculated as the blue-emission peak intensity when letting the green emission peak be 100. A peak present in the wavelength range of 490 nm to 560 nm was taken as the green emission peak. A peak present in the wavelength range of 420 nm to 480 nm was taken as the blue emission peak.

Table 1 below shows the emission-peak wavelength, relative emission-peak intensity, and ratio of the blue-emission peak intensity relative to that of the green emission peak (these are hereinafter collectively referred to as the "emission spectrum characteristics" as appropriate) of the respective phosphors of Example 1 and Comparative Examples 1 and 2.

[Measurement of excitation spectrum and calculation of characteristics thereof (Example 1 and Comparative Examples 1 and 2)]

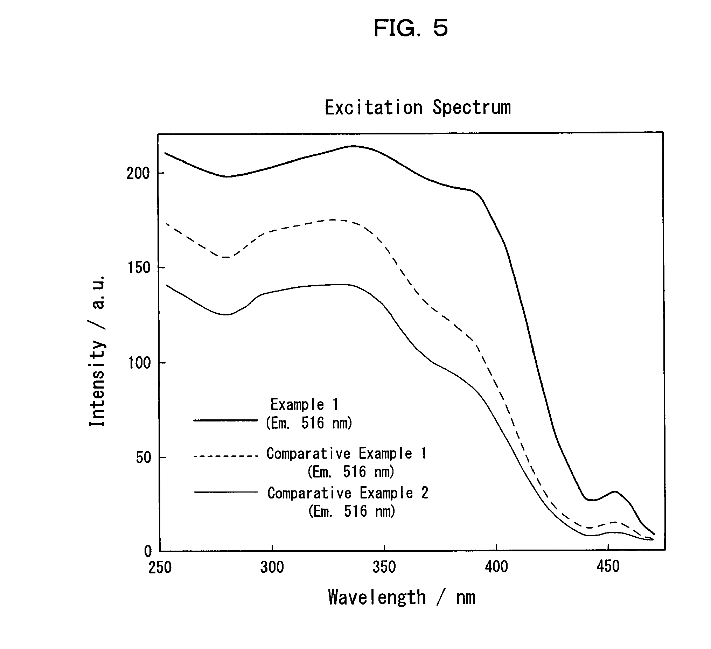

Also on each phosphor of Example 1 and Comparative Examples 1 and 2, excitation spectra were measured. Fig. 5 shows the excitation spectra. The excitation spectra were measured using a fluorescence spectrophotometer, F-4500 type (manufactured by Hitachi, Ltd.), at room temperature.

From the excitation spectra measured on the respective phosphors of Example 1 and Comparative Examples 1 and 2, reduction rate (%) of I(400) to I(340) was calculated in accordance with the formula [2'] below.

$$[\{I(340) - I(400)\} / I(340)] \times 100 \quad [2']$$

Where, I(340) and I(400) represent emission intensities of the excitation spectrum under excitation by wavelengths of 340 nm and 400 nm, respectively.

From the excitation spectra measured on the respective phosphors of Example 1 and Comparative Examples 1 and 2, reduction rate (%) of I(390) to I(382) was calculated in accordance with the formula [3'] below.

$$|[\{I(382) - I(390)\} / I(382)]| \times 100 \quad [3']$$

Where, I(382) and I(390) represent emission intensities of the excitation spectrum under excitation by wavelengths of 382 nm and 390 nm, respectively.

Table 1 below shows the reduction rate (%) of I(400) to I(340) and the reduction rate (%) of I(390) to I(382) (these are hereinafter collectively referred to as the "excitation spectrum characteristics" as appropriate) of the respective phosphors of Example 1 and Comparative Examples 1 and 2.

[Discussion on emission and excitation spectrum characteristics (Example 1 and Comparative Examples 1 and 2)]

[Table 1]

Table 1

| | Emission spectrum characteristics (excitation wavelength of 400 nm) | | | Excitation spectrum characteristics | |
|---|---|---|---|---|---|
| | Emission-peak wavelength (nm) | Relative emission-peak intensity (%) *1 | Ratio of blue-emission peak intensity relative to that of the green emission peak (%) | Reduction rate of I(400) to I(340) (%) *2 | Rate of change of I(390) to I(382) (%) *3 |
| Example 1 | 516 | 202 | 4.5 | 19 | 1.1 |
| Comparative Example 1 | 515 | 100 | 11.6 | 49 | 7.6 |
| Comparative Example 2 | 516 | 78 | 7.4 | 50 | 7.3 |

*1: Value when letting emission-peak intensity of phosphor of Comparative Example 1 be 100%
*2: Value represented by the formula [2'] below [(1(340)-I(400)} / I(340)] $\times$ 100 [2' ] Where, I(340) and I(400) represent emission intensities of the excitation spectrum under excitation by wavelengths of 340 nm and 400 nm, respectively.
*3: Value represented by the formula [3'] below |[{I(382)-I(390)} / I(382)]| $\times$ 100 [3']
Where, I(382) and I(390) represent emission intensities of the excitation spectrum under excitation by wavelengths of 382 nm and 390 nm, respectively. Note that *1 to *3 are the same also in other Tables.

It is evident from Table 1 that the phosphor of Example 1, in which Eu content was relatively high and a relatively small amount of KF was used as flux, was high in emission-peak intensity under excitation by near-ultraviolet light of 400 nm wavelength and particularly small in reduction rate of I(400) to I(340) and ratio of I(390) to I(382), in comparison with the phosphor of Comparative Example 1, which was a commercially available Eu,Mn-activated barium magnesium aluminate phosphor, and the phosphor of Comparative Example 2, in which Eu content was relatively high but no flux was used. Therefore, the phosphor of Example 1 is expected to stably achieve a high emission-peak intensity even when it is excited by near-ultraviolet light.

[Production of phosphor (Comparative Example 3)]

A phosphor was obtained in the same procedure as Example 1 except that aluminium fluoride (AlF$_3$), a trivalent metal element halide, was used as flux instead of potassium fluoride (KF), a univalent metal element halide, by being weighed out in a proportion of 0.3 weight % relative to the total weight of the phosphor materials weighed out. The phosphor will be hereinafter referred to as the "phosphor of Comparative Example 3".

[Measurement of temperature characteristics (Example 1 and Comparative Examples 1 and 3)]

On each phosphor of Example 1 and Comparative Examples 1 and 3, temperature dependences of brightness and emission intensity (these are hereinafter collectively referred to as the "temperature characteristics" as appropriate) under excitation by light of 405 nm wavelength were measured.

The temperature characteristics were measured as follows, using a multi-channel spectrum analyzer, MCPD7000, manufactured by Otsuka Electronics Co., Ltd. as emission spectrum measurement device, a luminance colorimeter BM5A as brightness measurement apparatus, a stage equipped with a cooling mechanism using a peltiert device and a heating mechanism using a heater, and a light source device equipped with a 150-W xenon lamp.

A cell holding the phosphor sample was put on the stage, and the temperature was changed stepwise at 20°C, 60°C, 100°C, 135°C, and 175°C. The surface temperature of the phosphor was measured, and subsequently the brightness values and emission spectra were measured by exciting the phosphor with light of 405 nm wavelength from the light source, which was separated using a diffraction grating. Then the emission-peak intensity was decided from the measured emission spectrum. At this point, as the measurement value of the surface temperature of the phosphor on the side irradiated with the excitation light, was used a value corrected by the temperature values measured with a radiation thermometer and a thermocouple.

Table 2 and Table 3 below show the temperature dependences of the brightness and emission intensity, respectively, of the respective phosphors of Example 1 and Comparative Examples 1 and 3 under excitation by 405 nm wavelength.

[Discussion on temperature characteristics (Example 1 and Comparative Examples 1 and 3)]

[Table 2]

Table 2

| Example 1 | | | Comparative Example 1 | | | Comparative Example 3 | | |
|---|---|---|---|---|---|---|---|---|
| Temperature (°C) | Relative brightness (%) [*4] | Ratio of change in brightness (%) [*5] | Temperature (°C) | Relative brightness (%) [*4] | Ratio of change in brightness (%) [*5] | Temperature (°C) | Relative brightness (%) [*4] | Ratio of change in brightness (%) [*5] |
| 20 | 100.0 | 0.0 | 20 | 100.0 | 0.0 | 20 | 100.0 | 0.0 |
| 59 | 101.3 | 1.3 | 61 | 103.7 | 3.7 | 60 | 101.0 | 1.0 |
| 102 | 102.5 | 2.5 | 103 | 108.7 | 8.7 | 104 | 100.4 | 0.4 |
| 137 | 101.9 | 1.9 | 138 | 110.3 | 10.3 | 138 | 96.3 | 3.7 |
| 176 | 99.4 | 0.6 | 176 | 111.2 | 11.2 | 178 | 84.9 | 15.1 |
| *4: Relative value of brightness (%) when letting brightness of each phosphor at room temperature (20°C) be 100% <br> *5: Absolute value of rate of change (%) in brightness when letting brightness of each phosphor at room temperature (20°C) be 100% <br> Note that *4 and *5 are the same also in other Tables. | | | | | | | | |

[Table 3]

Table 3

| Example 1 | | | Comparative Example 1 | | | Comparative Example 3 | | |
|---|---|---|---|---|---|---|---|---|
| Temperature (°C) | Relative emission-peak intensity (%) [*6] | Ratio of change in emission intensity (%) [*7] | Temperature (°C) | Relative emission intensity (%) [*6] | Ratio of change in emission intensity (%) [*7] | Temperature (°C) | Relative emission intensity (%) [*6] | Ratio of change in emission intensity (%) [*7] |
| 20 | 214 | 0 | 20 | 100 | 0 | 20 | 192 | 0 |
| 59 | 207 | 3 | 61 | 98 | 1 | 60 | 184 | 4 |
| 102 | 199 | 7 | 103 | 96 | 3 | 104 | 174 | 9 |
| 137 | 188 | 12 | 138 | 94 | 5 | 138 | 160 | 17 |
| 176 | 176 | 8 | 176 | 90 | 8 | 178 | 133 | 31 |

*6: Relative value of emission-peak intensity when letting emission-peak intensity of phosphor of Comparative Example 1 at room temperature (20°C) be 100%
*7: Rate of change (%) in emission-peak intensity when letting emission-peak intensity of each phosphor at room temperature (20°C) be 100%
Note that *6 and *7 are the same also in other Tables.

It is evident from Tables 2 and 3 that the phosphor of Example 1, in which Eu content was relatively high and a relatively small amount of KF was used as flux, was high in emission intensity and small in temperature dependences of brightness and emission-peak intensity, which means excellent temperature characteristics, under excitation by near-ultraviolet light of 405 nm wavelength in comparison with the phosphor of Comparative Example 1, which was a commercially available Eu,Mn-activated barium magnesium aluminate phosphor, and the phosphor of Comparative Example 3, in which Eu content was relatively low and $AlF_3$ was used as flux. Therefore, the phosphor of Example 1 is expected to give an excellent light emitting device which hardly shows color shift or decrease in emission intensity even when combined with an excitation light source emitting near-ultraviolet excitation light.

[Production of phosphor (Examples 2 to 6)]

Phosphors were obtained in the same procedure as Example 1 except that potassium fluoride (KF) was used as flux by being weighed out in weight ratios described in rows of "Example 2" to "Example 6" of Table 4 below. The phosphors will be hereinafter referred to as the "phosphors of Examples 2 to 6".

The compositions of phosphor materials and flux of each phosphor of Examples 2 to 6 are shown in Table 4 below, together with the compositions of phosphor materials and flux of the phosphor of Example 1.

In the respective Tables appearing later, the columns of "Compositions of phosphor materials" represent that the phosphor materials were weighed out i nmolar ratios of the numerical values "a" to "f" in those columns to give a phosphor represented by the formula [1'] below.

$$(1-a)Ba_{(1-b-c-d)}Sr_bCa_cEu_dMg_{(1-e-f)}Zn_eMn_fAl_{10}O_{17}\cdot(a)Ba_{(0.75-b'-c'-d')}Sr_{b'}Ca_{c'}EU_{d'}Al_{11}O_{17.25} \quad\quad [1']$$

[Table 4]

Table 4

| | Compositions of phosphor materials [8] | | | | | | Univalent metal element halide | | Trivalent metal element halide | |
|---|---|---|---|---|---|---|---|---|---|---|
| | a | b | c | d | e | f | Kind | Amount [9] | Kind | Amount [10] |
| Example 1 | 0.0 | 0.0 | 0.0 | 0.3 | 0.0 | 0.3 | KF | 0.47 | none | - |
| Example 2 | 0.0 | 0.0 | 0.0 | 0.3 | 0.0 | 0.3 | KF | 0.63 | none | - |
| Example 3 | 0.0 | 0.0 | 0.0 | 0.3 | 0.0 | 0.3 | KF | 0.51 | none | - |
| Example 4 | 0.0 | 0.0 | 0.0 | 0.3 | 0.0 | 0.3 | KF | 0.42 | none | - |
| Example 5 | 0.0 | 0.0 | 0.0 | 0.3 | 0.0 | 0.3 | KF | 0.37 | none | - |
| Example 6 | 0.0 | 0.0 | 0.0 | 0.3 | 0.0 | 0.3 | KF | 0.18 | none | - |

[8]: Phosphor materials were weighed out in molar ratios of the numerical values "a" to
"f" in the Table to give a phosphor represented by the formula [1'] below.
$(1-a)Ba(1-b-c-d)Sr_bCa_cEu_dMg_{(1-e-f)}Zn_eMn_fAl_{10}O_{17}\cdot(a)Ba_{(0.75-b'-c'-d')}Sr_{b'}$, $Ca_{c'}$ $Eu_{d'}$
$Al_{11}O_{17.25}$ [1']
[9, 10]: Weight % when letting the total weight of phosphor materials be 100 weight %
Note that [8] to [10] are the same also in other Tables.

[Calculation of emission and excitation spectrum characteristics and discussion thereon (Examples 2 to 6) ]

On each phosphor of Examples 2 to 6, emission spectrum and excitation spectrum were measured under excitation by light of 400 nm wavelength, and the emission spectrum characteristics and excitation spectrum characteristics were calculated, in the same procedure as Example 1.
The emission spectrum characteristics and excitation spectrum characteristics of respective phosphors of Examples 2 to 6 are shown in Table 5 below, together with the emission spectrum characteristics and excitation spectrum characteristics of the phosphor of Example 1.
[Table 5]

Table 5

| | Emission spectrum characteristics (excitation wavelength of 400 nm) | | | Excitation spectrum characteristics | |
|---|---|---|---|---|---|
| | Emission-peak wavelength (nm) | Relative emission-peak intensity (%) [*1] | Ratio of blue-emission peak intensity relative to that of the green emission peak (%) ) | Reduction rate of I (400) to I(340) (%) [*2] | Rate of change of I(390) to I(382) (%) [*3] |
| Example 1 | 516 | 202 | 4.5 | 19 | 1.1 |
| Example 2 | 517 | 185 | 4.7 | 23 | 1.5 |
| Example 3 | 516 | 199 | 4.5 | 20 | 0.9 |
| Example 4 | 516 | 201 | 4.5 | 19 | 1.1 |
| Example 5 | 516 | 196 | 4.6 | 21 | 1.4 |
| Example 6 | 516 | 93 | 6.5 | 49 | 7.1 |

It is evident from Tables 4 and 5 that the phosphors of Examples 1 to 6 were all excellent in emission spectrum characteristics and excitation spectrum characteristics, but there was a tendency of decrease in emission spectrum characteristics and excitation spectrum characteristics when the amount of KF, used as flux, was both too much and too little. Therefore, it is probable that there is an appropriate range with the amount of flux used.

[Production of phosphor (Examples 7 to 9)]

Phosphors were obtained in the same procedure as Example 1 except that potassium fluoride (KF) and aluminium fluoride ($AlF_3$) were used as fluxes by being weighed out in weight ratios described in rows of "Example 7" to "Example 9" of Table 6 below. The phosphors will be hereinafter referred to as the "phosphors of Examples 7 to 9". The compositions of phosphor materials and fluxes of each phosphor of Examples 7 to 9 are shown in Table 6 below, together with the compositions of phosphor materials and flux of the phosphor of Example 1.
[Table 6]

Table 6

| | Compositions of phosphor materials [*8] | | | | | | Univalent metal element halide | | Trivalent metal element halide | |
|---|---|---|---|---|---|---|---|---|---|---|
| | a | b | c | d | e | f | Kind | Amount [*9] | Kind | Amount [*10] |
| Example 1 | 0.0 | 0.0 | 0.0 | 0.3 | 0.0 | 0.3 | KF | 0.47 | none | - |
| Example 7 | 0.0 | 0.0 | 0.0 | 0.3 | 0.0 | 0.3 | KF | 0.42 | $AlF_3$ | 0.8 |
| Example 8 | 0.0 | 0.0 | 0.0 | 0.3 | 0.0 | 0.3 | KF | 0.37 | $AlF_3$ | 0.8 |
| Example 9 | 0.0 | 0.0 | 0.0 | 0.3 | 0.0 | 0.3 | KF | 0.29 | $AlF_3$ | 0.8 |

[Calculation of emission and excitation spectrum characteristics and discussion thereon (Examples 7 to 9)]

On each phosphor of Examples 7 to 9, emission spectrum and excitation spectrum were measured under excitation by light of 400 nm wavelength, and the emission spectrum characteristics and excitation spectrum characteristics were calculated, in the same procedure as Example 1.
The emission spectrum characteristics and excitation spectrum characteristics of respective phosphors of Examples 7 to 9 are shown in Table 7 below, together with the emission spectrum characteristics and excitation spectrum characteristics of the phosphor of Example 1. Incidentally, the full width at half maximum of the emission peak of Example 8 was 26.5 nm.
[Table 7]

Table 7

| | Emission spectrum characteristics (excitation wavelength of 400 nm) | | | Excitation spectrum characteristics | |
| --- | --- | --- | --- | --- | --- |
| | Emission-peak wavelength (nm) | Relative emission-peak intensity (%) [*1] | Ratio of blue-emission peak intensity relative to that of the green emission peak (%) | Reduction rate of I(400) to I(340) (%) [*2] | Rate of change of I(390) to I(382) (%) [*3] |
| Example 1 | 516 | 202 | 4.5 | 19 | 1.1 |
| Example 7 | 516 | 203 | 6.7 | 16 | 0.0 |
| Example 8 | 516 | 208 | 6.3 | 17 | 0.2 |
| Example 9 | 516 | 201 | 5.9 | 17 | 0.7 |

It is evident from Tables 6 and 7 that there was a tendency of improvement in emission spectrum characteristics and excitation spectrum characteristics when using, as flux, $AlF_3$, a trivalent metal element halide, in combination with KF, a univalent metal element halide, in comparison with when using KF alone.

[Production of phosphor (Examples 10 to 13 and Comparative Examples 4 and 5)]

Phosphors were obtained in the same procedure as Example 1 except for the following points. Strontium carbonate ($SrCO_3$) was used as Sr source. Each phosphor material was used by being weighed out in molar ratios described in rows of "Example 10" to "Example 13", "Comparative Example 4", and "Comparative Example 5" of Table 8 below. Potassium fluoride (KF) was used as flux by being weighed out in weight ratios described in rows of "Example 10" to "Example 13" and "Comparative Example 4" of Table 8 below. In addition, for Examples 11 to 13 and Comparative Example 5, aluminium fluoride ($AlF_3$) was used by being weighed out in weight ratios described in rows of "Example 11" to "Example 13" and "Comparative Example 5" of Table 8 below. The phosphors will be hereinafter referred to as the "phosphors of Examples 10 to 13 and Comparative Examples 4 and 5".
The compositions of phosphor materials and fluxes of each phosphor of Examples 10 to 13 and Comparative Examples 4 and 5 are shown in Table 8 below, together with the compositions of phosphor materials and flux of the phosphor of Example 1. An elemental analysis on the phosphor of Comparative Example 4 for the content ratio of each element showed that the content of K (potassium) relative to the number of sites which can be substituted with Eu was 5.6 mole % and the content of F (fluorine) was 0.1 mole %.
[Table 8]

Table 8

| | Compositions of phosphor materials [*8] | | | | | | Univalent metal element halide | | Trivalent metal element halide | |
| --- | --- | --- | --- | --- | --- | --- | --- | --- | --- | --- |
| | a | b | c | d | e | f | Kind | Amount [*9] | Kind | Amount [*10] |
| Example 1 | 0.0 | 0.0 | 0.0 | 0.3 | 0.0 | 0.3 | KF | 0.47 | none | - |
| Example 10 | 0.0 | 0.245 | 0.0 | 0.3 | 0.0 | 0.3 | KF | 0.37 | none | - |
| Example 11 | 0.0 | 0.245 | 0.0 | 0.3 | 0.0 | 0.3 | KF | 0.93 | $AlF_3$ | 0.8 |
| Example 12 | 0.0 | 0.245 | 0.0 | 0.3 | 0.0 | 0.3 | KF | 0.37 | $AlF_3$ | 0.8 |
| Example 13 | 0.0 | 0.245 | 0.0 | 0.3 | 0.0 | 0.3 | KF | 0.15 | $AlF_3$ | 0.8 |
| Comparative Example 4 | 0.0 | 0.245 | 0.0 | 0.3 | 0.0 | 0.3 | KF | 3.7 | none | - |
| Comparative Example 5 | 0.0 | 0.245 | 0.0 | 0.3 | 0.0 | 0.3 | none | - | $AlF_3$ | 0.8 |

[Calculation of emission and excitation spectrum characteristics and discussion thereon (Examples 10 to 13 and Comparative Examples 4 and 5)]

On each phosphor of Examples 10 to 13 and Comparative Examples 4 and 5, emission spectrum and excitation spectrum were measured under excitation by light of 400 nm wavelength, and the emission spectrum characteristics and excitation spectrum characteristics were calculated, in the same procedure as Example 1.

The emission spectrum characteristics and excitation spectrum characteristics of respective phosphors of Examples 10 to 13 and Comparative Examples 4 and 5 are shown in Table 9 below, together with the emission spectrum characteristics and excitation spectrum characteristics of the phosphor of Example 1. Incidentally, the full width at half maximum of the emission peak of Example 12 was 28.2 nm.

[Table 9]

Table 9

| | Emission spectrum characteristics (excitation wavelength of 400 nm) | | | Excitation spectrum characteristics | |
|---|---|---|---|---|---|
| | Emission-peak wavelength (nm) | Relative emission-peak intensity (%) *4 | Ratio of blue-emission peak intensity relative to that of the green emission peak (%) | Reduction rate of I(400) to I(340) (%) *5 | Rate of change of I(390) to I(382) (%) *6 |
| Example 1 | 516 | 202 | 4.5 | 19 | 1.1 |
| Example 10 | 517 | 201 | 5.4 | 18 | 0.8 |
| Example 11 | 516 | 172 | 9.0 | 25 | 2.2 |
| Example 12 | 516 | 195 | 6.3 | 18 | 0.7 |
| Example 13 | 516 | 190 | 6.4 | 23 | 1.6 |
| Comparative Example 4 | 516 | 160 | 7.6 | 33 | 3.6 |
| Comparative Example 5 | 516 | 153 | 6.4 | 34 | 3.8 |

It is evident from Tables 8 and 9 that, even in a system which contains Sr in its composition, effects of improving emission spectrum characteristics and excitation spectrum characteristics could be achieved by using KF, a univalent metal element halide, as flux at the time of firing.

In addition, it is evident that there was a tendency of improvement in emission spectrum characteristics and excitation spectrum characteristics when using, as flux, AlF$_3$, a trivalent metal element halide, in combination with KF, a univalent metal element halide, in comparison with when using KF alone.

Particularly, it is evident from, for example, Example 13 that even a relatively small amount of KF used can achieve effects of improving emission spectrum characteristics and excitation spectrum characteristics when using AlF$_3$ as additional flux.

[Production of phosphor (Examples 14 to 17)]

Phosphors were obtained in the same procedure as Example 1 except for the following points. Each phosphor material was used by being weighed out in molar ratios described in rows of "Example 14" to "Example 17" of Table 10 below. As flux, instead of potassium fluoride (KF), univalent metal element halides described in rows of "Example 14" to "Example 17" of Table 10 below were used by being weighed out in weight ratios described in the Table. In addition, for Example 17, aluminium fluoride (AlF$_3$) was also used by being weighed out in a weight ratio described in a row of "Example 17" of Table 10 below. The phosphors will be hereinafter referred to as the "phosphors of Examples 14 to 17".

The compositions of phosphor materials and fluxes of each phosphor of Examples 14 to 17 are shown in Table 10 below, together with the compositions of phosphor materials and flux of the phosphor of Example 1.

[Table 10]

Table 10

| | Compositions of phosphor materials *8 | | | | | | Univalent metal element halide | | Trivalent metal element halide | |
|---|---|---|---|---|---|---|---|---|---|---|
| | a | b | c | d | e | f | Kind | Amount *9 | Kind | Amount *10 |
| Example 1 | 0.0 | 0.0 | 0.0 | 0.3 | 0.0 | 0.3 | KF | 0.47 | none | - |
| Example 14 | 0.0 | 0.0 | 0.0 | 0.3 | 0.0 | 0.3 | NaF | 0.47 | none | - |
| Example 15 | 0.0 | 0.0 | 0.0 | 0.3 | 0.0 | 0.3 | RbF | 0.47 | none | - |
| Example 16 | 0.0 | 0.0 | 0.0 | 0.3 | 0.0 | 0.3 | CsF | 0.40 | none | - |
| Example 17 | 0.0 | 0.245 | 0.0 | 0.3 | 0.0 | 0.3 | LiF | 0.12 | AlF$_3$ | 0.80 |

[Calculation of emission and excitation spectrum characteristics and discussion thereon (Examples 14 to 17)]

On each phosphor of Examples 14 to 17, emission spectrum and excitation spectrum were measured under excitation by light of 400 nm wavelength, and the emission spectrum characteristics and excitation spectrum characteristics were calculated, in the same procedure as Example 1.
The emission spectrum characteristics and excitation spectrum characteristics of respective phosphors of Examples 14 to 17 are shown in Table 11 below, together with the emission spectrum characteristics and excitation spectrum characteristics of the phosphor of Example 1.
[Table 11]

Table 11

| | Emission spectrum characteristics (excitation wavelength of 400 nm) | | | Excitation spectrum characteristics | |
|---|---|---|---|---|---|
| | Emission-peak wavelength (nm) | Relative emission-peak intensity (%) *1 | Ratio of blue-emission peak intensity relative to that of the green emission peak (%) | Reduction rate of I (400) to I(340) (%) *2 | Rate of change of I(390) to I(382) (%) *3 |
| Example 1 | 516 | 202 | 4.5 | 19 | 1.1 |
| Example 14 | 516 | 205 | 4.4 | 18 | 0.8 |
| Example 15 | 516 | 108 | 6.2 | 47 | 7.2 |
| Example 16 | 516 | 79 | 7.5 | 52 | 8.3 |
| Example 17 | 516 | 155 | 7.5 | 30 | 3.0 |

It is evident from Tables 10 and 11 that, effects of improving emission spectrum characteristics and excitation spectrum characteristics could be achieved even when using univalent metal element halides other than KF as flux.

[Production of phosphor (Example 18)]

A phosphor was obtained in the same procedure as Example 1 except that each phosphor material was used by being weighed out in molar ratios described in a row of "Example 18" of Table 12 below. Potassium fluoride (KF) was used as flux by being weighed out in a weight ratio described in a row of "Example 18" of Table 12 below. The phosphor will be hereinafter referred to as the "phosphor of Example 18".
The compositions of phosphor materials and flux of the phosphor of Example 18 are shown in Table 12 below, together with the compositions of phosphor materials and flux of the phosphor of Example 1.
[Table 12]

Table 12

| | Compositions of phosphor materials [8] | | | | | | Univalent metal element halide | | Trivalent metal element halide | |
|---|---|---|---|---|---|---|---|---|---|---|
| | a | b | c | d | e | f | Kind | Amount [9] | Kind | Amount [10] |
| Example 1 | 0.0 | 0.0 | 0.0 | 0.3 | 0.0 | 0.3 | KF | 0.47 | none | - |
| Example 18 | 0.0 | 0.0 | 0.0 | 0.3 | 0.0 | 0.0 | KF | 0.47 | none | - |

[Calculation of emission and excitation spectrum characteristics and discussion thereon (Example 18)]

On the phosphor of Example 18, emission spectrum and excitation spectrum were measured under excitation by light of 400 nm wavelength, and the emission spectrum characteristics and excitation spectrum characteristics were calculated, in the same procedure as Example 1.
The emission spectrum characteristics and excitation spectrum characteristics of the phosphor of Example 18 are shown in Table 13 below, together with the emission spectrum characteristics and excitation spectrum characteristics of the phosphor of Example 1.
[Table 13]

Table 13

| | Emission spectrum characteristics (excitation wavelength of 400 nm) | | | Excitation spectrum characteristics | |
|---|---|---|---|---|---|
| | Emission-peak wavelength (nm) | Relative emission-peak intensity (%) [1] | Ratio of blue-emission peak intensity relative to that of the green emission peak (%) | Reduction rate of I (400) to I(340) (%) [2] | Rate of change of I(390) to I(382) (%) [3] |
| Example 1 | 516 | 202 | 4.5 | 19 | 1.1 |
| Example 18 | 458 | 107 | - | 30 | 3.3 |

It is evident from Tables 12 and 13 that, even in a phosphor which contains no Mn in its composition, effects of improving emission spectrum characteristics and excitation spectrum characteristics could be achieved by using KF, a univalent metal element halide, as flux at the time of firing a phosphor precursor.

[Production of phosphor (Examples 19 to 24)]

Phosphors were obtained in the same procedure as Example 1 except for the following points. Europium oxide ($Eu_2O_3$) and/or europium fluoride ($EuF_3$) were used as Eu source by being weighed out in molar ratios described in rows of "Example 19" to "Example 24" of Table 14 below. Each phosphor material was used by being weighed out in molar ratios described in rows of "Example 19" to "Example 24" of Table 15 below. As flux, sodium fluoride (NaF) was used by being weighed out in a proportion of 0.47 weight % relative to the total weight of the above-mentioned phosphor materials weighed out. The phosphors will be hereinafter referred to as the "phosphors of Examples 19 to 24".
The compositions of phosphor materials and flux of the phosphors of Examples 19 to 24 are shown in Table 15 below, together with the compositions of phosphor materials and flux of the phosphor of Example 1.
[Table 14]

Table 14

| | Ratio of $[EuF_3]/([EuF_3]+0.5[Eu_2O_3])$ [11] |
|---|---|
| Example 19 | 0.0 |
| Example 20 | 5.0 |
| Example 21 | 9.0 |
| Example 22 | 12.5 |

(continued)

| | Ratio of [EuF₃]/([EuF₃]+0.5[Eu₂O₃]) *11 |
|---|---|
| Example 23 | 25.0 |
| Example 24 | 100.0 |

*8: EuF₃ and/or Eu₂O₃ were weighed out so that the ratio represented by [EuF₃]/([EuF₃]+0.5[Eu₂O₃]) took the value in each row in the Table. Where, [EuF₃] represents number of moles of EuF₃ used and [Eu₂O₃] represents number of moles of Eu₂O₃ used.

[Table 15]

Table 15

| | Compositions of phosphor materials *8 | | | | | | Univalent metal element halide | | Trivalent metal element halide | |
|---|---|---|---|---|---|---|---|---|---|---|
| | a | b | c | d | e | f | Kind | Amount *9 | Kind | Amount *10 |
| Example 1 | 0.0 | 0.0 | 0.0 | 0.3 | 0.0 | 0.3 | KF | 0.47 | none | - |
| Example 19 | 0.0 | 0.0 | 0.0 | 0.4 | 0.0 | 0.3 | NaF | 0.47 | none | - |
| Example 20 | 0.0 | 0.0 | 0.0 | 0.4 | 0.0 | 0.3 | NaF | 0.47 | none | - |
| Example 21 | 0.0 | 0.0 | 0.0 | 0.4 | 0.0 | 0.3 | NaF | 0.47 | none | - |
| Example 22 | 0.0 | 0.0 | 0.0 | 0.4 | 0.0 | 0.3 | NaF | 0.47 | none | - |
| Example 23 | 0.0 | 0.0 | 0.0 | 0.4 | 0.0 | 0.3 | NaF | 0.47 | none | - |
| Example 24 | 0.0 | 0.0 | 0.0 | 0.4 | 0.0 | 0.3 | NaF | 0.47 | none | - |

[Calculation of emission and excitation spectrum characteristics and discussion thereon (Examples 19 to 24)]

On each phosphor of Examples 19 to 24, emission spectrum and excitation spectrum were measured under excitation by light of 400 nm wavelength, and the emission spectrum characteristics and excitation spectrum characteristics were calculated, in the same procedure as Example 1.

The emission spectrum characteristics and excitation spectrum characteristics of respective phosphors of Examples 19 to 24 are shown in Table 16 below, together with the emission spectrum characteristics and excitation spectrum characteristics of the phosphor of Example 1.

[Calculation of emission and excitation spectrum characteristics and discussion thereon (Examples 19 to 24)]

Table 16

| | Emission spectrum characteristics (excitation wavelength of 400 nm) | | | Excitation spectrum characteristics | |
|---|---|---|---|---|---|
| | Emission-peak wavelength (nm) | Relative emission-peak intensity (%) *1 | Ratio of blue-emission peak intensity relative to that of the green emission peak (%) | Reduction rate of I (400) to I(340) (%) *2 | Rate of change of I(390) to I(382) (%) *3 |
| Example 1 | 516 | 202 | 4.5 | 19 | 1.1 |
| Example 19 | 515 | 205 | 4.7 | 13 | 1.7 |
| Example 20 | 515 | 215 | 4.5 | 11 | 1.3 |

(continued)

| | Emission spectrum characteristics (excitation wavelength of 400 nm) | | | Excitation spectrum characteristics | |
|---|---|---|---|---|---|
| | Emission-peak wavelength (nm) | Relative emission-peak intensity (%) [*1] | Ratio of blue-emission peak intensity relative to that of the green emission peak (%) | Reduction rate of I (400) to I(340) (%) [*2] | Rate of change of I(390) to I(382) (%) [*3] |
| Example 21 | 515 | 216 | 4.9 | 10 | 1.1 |
| Example 22 | 515 | 217 | 5.1 | 8 | 0.5 |
| Example 23 | 516 | 209 | 5.3 | 10 | 1.0 |
| Example 24 | 514 | 165 | 11.2 | 16 | 2.1 |

It is evident from Tables 14 to 16 that, when using any of $Eu_2O_3$ and $EuF_3$ as Eu source, effects of improving emission spectrum characteristics and excitation spectrum characteristics could also be achieved by using NaF as flux. Particularly, it is evident that effects of improving emission spectrum characteristics and excitation spectrum characteristics could be achieved markedly when combining $Eu_2O_3$ and $EuF_3$.

[Measurement of temperature characteristics and discussion thereon (Examples 8 and 10)]

On each phosphor of Examples 8 and 10 mentioned earlier, temperature dependences of brightness and emission intensity under excitation by light of 405 nm wavelength were measured in the same procedure as Example 1. The compositions of phosphor materials and fluxes of the phosphors of Examples 1, 8, and 10 are shown in Table 17 below. Table 18 and Table 19 below show the measurement results of temperature dependences of the brightness and emission intensity, respectively, under excitation by 405 nm wavelength.

[Table 17]

Table 17

| | Compositions of phosphor materials [*8] | | | | | | Univalent metal element halide | | Trivalent metal element halide | |
|---|---|---|---|---|---|---|---|---|---|---|
| | a | b | c | d | e | f | Kind | Amount [*9] | Kind | Amount [*10] |
| Example 1 | 0.0 | 0.0 | 0.0 | 0.3 | 0.0 | 0.3 | KF | 0.47 | none | - |
| Example 8 | 0.0 | 0.0 | 0.0 | 0.3 | 0.0 | 0.3 | KF | 0.37 | $AlF_3$ | 0.80 |
| Example 10 | 0.0 | 0.245 | 0.0 | 0.3 | 0.0 | 0.3 | KF | 0.37 | none | - |

[Table 18]

Table 18

| Example 1 | | | Example 8 | | | Example 10 | | |
|---|---|---|---|---|---|---|---|---|
| Temperature (°C) | Relative brightness (%) [*4] | Ratio of change in brightness (%) [*5] | Temperature (°C) | Relative brightness (%) [*4] | Ratio of change in brightness (%) [*5] | Temperature (°C) | Relative emission brightness (%) [*4] | Ratio of change in brightness (%) [*5] |
| 20 | 100.0 | 0.0 | 20 | 100.0 | 0.0 | 20 | 100.0 | 0.0 |
| 59 | 101.3 | 1.3 | 57 | 101.4 | 1.4 | 58 | 100.6 | 0.6 |
| 102 | 102.5 | 2.5 | 97 | 101.9 | 1.9 | 99 | 100.6 | 0.6 |
| 137 | 101.9 | 1.9 | 129 | 97.1 | 2.9 | 133 | 101.8 | 1.8 |
| 176 | 99.4 | 0.6 | 167 | 93.9 | 6.1 | 173 | 98.9 | 1.1 |

[Table 19]

Table 19

| Example 1 | | | Example 8 | | | Example 10 | | |
|---|---|---|---|---|---|---|---|---|
| Temperature (°C) | Relative emission intensity (%) [*6] | Ratio of change in emission intensity (%) [*7] | Temperature (°C) | Relative emission intensity (%) [*6] | Ratio of change in emission intensity (%) [*7] | Temperature (°C) | Relative emission intensity (%) [*6] | Ratio of change in emission intensity (%) [*7] |
| 20 | 214 | 0 | 20 | 212 | 0 | 20 | 209 | 0 |
| 59 | 207 | 3 | 57 | 205 | 3 | 58 | 201 | 4 |
| 102 | 199 | 7 | 97 | 197 | 7 | 99 | 191 | 9 |
| 137 | 188 | 12 | 129 | 181 | 14 | 133 | 186 | 11 |
| 176 | 176 | 8 | 167 | 168 | 21 | 173 | 172 | 18 |

It is evident from Tables 17 to 19 that an effect of improving temperature characteristics could be obtained even when using, as flux, AlF$_3$, a trivalent metal element halide, in combination with KF, a univalent metal element halide, though the effect was inferior in comparison with when using KF alone.
For a phosphor which contains Sr in its composition, it is evident that the temperature dependence of brightness became very low by using KF, a univalent metal element halide, which means an improvement in temperature characteristics.

[Production of phosphor (Examples 25 and 26, and Comparative Example 6)]

As phosphor materials, barium carbonate (BaCO$_3$), strontium carbonate (SrCO$_3$), europium oxide (Eu$_3$O$_3$), basic magnesium carbonate (mass of 93.17 per 1 mole of Mg), and a-alumina (Al$_2$O$_3$) were used by being weighed out in accordance with the compositions shown in Table 20 below. As flux, sodium fluoride (NaF) was used in a proportion of 0.8 weight % relative to the total weight of the phosphor materials. The phosphor materials were mixed in a mortar for 30 minutes and then filled in an alumina crucible. It was fired in a firing furnace at 1150°C for 5 hours, thereby affording a phosphor precursor. After adding with the above-mentioned flux to the phosphor precursor obtained, they were pulverized and mixed in a mortar for 30 minutes and the mixture obtained was filled in an alumina crucible. It was fired at 1530°C for 5 hours in a nitrogen gas with bead-shaped graphites placed in a space around the crucible. The fired product obtained was ground and subjected to a particle-dispersion treatment, thereby to obtain a phosphor. The phosphor will be hereinafter referred to as the "phosphor of Example 25".
A phosphor was obtained in the same procedure as Example 25 except that potassium fluoride (KF) was used as flux in a proportion of 0.60 weight % relative to the total weight of the phosphor materials weighed out. The phosphor will be hereinafter referred to as the "phosphor of Example 26".
A phosphor was obtained in the same procedure as Example 25 except that aluminium fluoride (AlF$_3$) was used as flux instead of potassium fluoride (KF) by being weighed out in a proportion of 0.60 weight % relative to the total weight of the phosphor materials weighed out. The phosphor will be hereinafter referred to as the "phosphor of Comparative Example 6".
The compositions of phosphor materials and flux of each phosphor of Examples 25 and 26, and Comparative Example 6 are shown in Table 20 below.
[Table 20]

Table 20

| | Compositions of phosphor materials *8 | | | | | | Univalent metal element halide | | Trivalent metal element halide | |
|---|---|---|---|---|---|---|---|---|---|---|
| | a | b | c | d | e | f | Kind | Amount *9 | Kind | Amount *10 |
| Example 25 | 0.0 | 0.0 | 0.0 | 0.3 | 0.0 | 0.3 | NaF | 0.8 | none | - |
| Example 26 | 0.0 | 0.0 | 0.0 | 0.3 | 0.0 | 0.3 | KF | 0.6 | none | - |
| Comparative Example 6 | 0.0 | 0.0 | 0.0 | 0.3 | 0.0 | 0.3 | none | - | AlF$_3$ | 0.6 |

[Calculation of excitation spectrum characteristics and discussion thereon (Examples 25 and 26, and Comparative Example 6)]

On each phosphor of Examples 25 and 26, and Comparative Example 6, emission spectrum was measured and the emission spectrum characteristics and excitation spectrum characteristics were calculated, in the same procedure as Example 1, except that the excitation wavelength was changed to 405 nm. The results are shown in Table 21 below.
[Table 21]

Table 21

| | Emission spectrum characteristics (excitation wavelength of 405 nm) | |
|---|---|---|
| | Emission-peak wavelength (nm) | Relative emission-peak intensity (%) *12 |
| Example 25 | 455 | 112 |
| Example 26 | 454 | 112 |

(continued)

| | Emission spectrum characteristics (excitation wavelength of 405 nm) | |
|---|---|---|
| | Emission-peak wavelength (nm) | Relative emission-peak intensity (%) [*12] |
| Comparative Example 6 | 453 | 100 |
| *12: Value when letting emission-peak intensity of phosphor of Comparative Example 6 be 100% | | |

It is evident from Tables 20 and 21 that the emission intensities of blue light of the phosphors of Examples 25 and 26, which used NaF and KF respectively as flux, were increased in comparison with the phosphor of Comparative Example 6, which used $AlF_3$ as flux.

[Measurement of temperature characteristics and discussion thereon (Examples 25 and 26, and Comparative Example 6)]

On each phosphor of Examples 25 and 26, and Comparative Example 6 mentioned above, temperature dependence of brightness under excitation by light of 405 nm wavelength was measured in the same procedure as Example 1. Table 22 below shows the measurement results of temperature dependences of the brightness.
[Table 22]

Table 22

| Example 25 | | | Example 26 | | | Comparative Example 6 | | |
|---|---|---|---|---|---|---|---|---|
| Temperature (°C) | Relative brightness (%) [*4] | Ratio of change in brightness (%) [*5] | Temperature (°C) | Relative brightness (%) [*4] | Ratio of change in brightness (%) [*5] | Temperature (°C) | Relative brightness (%) [*4] | Ratio of change in brightness (%) [*5] |
| 24 | 100.0 | 0.0 | 24 | 100.0 | 0.0 | 24 | 100.0 | 0.0 |
| 57 | 101.4 | 1.4 | 58 | 102.5 | 2.5 | 60 | 105.7 | 5.7 |
| 96 | 99.9 | 0.1 | 99 | 104.1 | 4.1 | 98 | 101.5 | 1.5 |
| 128 | 95.8 | 4.2 | 135 | 102.4 | 2.4 | 133 | 87.9 | 12.1 |
| 168 | 95.0 | 5.0 | 174 | 104.9 | 4.9 | 171 | 66.5 | 33.5 |

It is evident from Table 22 that the temperature dependences of brightness of the phosphors of Examples 25 and 26, which used NaF and KF respectively as flux, got lowered in comparison with the phosphor of Comparative Example 6, which used $AlF_3$ as flux.

[Production of phosphor (Example 27)]

As phosphor materials, 0.552 g of barium carbonate ($BaCO_3$), 0.211 g of europium oxide ($Eu_2O_3$), 0.261 g of basic magnesium carbonate (mass of 93.17 per 1 mole of Mg), 0.138 g of manganese carbonate ($MnCO_3$), and 2.038 g of $\alpha$-alumina ($Al_2O_3$) were weighed out and used.

The above phosphor materials were mixed in a mortar for 30 minutes and then filled in an alumina crucible. They were fired at 1200°C for 5 hours under atmospheric pressure. The fired product obtained was ground, added with 0.4 weight % of $AlF_3$ as flux, and then mixed. The mixture was filled in an alumina crucible and fired at 1450°C for 5 hours in a weakly reducing atmosphere with a flow of a nitrogen gas containing 4 volume % of hydrogen.

The fired product obtained was ground, added with 0.6 weight % of KF relative to the weight of the ground product, and then mixed. The mixture was filled in an alumina crucible. Then, it was fired at 1550°C for 5 hours under atmospheric pressure with bead-shaped graphites placed in a space around the crucible to create a reducing atmosphere. The fired product obtained was ground, classified, and washed, thereby to obtain a phosphor. The phosphor will be hereinafter referred to as the "phosphor of Example 27".

The composition formula of the phosphor of Example 27 obtained was $Ba_{0.7}Eu_{0.3}Mg_{0.7}Mn_{0.3}Al_{10}O_{17}$. From an elemental analysis on the phosphor of Example 27 carried out in the same way as Example 1, it was showed that the ratio of K (potassium) relative to the number of sites which can be substituted with Eu was 1.6 mole % and the content of F (fluorine) was 1.7 mole %.

[Table 23]

Table 23

| | Emission spectrum characteristics (excitation wavelength of 405 nm) | | | Excitation spectrum characteristics | |
|---|---|---|---|---|---|
| | Emission-peak wavelength (nm) | Relative emission-peak intensity (%) [*1] | Ratio of blue-emission peak intensity relative to that of the green emission peak (%) | Reduction rate of I (400) to I(340) (%) [*2] | Rate of change of I(390) to I(382) (%) [*3] |
| Example 27 | 515 | 235 | 2.9 | 18 | 2.7 |

[Production of phosphor (Example 28)]

As phosphor materials, 0.552 g of barium carbonate ($BaCO_3$), 0.211 g of europium oxide ($Eu_2O_3$), 0.373 g of basic magnesium carbonate (mass of 93.17 per 1 mole of Mg), and 2.038 g of $\alpha$-alumina ($Al_2O_3$) were weighed out and used.

The above phosphor materials were mixed in a mortar for 30 minutes and then filled in an alumina crucible. They were fired at 1200°C for 5 hours under atmospheric pressure. The fired product obtained was ground and then filled in an alumina crucible. It was fired at 1450°C for 5 hours in a weakly reducing atmosphere with a flow of a nitrogen gas containing 4 volume % of hydrogen.

The fired product obtained was ground, added with 0.8 weight % of KF relative to the weight of the ground product, and then mixed. The mixture was filled in an alumina crucible. Then, it was fired at 1550°C for 5 hours under atmospheric pressure with bead-shaped graphites placed in a space around the crucible to create a reducing atmosphere. The fired product obtained was ground, classified, and washed, thereby to obtain a phosphor. The phosphor will be hereinafter referred to as the "phosphor of Example 28".

The composition formula of the phosphor of Example 28 obtained was $Ba_{0.7}Eu_{0.3}MgAl_{10}O_{17}$. From an elemental analysis on the phosphor of Example 28 carried out in the same way as Example 1, it was showed that the ratio of K (potassium) relative to the number of sites which can be substituted with Eu was 2.0 mole % and the content of F (fluorine) was 0.3 mole % .

[Production of phosphor (Example 29)]

A phosphor was obtained in the same procedure as Example 28 except for the following points. The fired product obtained by firing at 1200°C for 5 hours under atmospheric pressure was fired, after added with 0.3 weight % of KF relative to the fired product obtained, at 1450°C for 5 hours with a flow of a nitrogen gas containing 4 volume % of hydrogen. In addition, 0.5 weight % of KF was added, instead of 0.8 weight % of KF, to the fired product obtained by firing at 1450°C for 5 hours with a flow of a nitrogen gas containing 4 volume % of hydrogen. The phosphor will be hereinafter referred to as the "phosphor of Example 29".

[Preparation of phosphor (Comparative Example 7)]

A phosphor was obtained in the same procedure as Example 29 except that 0.3 weight % of KF was changed to 0.4 weight % of $AlF_3$ and that 0.5 weight % of KF was changed to 0.6 weight % of $AlF_3$. The phosphor will be hereinafter referred to as the "phosphor of Comparative Example 7".

[Preparation of phosphor (Comparative Example 8)]

A commercially available, Eu-activated barium magnesium aluminate phosphor (LP-B4, manufactured by Kasei Optonics, Ltd.) was used as the phosphor of Comparative Example 8.

[Measurement of emission spectrum and calculation of characteristics thereof (Examples 28 and 29, and Comparative Examples 7 and 8)]

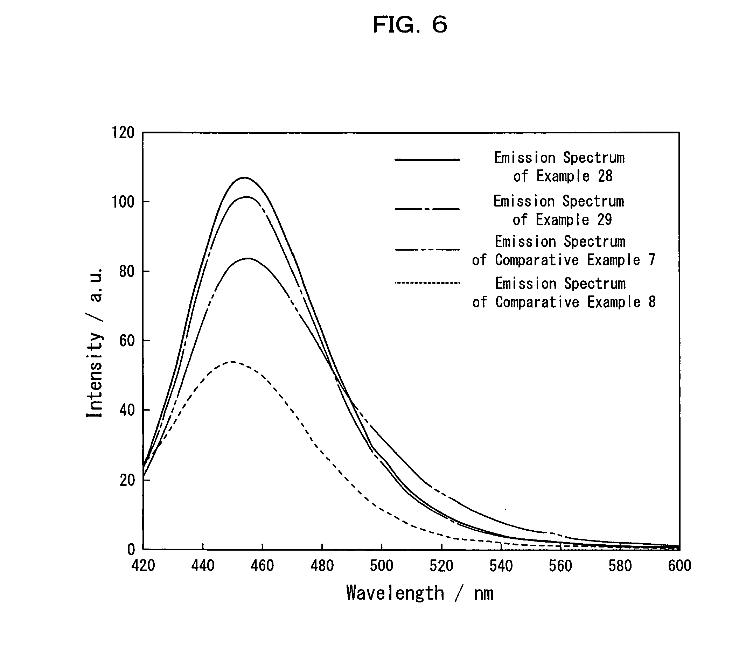

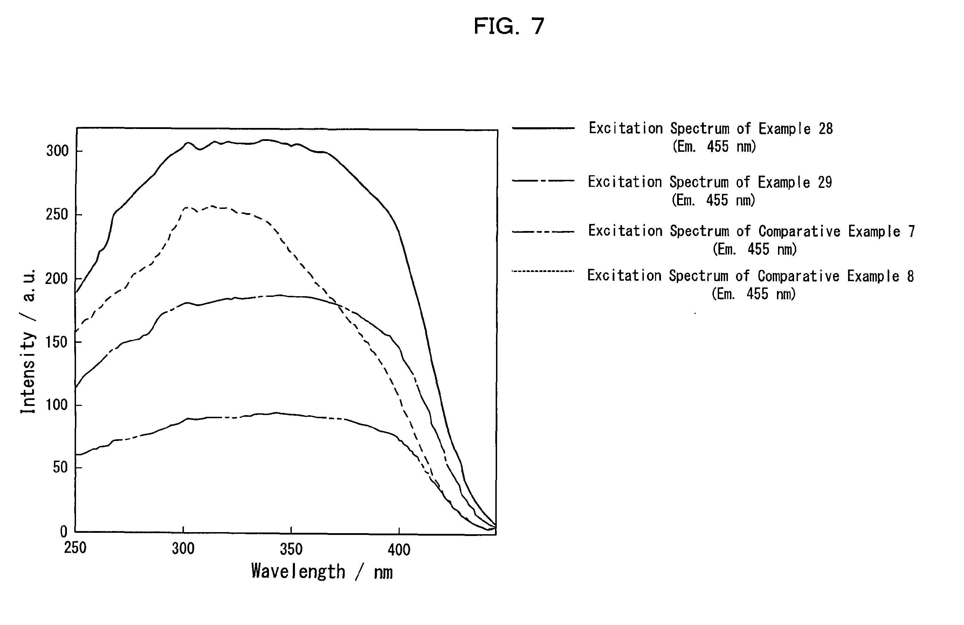

On each phosphor of Examples 28 and 29, and Comparative Examples 7 and 8, emission spectrum and excitation spectrum were measured in the same procedure as Example 1, except that the excitation wavelength was changed to 405 nm. Fig. 6 shows the emission spectrum and Fig. 7 shows the excitation spectrum. The emission spectrum characteristics are shown in Table 24 below.

[Table 24]

Table 24

|  | Emission spectrum characteristics (excitation wavelength of 405 nm) | |
| --- | --- | --- |
|  | Emission-peak wavelength (nm) | Relative emission-peak intensity (%) [13] |
| Example 28 | 455 | 197 |
| Example 29 | 455 | 187 |
| Comparative Example 7 | 455 | 154 |
| Comparative Example 8 | 450 | 100 |
| *13: Value when letting emission-peak intensity of phosphor of Comparative Example 8 be 100% | | |

It is evident from Table 24 that the emission-peak intensities of the phosphors of Examples 28 and 29 were markedly higher than those of the phosphors of Comparative Example 7, which used $AlF_3$ as flux, and Comparative Example 8, in which a commercially available, Eu-activated barium magnesium aluminate phosphor was used.

[Measurement of temperature characteristics and discussion thereon (Example 28 and Comparative Example 8)]

On each phosphor of Example 28 and Comparative Example 8 mentioned earlier, temperature dependence of brightness under excitation by light of 405 nm wavelength was measured in the same procedure as Example 1. Table 25 below shows the measurement results of temperature dependences of the brightness.

[Table 25]

Table 25

| Example 28 | | | Comparative Example 8 | | |
|---|---|---|---|---|---|
| Temperature (°C) | Relative brightness (%) *4 | Ratio of change in brightness (%) *5 | Temperature (°C) | Relative brightness (%) *4 | Ratio of change in brightness (%) *5 |
| 21 | 100.0 | 0.0 | 21 | 100.0 | 0.0 |
| 59 | 103.2 | 3.2 | 59 | 105.1 | 5.1 |
| 101 | 104.9 | 4.9 | 100 | 110.6 | 10.6 |
| 136 | 103.7 | 3.7 | 133 | 112.2 | 12.2 |
| 175 | 98.0 | 2.0 | 170 | 114.8 | 14.8 |

From Table 25, it is evident that, in the commercially available phosphor, the rate of change in brightness due to temperature change at 170°C reaches approximately as high as 15%, whereas the phosphor of the present invention has significantly small rate of change in brightness. This shows that the phosphor of the present invention has better temperature characteristics.

[Summary on Examples of phosphor]

From the above results of Examples, it is evident that phosphors excellent in excitation spectrum characteristics or temperature characteristics can be achieved by containing a minute amount of alkali metal element. This is probably because a minute amount of Ba sites or Sr sites, which are the sites that can be substituted with Eu, are replaced by the alkali metal element, which is an element having a different valency from the sites, and thereby the amount of defects of the sites is adjusted appropriately.

[Measurement of c-axis length of phosphor crystal]

On the phosphors of Examples 5, 10, 19, 22, and 28 out of the above-mentioned Examples, scanning electron microscope (SEM) observation was performed. From the SEM image observed, each c-axis length was determined. Specifically, each mean value was calculated from heights of hexagonal columns measured on 33 single grains, which corresponded to 17% of the number of the entire particles in the SEM image. The results are shown in Table 26 below.

[Table 26]

Table 26

| | c-axis length |
|---|---|
| Example 5 | 2.3 $\mu$m |
| Example 10 | 3.4 $\mu$m |
| Example 19 | 3.0 $\mu$m |
| Example 22 | 4.4 $\mu$m |
| Example 28 | 3.6 $\mu$m |

[Production of green light emitting device (Examples 30 and 31, and Comparative Example 9)]

A surface-mount type green light emitting device of which the constitution is shown in Fig. 2(b) was produced by the following procedure. Of the light emitting device constituents, those shown in Fig. 2(b) will be described with their reference numerals in Fig. 2(b) in parentheses as appropriate.
As the first luminous body (22), a near-ultraviolet light-emitting diode, C395-MB290-E0400 (manufactured by Cree, Inc.), was used. The near-ultraviolet LED (22) was bonded by die bonding using a silver paste as adhesive to the electrode (27) that was disposed at the bottom of the recess in the frame (24). The adhesive, namely, silver paste, was applied thinly and uniformly, in light of efficient dissipation of heat generated at the near-ultraviolet LED (22). After curing the silver paste by heating at 150°C for 30 minutes, the near-ultraviolet (22) and the electrode (26) of the frame (24) were bonded together through wire bonding. As wire (25), a gold wire with diameter of 25 $\mu$m was used.

As luminescent material in the phosphor-containing part (23), the green phosphor of Example 21 described above was used. A phosphor slurry (phosphor-containing composition) was prepared by mixing this phosphor with a silicone resin (JCR6101UP, manufactured by Dow Corning Toray Co., Ltd.).

The obtained phosphor slurry was poured into the recess of the above-mentioned frame (24) and heated at 150°C for 2 hours so as to be cured, thereby forming a phosphor-containing part (23). The surface-mount green light emitting device was produced in such a way. This will be hereinafter referred to as the "light emitting device of Example 30".

Another surface-mount type green light emitting device was produced in the same way as Example 30 except that the phosphor of Example 19 was used in place of the phosphor of Example 21. This will be hereinafter referred to as the "light emitting device of Example 31".

Still another surface-mount type green light emitting device was produced in the same way as Example 30 except that the phosphor of Comparative Example 1 was used in place of the phosphor of Example 21. This will be hereinafter referred to as the "light emitting device of Comparative Example 9".

[Measurement of characteristics and discussion thereon of light emitting device (Examples 30 and 31, and Comparative Example 9)]

With respect to the produced light emitting device of Examples 30 and 31, and Comparative Example 9, characteristics measurement was performed in the following procedure. The light emitting device was driven to emit light at 25°C by energizing the near-ultraviolet LED (22) with an electric power of 0.076 W. All emissions from the light emitting device were received by an integrating sphere and then guided to a spectroscope through optical fiber. The emission spectrum, total radiation flux, and entire luminous flux were thereby measured. More specifically, the measurement was performed in a room where the temperature was kept at $25\pm1$°C using a software for measuring color and illumination intensity and a spectroscope HR2000 series (integrating sphere version), which are manufactured by Ocean Optics, Inc., while driven with 0.076-W electric power. In addition, emission efficiency (lm/W) was decided by dividing the value of the entire luminous flux by the value of the total radiation flux. The results are shown in Table 27.

[Table 27]

Table 27

| Light emitting device | Phosphor | Total radiation flux (mW) | Entire luminous flux (Lumen) | Emission efficiency (Lumen/W) | Emission-peak wavelength (nm) |
|---|---|---|---|---|---|
| Example 30 | Example 21 | 6.1 | 2.1 | 345 | 516 |
| Example 31 | Example 19 | 6.1 | 2.0 | 323 | 516 |
| Comparative Example 9 | Comparative Example 1 | 5.7 | 1.4 | 250 | 517 |

From Table 27, it can be seen that the light emitting devices of Examples 30 and 31 using phosphors of Examples 21 and 19 respectively showed much brighter green luminescences than the light emitting device of Comparative Example 9 using the phosphor of Comparative Example 1.

[Production of white light emitting device]

The second phosphors used for producing the white light emitting devices were prepared as follows.

[Production of $Ba_{1.39}Sr_{0.46}Eu_{0.15}SiO_4$ (Reference Example 1)]

For producing a phosphor having a chemical composition ratio of $Ba_{1.70}Sr_{0.15}Eu_{0.15}SiO_4$, phosphor material powders of $BaCO_3$, $SrCO_3$, $Eu_2O_3$, and $SiO_2$ were weighed out and mixed in molar ratios of 1.7, 0.15, 0.075, and 1, respectively, relative to the 1 mole of the phosphor.

The mixture obtained was fired at 1100°C for 12 hours under a nitrogen atmosphere and then pulverized. A primary fired powder was thereby obtained. Then the primary fired powder was fired at 1200°C for 6 hours in the presence of carbon under a atmosphere of nitrogen gas containing 4 volume % of hydrogen, thereby affording a secondary fired powder. It was subjected to a steam treatment at 1300°C for 2 hours, thereby producing $Ba_{1.39}Sr_{0.46}Eu_{0.15}SiO_4$.

[Production of $Ca_{0.872}Eu_{0.008}Al_{0.88}Si_{1.12}N_{2.88}O_{0.12}$

(Reference Example 2)]

A phosphor was prepared in which 12% of $Si_2N_2O$ was solid-solved in $CaAlSiN_3$:Eu. Namely, material powders of $Eu_2O_3$, $Ca_3N_2$, AlN, $Al_2O_3$, and $Si_3N_4$ were weighed out and mixed to give a phosphor chemical composition ratio of $Eu_{0.008}Ca_{0.872}Al_{0.88}Si_{1.12}N_{2.88}O_{0.12}$, followed by being filled in a boron nitride crucible. The steps of weighing and mixing of the powders were all performed within a glove box that can keep its nitrogen atmosphere under 1 ppm or lower in moisture content and also under 1 ppm or lower in oxygen content.

The material mixture was heated from room temperature to 800°C after evacuating the firing furnace with a diffusion pump, and then a nitrogen with a purity of 99.999 volume % was introduced at 800°C until the pressure reached 0.92 MPa. The temperature was then raised to 1750°C and then maintained at 1750°C for 10 hours. The obtained mixure,. [sic] This mixed powder was transferred into a boron nitride crucible and placed in an electric furnace graphite resistance heating. Firing operation was performed by firing the mixture powder and then pulverized the fired product obtained. A red phosphor $Eu_{0.008}Ca_{0.992-x}Al_{1-x}Si_{1+x}N_{3-x}O_x$ (where, x=0.12) was thereby obtained.

[Production of $Sr_9Eu_1(PO_4)_6Cl_2$ (Reference Example 3)]

$SrCO_3$, $SrHPO_4$, and $Eu_2O_3$ were weighed out in a molar ratio of 2:6:0.5 and mixed. The mixture was fired at 1050°C for 5 hours in air and then pulverized, thereby affording a primary fired powder. Subsequently, $SrCl_2$ was mixed in the fired powder in a proportion of 1 mole relative to 2 mole of $SrCO_3$. They were fired at 920°C for 3 hours under an atmosphere of nitrogen gas containing 4 volume % of hydrogen and then pulverized, thereby affording a secondary fired powder. Further, in the secondary fired powder, $SrCl_2$ was mixed as flux in a proportion of 1 mole relative to 2 mole of $SrCO_3$. They were fired at 1050°C for 5 hours under an atmosphere of nitrogen gas containing 4 volume % of hydrogen and then pulverized, thereby affording a blue phosphor $Sr_9Eu_1(PO_4)_6Cl_2$.

[Production of $Ca_{0.985}Eu_{0.015}AlSiN_3$ (Reference Example 4)]

$Ca_3N_2$, AlN, $Si_3N_4$, and $EuF_3$ were weighed out to give a charge composition ratio of metal elements of $Ca_{0.985}Eu_{0.015}AlSi_{1.03}$. In other words, 68.61 g of $Ca_3N_2$ (manufactured by CERAC, inc.), 57.37 g of AlN (manufactured by TOKUYAMA Corp.), 74.61 g of $Si_3N_4$ (manufactured by Ube Industries, Ltd.) and 2.34 g of $EuF_3$ (manufactured by Shin-Etsu Chemical Co., Ltd.) were used.

These phosphor material powders were mixed within an $N_2$ glove box using a mixer until they became homogeneous. The mixture thus obtained was filled into a BN crucible and compression-molded by applying a slight weight. It was placed in a resistance-heating, vacuum pressurized-atmosphere heat-treating furnace (manufactured by Fujidenpa Kogyo Co., Ltd.) and vacuum heated from room temperature to 800°C at a temperature rising rate of 10 °C/min under a reduced pressure of <$5\times10^{-3}$ Pa (namely, less than $5\times10^{-3}$ Pa). When the temperature reached 800°C, nitrogen gas of high purity (99.9995 %) was introduced in 30 minutes until the pressure reached 0.5 MPa, while maintaining the temperature. After the introduction, the temperature was further raised to 1800°C at a temperature rising rate of 5 °C/min while the pressure was maintained at 0.5 MPa. After that temperature was maintained for 3 hours, the product was allowed to cool to room temperature. $Ca_{0.985}Eu_{0.015}AlSiN_3$ was thereby obtained.

[Examples 32 and 33: white light emitting device]

Light emitting devices were produced in the same way as Example 30 except that the blue phosphor of Example 28 and the phosphors of Reference Examples 1 and 2 were used as the luminescent materials contained in the phosphor-containing resinous part (22). The amounts of each phosphor mixed differ between Example 32 and Example 33 so that the respective light emitting devices have color temperatures of 4000 K and 2800 K, as shown in Table 28 below. The emission spectra of the white light emitting devices produced are shown in Table 8 and Table 9, respectively. Their general color rendering index (Ra) were also examined.

General color rendering indexes (Ra) can be obtained as the mean value of 8 kinds of color rendering indexes ($R_1$ to $R_8$), which are corresponding to 8 kinds of hues respectively, calculated from the emission spectrum.

[Table 28]

Table 28

| | Amount of phosphor used (weight %) when letting binder be 100 | | | Color temperature | General color rendering indexes Ra |
|---|---|---|---|---|---|
| | $Ba_{0.7}Eu_{0.3}MgAl_{10}O_{17}$ | $Ba_{1.39}Sr_{0.46}Eu_{0.15}SiO_4$ | $Ca_{0.80}Eu_{0.08}Al_{0.88}Si_{1.12}N_{2.88}O_{0.12}$ | | |
| Example 32 | 9 | 1 | 3 | 4000 K | 97 |
| Example 33 | 8 | 1 | 4 | 2800 K | 97 |

When the general color rendering indexes of two commercially available white light emitting devices whose color temperatures were 2800 K were determined, it turned out that both Ra were equal to 91. On the other hand, Ra was equal to 97 in the white light emitting device using the blue phosphor of the present invention, which means significantly excellent color rendering.

[Example 34: white light emitting device using Power Chip]

A light emitting device was produced by the same procedure as Example 30 except for the following 4 points.

1) Power Chip C395XB900 (manufactured by Cree, Inc.) was used in place of the C395MB290-E400 (manufactured by Cree, Inc.).
2) A phosphor slurry (phosphor-containing composition) was prepared by mixing the green phosphor of Example 27, the phosphors of Reference Examples 3 and 4, a silicone resin (JCR6101UP, manufactured by Dow Corning Toray Co., Ltd.), a curing agent (YLH1230, manufactured by Japan Epoxy Resins Co., Ltd.) and an aerosil (RY-200S, manufactured by Nippon Aerojil). The phosphor-containing part (23) was formed by using the phosphor slurry. The aerosil was used for preventing sedimentation of the phosphors in the resin.
3) The weight ratios of the respective phosphors mixed in the phosphor slurry relative to the total weight (= 100) of the silicone resin, curing agent, and aerosil were: 2.5 weight % for the green phosphor of Example 27, 17.6 weight % for the phosphor of Reference Example 3, and 1.1 weight % for the phosphor of Reference Example 4.
4) The phosphor slurry was cured under the condition of at 70°C for 1 hour and then at 140°C for 3 hours.

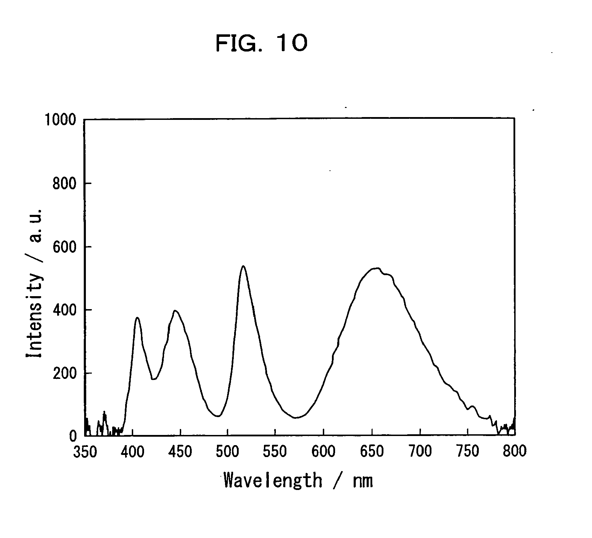

The emission spectrum at room temperature of the white light emitting device produced was measured. The emission spectrum measured is shown in Fig. 10. From the emission spectrum, it is evident that the full widths at half maximums of blue and green emission peaks are very small, which makes possible a luminescence with excellent color purity. It is also evident that the red luminous wavelength is located close to 660 nm, which means that the luminescence is of deep and excellent red color. These facts show that the present light emitting device can be used significantly suitably for displays.

A durability test was performed on the white light emitting device produced. Specifically, it was driven to emit light by energizing its near-ultraviolet LED with 20-mA current while placed in a durability test apparatus under the condition of 85-°C temperature and less than 10% of relative humidity. Table 29 below shows the relative brightness values and color coordinates values measured at respective driven times.

[Table 29]

Table 29

| Operation time (hour) | 0 | 96 | 260 | 520 | 710 | 995 |
|---|---|---|---|---|---|---|
| Relative brightness (%) | 100 | 96 | 100 | 99 | 102 | 101 |
| Color coordinate value (CIEx) | 0.319 | 0.320 | 0.318 | 0.319 | 0.318 | 0.319 |
| Color coordinate value (CIEy) | 0.294 | 0.303 | 0.303 | 0.305 | 0.304 | 0.305 |

It can be seen that, though the present white light emitting device, comprising the green phosphor of the present invention and appropriately-selected blue and red phosphors, used Power Chip, which is an excitation light source with large heat generation, under such a high temperature as 85°C, its brightness did not decrease or its color coordinates value (CIEx and CIEy), which show the degree of color shift, hardly changed, even after 995 hours had passed.

Industrial Applicability

There is no special limitation on the use of the phosphor of the present invention, and it can be used for any fields in which ordinary phosphors are used. It can be suitably used for long-life and energy-saving light emitting devices by combined with an excitation light source such as a near-ultraviolet LED, making the most of its characteristic of exhibiting high emission intensity stably even under excitation by near-ultraviolet light.
The light emitting device of the present invention can be used for a variety of fields in which ordinary light emitting devices are used. Among them, it can be preferably used as light source of displays or illuminating devices.

The present invention has been explained in detail above with reference to specific embodiments. However, it is evident to those skilled in the art that various modifications can be added thereto without departing from the intention and the scope of the present invention.

The present application is based on Japanese Patent Application (Patent Application No. 2007-92852) filed on March 30, 2007 and their entireties are incorporated herewith by reference.

**Claims**

1. A phosphor having a crystal phase comprising an alkali metal element, wherein:

   a rate of substituted Eu (europium) to the number of sites which can be substituted with Eu of said crystal phase is 15% or higher, and
   a ratio of said alkali metal element to the number of sites which can be substituted with Eu of said crystal phase is 3% or lower.

2. A phosphor according to claim 1 wherein, said phosphor has β-alumina structure.

3. A phosphor according to claim 1 or claim 2 wherein,

   said phosphor has an emission peak in the wavelength region between 470 nm and 570 nm when excited with light in a wavelength range between 380 nm and 410 nm.

4. A phosphor according to claim 1 or claim 2 wherein,

   said phosphor has an emission peak in the wavelength region between 420 nm and 470 nm when excited with light in a wavelength range between 380 nm and 410 nm.

5. A phosphor according to any one of claims 1 to 4, wherein

   the full width at half maximum of the emission peak is 60 nm or smaller.

6. A phosphor according to any one of claims 1 to 5, wherein

   said phosphor is an oxide phosphor of which the oxygen content to the total amount of elements constituting anions in said phosphor is 40 atomic percent or higher.

7. A phosphor according to any one of claims 1 to 6, wherein

   said phosphor is an alkaline-earth metal aluminate.

8. A phosphor according to any one of claims 1 to 7

   further containing Mn (manganese).

9. A phosphor according to any one of claims 1 to 8

   further containing Mg (magnesium).

10. A phosphor according to any one of claims 1 to 9

    represented by the formula [1] below.

$$(1-a)Ba_{(1-b-c-d)}Sr_bCa_cEu_dMg_{(1-e-f)}Zn_eMn_fAl_gO_h \cdot (a)Ba_{(0.75-b'-c'-d')}Sr_{b'}Ca_{c'}Eu_{d'}Al_{11}O_{17.25} \cdot A_i \qquad [1]$$

    (Where
    A represents at least one kind of alkali metal element, and
    a, b, c, d, e, f, g, h, i, b', c', and d' represent numbers satisfying the following conditions:

       $0 \leq a \leq 1$,
       $0 \leq b < 1$,

$0 \leq c < 1$,
$0.1 < d < 1$,
$0 \leq e < 1$,
$0 \leq f \leq 1$,
$9 \leq g \leq 11$,
$15.3 \leq h \leq 18.7$,
$0 \leq i \leq 0.03$,
$0 \leq b' < 1$,
$0 \leq c' < 1$, and
$0.1 < d' < 1$.)

**11.** A production method of a phosphor

comprising a step of firing a phosphor precursor in the presence of univalent metal element halide of more than 0 weight % and less than 1 weight %.

**12.** A production method of a phosphor, according to claim 11, wherein

said univalent metal element halide is halide of one or more kinds of metal elements selected from the group consisting of Na (sodium), K (potassium), and Li (lithium).

**13.** A production method of a phosphor, according to claim 11 or claim 12, wherein

the obtained phosphor is an alkaline-earth metal aluminate.

**14.** A production method of a phosphor, according to any one of claims 11 to 13, wherein

the obtained phosphor is represented by the formula [1] below.

$$(1-a)Ba_{(1-b-c-d)}Sr_bCa_cEu_dMg_{(1-e-f)}Zn_eMn_fAl_gO_h \cdot (a)Ba_{(0.75-b'-c'-d')}Sr_{b'}Ca_{c'}Eu_{d'}Al_{11}O_{17.25} \cdot A_i \qquad [1]$$

(Where
A represents at least one kind of alkali metal, and
a, b, c, d, e, f, g, h, i, b', c', and d' represent numbers satisfying the following conditions:

$0 \leq a \leq 1$,
$0 \leq b < 1$,
$0 \leq c < 1$,
$0.1 < d < 1$,
$0 \leq e < 1$,
$0 \leq f \leq 1$,
$9 \leq g \leq 11$,
$15.3 \leq h \leq 18.7$,
$0 \leq i \leq 0.03$,
$0 \leq b' < 1$,
$0 \leq c' < 1$, and
$0.1 < d' < 1$.)

**15.** A phosphor-containing composition comprising: said phosphor according to any one of claims 1 to 10 and a liquid medium.

**16.** A light emitting device comprising: a first luminous body and a second luminous body which emits visible light when irradiated with light from said first luminous body, wherein

said second luminous body comprises, as a first phosphor, at least one kind of said phosphor according to any one of claims 1 to 10.

**17.** A light emitting device according to claim 16, wherein

said second luminous body comprises, as a second phosphor, at least one kind of a phosphor of which luminous wavelength is different from that of said first phosphor.

**18.** A light emitting device according to claim 17, wherein

said first luminous body has an emission peak in the wavelength range of 300 nm or longer and 420 nm or shorter, and
said second luminous body comprises, as the second phosphor, at least one kind of a phosphor having an emission peak in the wavelength range of 530 nm or longer and 780 nm or shorter.

**19.** A light emitting device according to claim 17, wherein

said first luminous body has an emission peak in the wavelength range of 300 nm or longer and 420 nm or shorter, and
said second luminous body comprises, as the second phosphor, at least one kind of a phosphor having an emission peak in the wavelength range of longer than 420 nm and 490 nm or shorter and at least one kind of a phosphor having an emission peak in the wavelength range of 570 nm or longer and 780 nm or shorter.

**20.** A light emitting device according to claim 17, wherein

said first luminous body has an emission peak in the wavelength range of 300 nm or longer and 420 nm or shorter, and
said second luminous body comprises, as the second phosphor, at least one kind of a phosphor having an emission peak in the wavelength range of longer than 500 nm and 550 nm or shorter and at least one kind of a phosphor having an emission peak in the wavelength range of 570 nm or longer and 780 nm or shorter.

**21.** A display comprising, as a light source, a light emitting device according to any one of claims 16 to 20.

**22.** An illuminating device comprising, as a light source, a light emitting device according to any one of claims 16 to 20.

# FIG. 1

# FIG. 2(a)

# FIG. 2(b)

# FIG. 3

# FIG. 4

Emission Spectrum

# FIG. 5

## Excitation Spectrum

EP 2 141 215 A1

# FIG. 6

EP 2 141 215 A1

# FIG. 7

Legend:
- —————— Excitation Spectrum of Example 28 (Em. 455 nm)
- —·—·— Excitation Spectrum of Example 29 (Em. 455 nm)
- —··—··— Excitation Spectrum of Comparative Example 7 (Em. 455 nm)
- ··········· Excitation Spectrum of Comparative Example 8 (Em. 455 nm)

Axis labels: Intensity / a.u. (vertical), Wavelength / nm (horizontal)

## FIG. 8

## FIG. 9

FIG. 10

<div align="center">

**INTERNATIONAL SEARCH REPORT**

</div>

| | International application No. |
|---|---|
| | PCT/JP2008/056340 |

**A. CLASSIFICATION OF SUBJECT MATTER**
*C09K11/64(2006.01)i, C09K11/08(2006.01)i, H01L33/00(2006.01)i, H01S5/022 (2006.01)i, H05B33/14(2006.01)i*

According to International Patent Classification (IPC) or to both national classification and IPC

**B. FIELDS SEARCHED**

Minimum documentation searched (classification system followed by classification symbols)
C09K11/00-11/89, H01L33/00, H01S5/022, H05B33/14

Documentation searched other than minimum documentation to the extent that such documents are included in the fields searched
Jitsuyo Shinan Koho        1922-1996    Jitsuyo Shinan Toroku Koho    1996-2008
Kokai Jitsuyo Shinan Koho   1971-2008    Toroku Jitsuyo Shinan Koho    1994-2008

Electronic data base consulted during the international search (name of data base and, where practicable, search terms used)
CAplus(STN)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 52-144385 A (Dai Nippon Toryo Co., Ltd.),<br>01 December, 1977 (01.12.77),<br>Claims; page 5, upper left column, table 1;<br>example 1; Fig. 1<br>(Family: none) | 1-7,10-14<br>8,9,15-22 |
| Y | JP 8-60147 A (Mitsubishi Chemical Corp.),<br>05 March, 1996 (05.03.96),<br>Claims; Par. No. [0012]; examples<br>& US 5611959 A        & EP 697453 A1<br>& KR 10-0232395 B1      & CN 1129727 A | 8,9,15-22 |
| X | JP 2001-311075 A (Osram Sylvania Inc.),<br>09 November, 2001 (09.11.01),<br>Claims 1 to 4<br>& US 2001/0040231 A1    & EP 1148110 A2 | 11-12 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 June, 2008 (23.06.08) | 08 July, 2008 (08.07.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2008/056340 |

C (Continuation). DOCUMENTS CONSIDERED TO BE RELEVANT

| Category* | Citation of document, with indication, where appropriate, of the relevant passages | Relevant to claim No. |
|---|---|---|
| X | JP 2002-226847 A (Toshiba Corp.),<br>14 August, 2002 (14.08.02),<br>Examples<br>& US 2003/0132699 A1 & EP 1273645 A1<br>& WO 2001/077254 A1 & TW 567222 B<br>& CN 1422320 A | 11-12 |
| A | JP 2002-249766 A (Kasei Optonix, Ltd.),<br>06 September, 2002 (06.09.02),<br>Claims; examples<br>(Family: none) | 1-22 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 56025471 A
- JP 57008150 A
- JP 8060147 A
- JP 2209989 A
- JP 2233794 A
- JP 3231987 A
- JP 6314593 A
- JP 2002223008 A

- JP 2005082788 A
- JP 2006028458 A
- JP 2007112973 A
- JP 2007112975 A
- JP 2007019459 A
- JP 2006176468 A
- JP 2004300247 A
- JP 2007092852 A

**Non-patent literature cited in the description**

- *AIChE Journal,* 1998, vol. 44 (5), 1141